# EUROPEAN PATENT SPECIFICATION

(11) **EP 4 467 553 B1**
(45) Date of publication and mention of the grant of the patent: **27.08.2025**
(21) Application number: 24165701.4
(22) Date of filing: 22.03.2024
(51) Int. Cl.: C07F 15/00, C07B 59/00, C09K 11/06, H10K 50/11, H10K 85/30, H10K 101/10

(54) **FLUORINE-CONTAINING TETRADENTATE CYCLOMETALATED PLATINUM (II) COMPLEX, ELECTRONIC DEVICE AND APPLICATION THEREOF**
FLUORHALTIGER TETRADENTAT-CYCLOMETALLIERTER PLATIN(II)-KOMPLEX, ELEKTRONISCHE VORRICHTUNG UND ANWENDUNG DAVON
COMPLEXE DE PLATINE (II) CYCLOMÉTALLÉATE TÉTRADENTATE CONTENANT DU FLUOR, DISPOSITIF ÉLECTRONIQUE ET APPLICATION ASSOCIÉE

(30) Priority: 23.05.2023 CN 202310580532
(43) Date of publication of application: 27.11.2024
(73) Proprietor: Zhejiang University of Technology, Hangzhou, Zhejiang 310014 (CN); Zhejiang Huaxian Photoelectricity Technology Co., Ltd, Jiaxing, Zhejiang 314107 (CN)
(72) Inventor: Li, Guijie, Hangzhou, 310014 (CN); Zhang, Chengyao, Hangzhou, 310014 (CN); Yang, Yunfang, Hangzhou, 310014 (CN); She, Yuanbin, Hangzhou, 310014 (CN); Gao, Chunji, Jiaxing, 314107 (CN)
(74) Representative: Loo, Chi Ching

(56) References cited:
- EP-A1- 4 039 692

## Description

### TECHNICAL FIELD

The disclosure belongs to the field of organic electroluminescence, and particularly relates to a fluorine-containing tetradentate cyclometalated platinum (II) complex, an electronic device and application thereof.

### BACKGROUND ART

An Organic light-emitting diode (OLED) is a new generation of full-color display and lighting technologies. Compared with shortcomings of a liquid crystal display such as a slow response speed, a small viewing angle, need of backlight and high energy consumption, the OLED, as a self-luminous device, needs no backlight and saves energy. Meanwhile, it has a low driving voltage, a fast response speed, high resolution and contrast, a large viewing angle, and excellent low temperature performance; and an OLED device can be made thinner and in a flexible structure. In addition, it has advantages of low production cost, simple production processes and large-scale production. Therefore, the OLED presents a wide and huge application prospect in high-end electronic products and aerospace. With gradual increase of investment, further development of research and development, and upgrading of production equipment, the OLED has a very wide range of application scenarios and development prospects in the future.

A key of OLED development lies in design and development of luminescent materials. Almost all of light-emitting layers in currently applied OLED devices adopt a donor-acceptor light-emitting system mechanism, that is, a donor material is doped with an acceptor light-emitting material, and an energy gap of the donor material is generally greater than that of the acceptor light-emitting material, and energy is transferred from the donor material to the acceptor material, so that the acceptor material is excited to emit light. Commonly used organic phosphorescent acceptor materials are generally heavy metal atoms such as iridium (III), platinum (II), Pd(II), and so on. Commonly used organic phosphorescent materials mCBP (3,3-bis (9-carbazolyl)-biphenyl) and 2,6-MCPy (2,6-bis (9-carbazolyl)-Pyridine) have efficient and high triplet energy levels. When they are used as organic materials, triplet energy can be effectively transferred from luminescent organic materials to phosphorescent acceptor materials. However, due to characteristics of mCBP in which holes are easy to transport but electrons are difficult to flow, and holes cannot be well transported in 2,6-mCPy, charges in the light-emitting layer are unbalanced, which reduces current efficiency of a device. Meanwhile, currently applied heavy-metal phosphorescent organic complex molecules are cyclometalated iridium (III) complex molecules, with limited types. Content of metallic platinum in the earth's crust and its annual yield worldwide are about ten times that of metallic iridium, and cost of IrCl₃·H₂O for preparing iridium (III) complex phosphorescent materials is also much higher than that of PtCl₂ for preparing platinum (II) complex phosphorescent materials. In addition, the preparation of iridium (III) complex phosphorescent materials involves four-step reactions: iridium (III) dimer, iridium (III) intermediate ligand exchange, synthesis of mer-iridium (III) complex and mer-to-fac-iridium (III) complex isomer conversion, which greatly reduces a total yield, greatly reduces utilization of raw material IrCl₃·H₂O, and increase the preparation cost of the iridium (III) complex phosphorescent materials. In contrast, preparation of platinum (II) complex phosphorescent material only involves reaction of designing of ligand metallization of platinum salt in the last step above, with high utilization of platinum element, which can further reduce the preparation cost of the platinum (II) complex phosphorescent materials. To sum up, preparation cost of platinum (II) complex phosphorescent materials is much lower than that of iridium (III) complex phosphorescent materials. However, there are still some technical difficulties in development of platinum complex-based materials and devices, and it is an important research problem to improve efficiency and service life of devices. Therefore, it is urgent to develop new phosphorescent platinum (II) complexes. Examples of known organic luminescent materials can be found in EP4039692.

### SUMMARY

In view of this, an object of the present disclosure is to provide a fluorine-containing tetradentate cyclometalated platinum (II) complex, an electronic device and applications thereof. The fluorine-containing tetradentate cyclometalated platinum (II) complex according to the disclosure can be used as a phosphorescent acceptor material of a light-emitting layer so as to cause a device to be with excellent performance. Furthermore, when it is combined with a specific donor material, current efficiency and service life of an electronic device, especially an organic electroluminescent device, can be improved, and an operating voltage of an element can be reduced.

A fluorine-containing tetradentate cyclometalated platinum (II) complex is provided in the disclosure, which has a structure shown in formula (I) or formula (II): 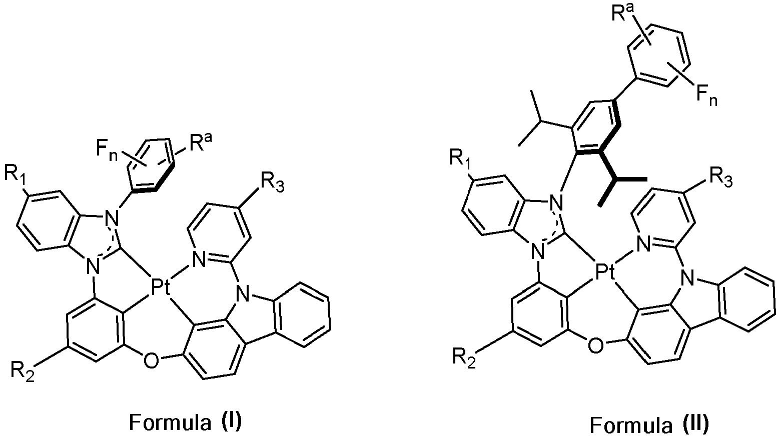
in the formula (I) or formula (II), Fₙ indicates that there are one or more F substituted on a benzene ring where it is located, where n is a positive integer from 1 to 5;
R^{a} is represented as monosubstituted, disubstituted, trisubstituted, tetrasubstituted or unsubstituted; R^{a} is selected from H or C1-C30 alkyl;
R₁, R₂ and R₃ are independently selected from a group consisting of hydrogen, F, N, O, S, CN, C1-C30 alkyl, C1-C30 cycloalkyl, C1-C30 heterocycloalkyl, C1-C30 haloalkyl, C6-C60 aryl and C6-C60 heteroaryl.

Preferably, at least one hydrogen in R₁, R₂ and R₃ can be substituted by deuterium or F.

Preferably, R₁ and R₃ are independently selected from hydrogen or C1-C30 alkyl.

Further preferably, R₂ is selected from hydrogen, deuterium, CN, substituted or unsubstituted C1-C30 alkyl, substituted or unsubstituted C1-C30 heteroalkyl, substituted or unsubstituted C1-C30 cycloalkyl, substituted or unsubstituted C1-C30 heterocycloalkyl, substituted or unsubstituted C1-C30 haloalkyl, substituted or unsubstituted C6-C60 aryl, and substituted or unsubstituted C6-C60. Heteroatoms on the heteroalkyl, heterocycloalkyl or heteroaryl are selected from one or more of O, S and/or N.

Further preferably, the tetradentate metal platinum (II) complex selected from ones with any one of following chemical structures, in which "D" represents deuterium: 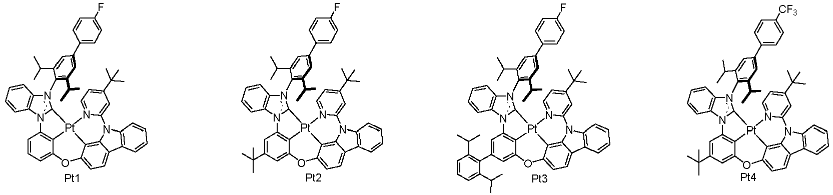 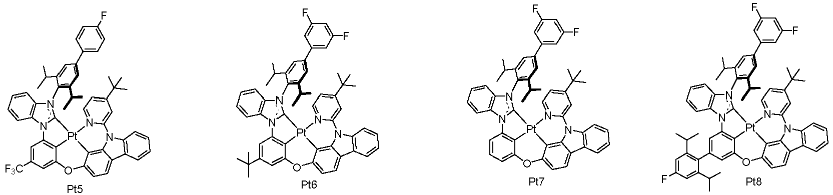 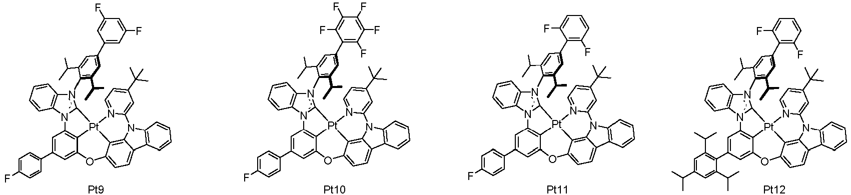 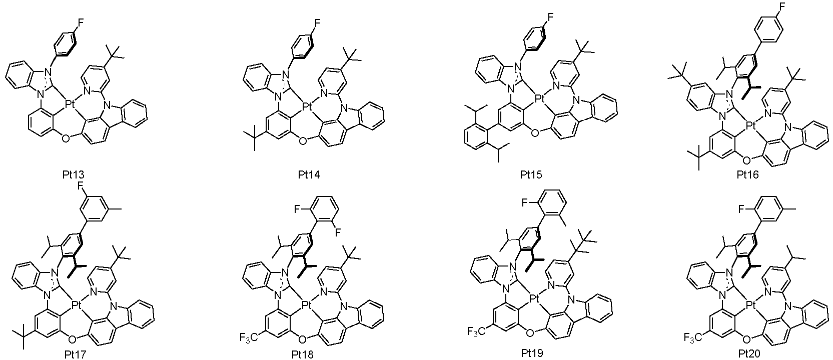 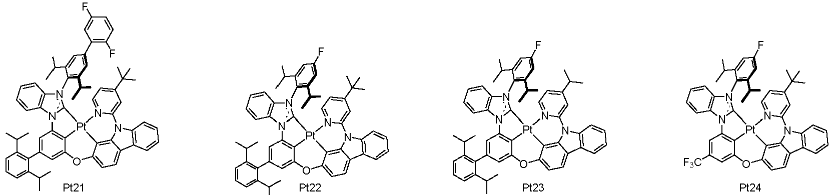 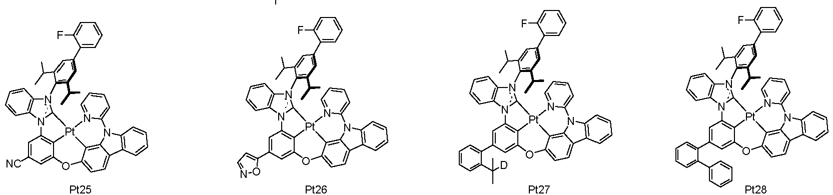 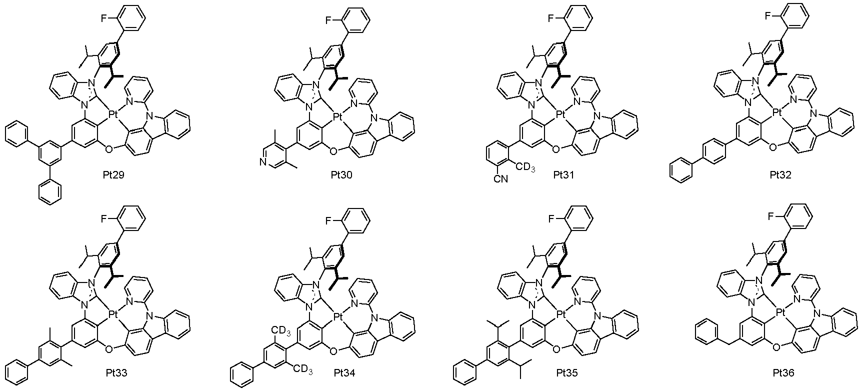 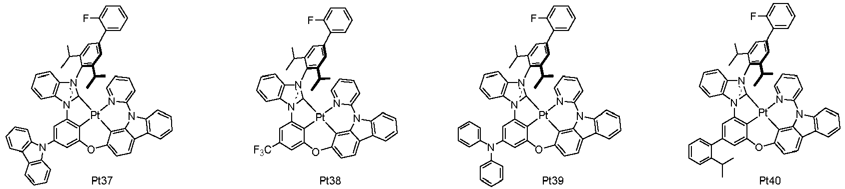 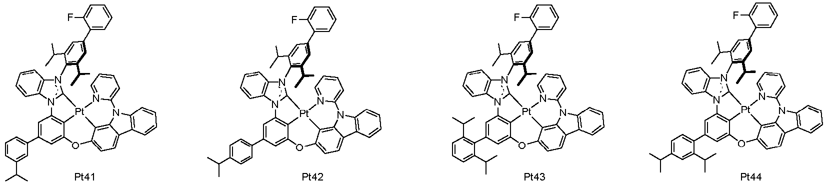 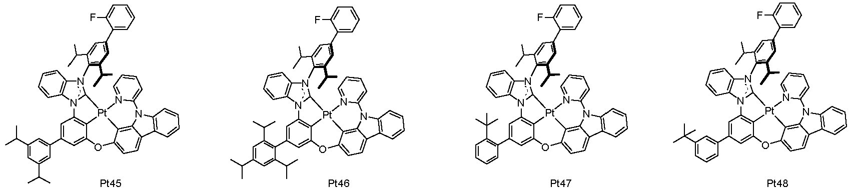 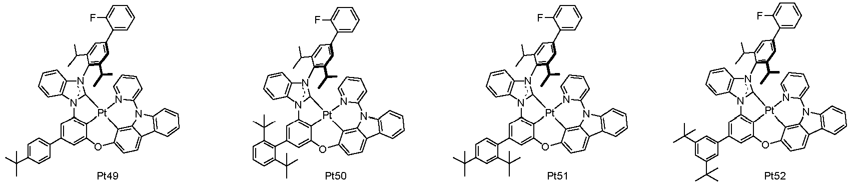 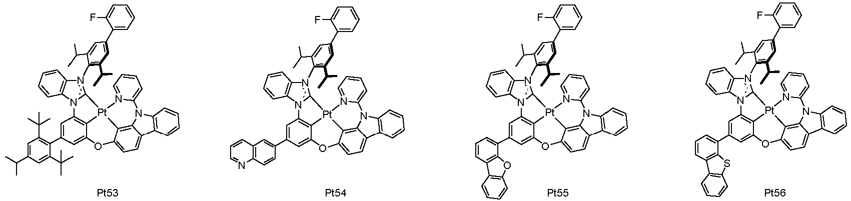 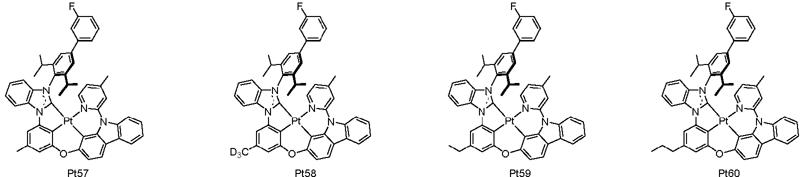 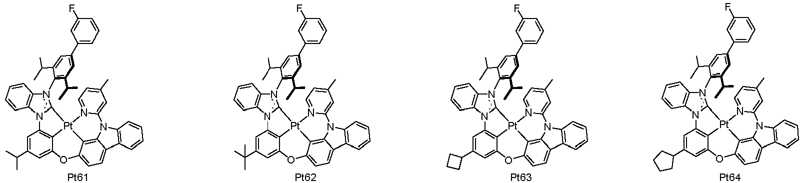 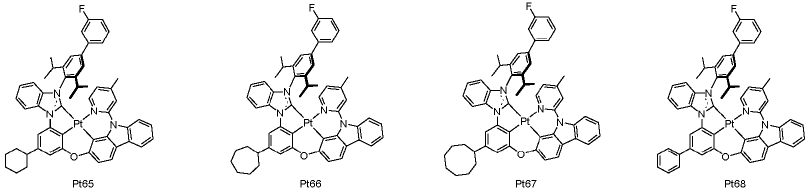 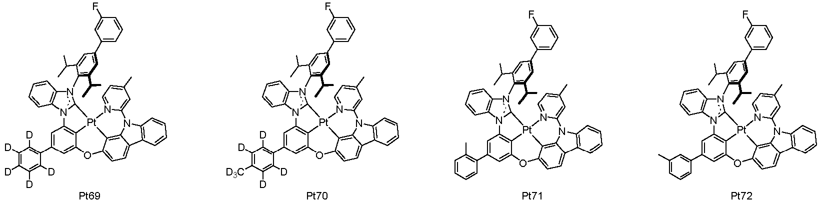 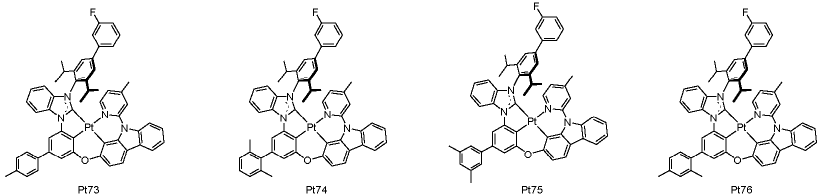 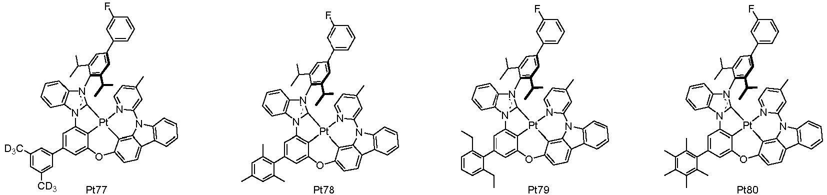 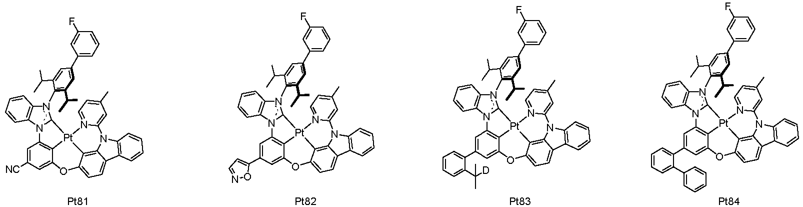 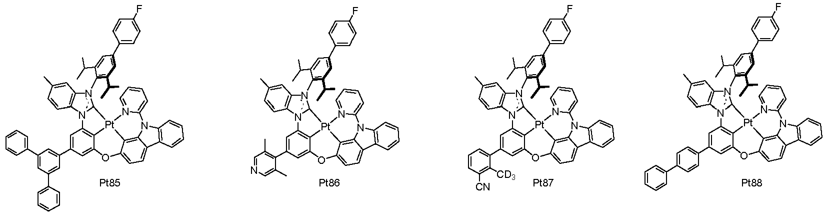 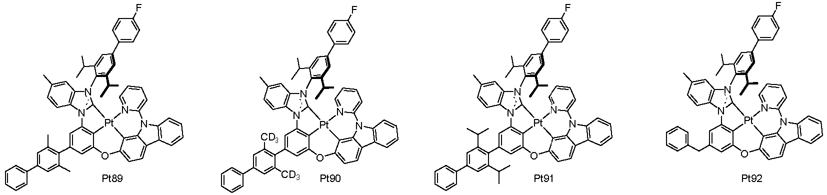 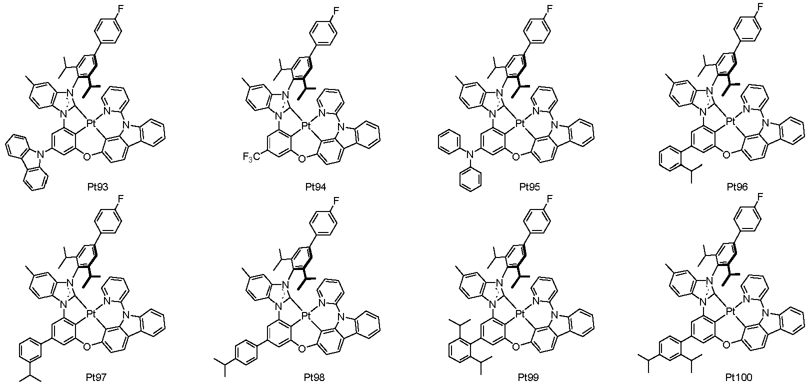 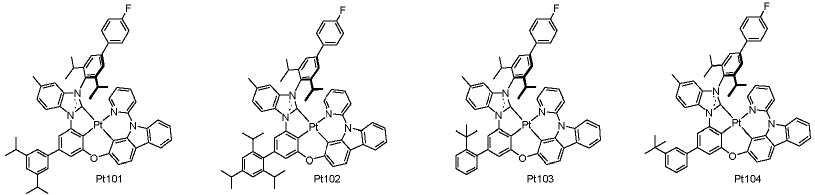 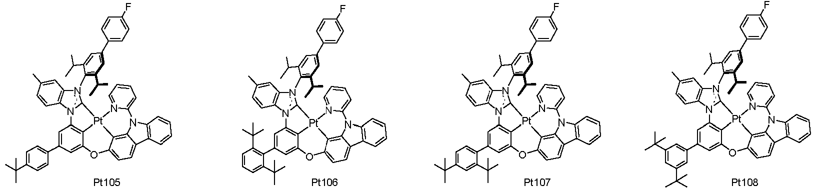 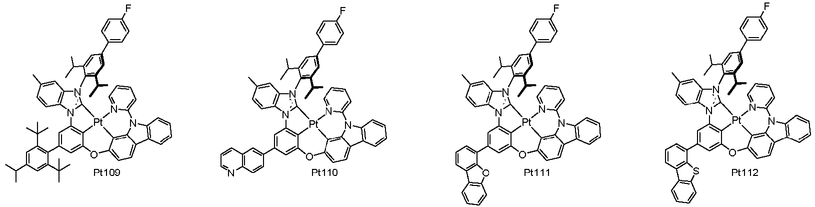 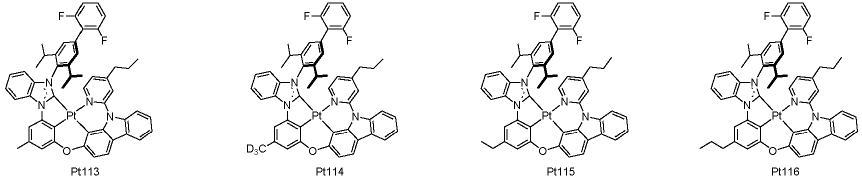 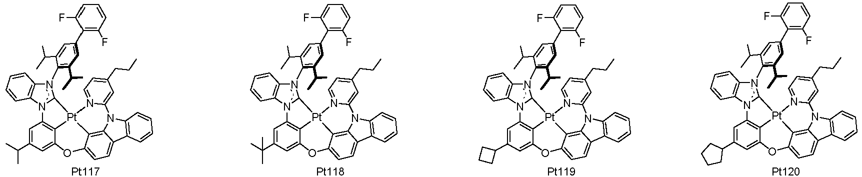 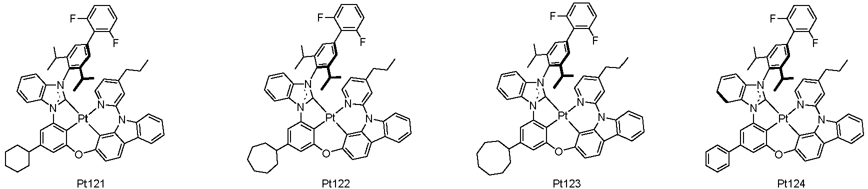 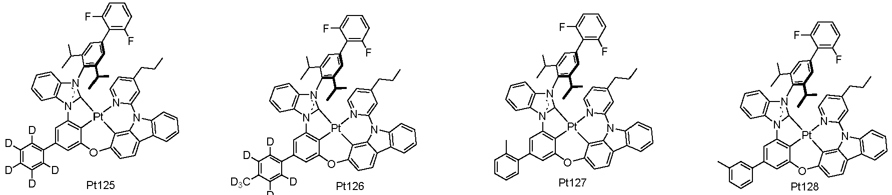 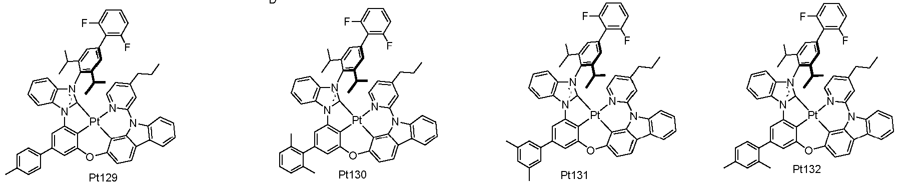 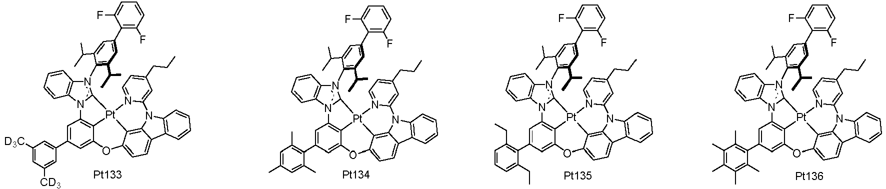 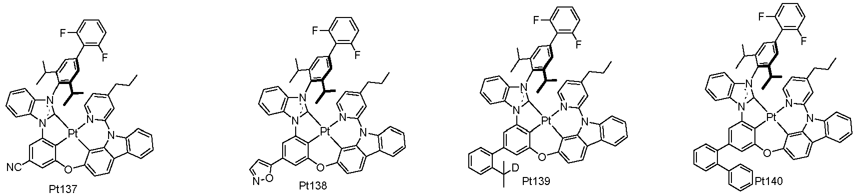 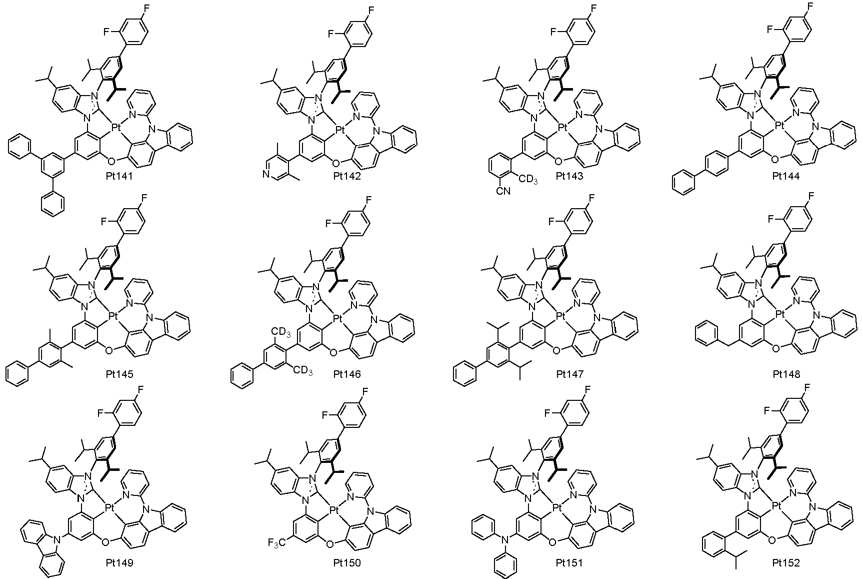 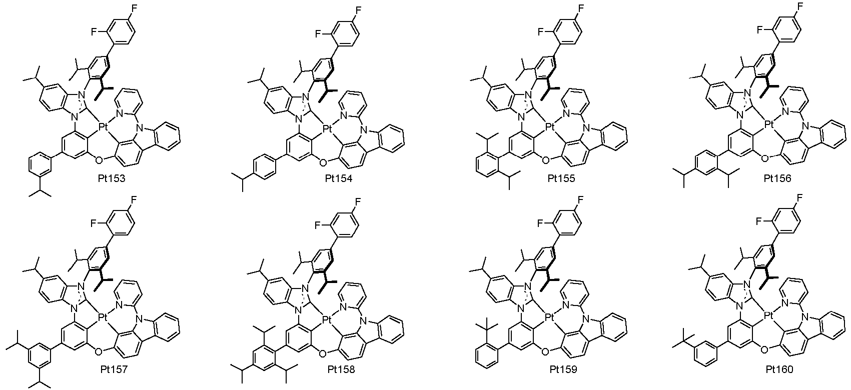 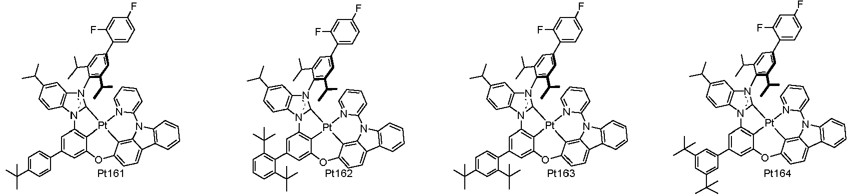 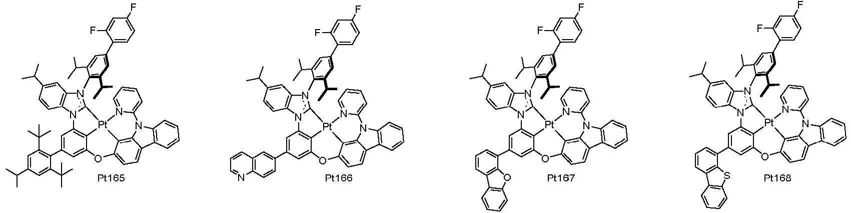 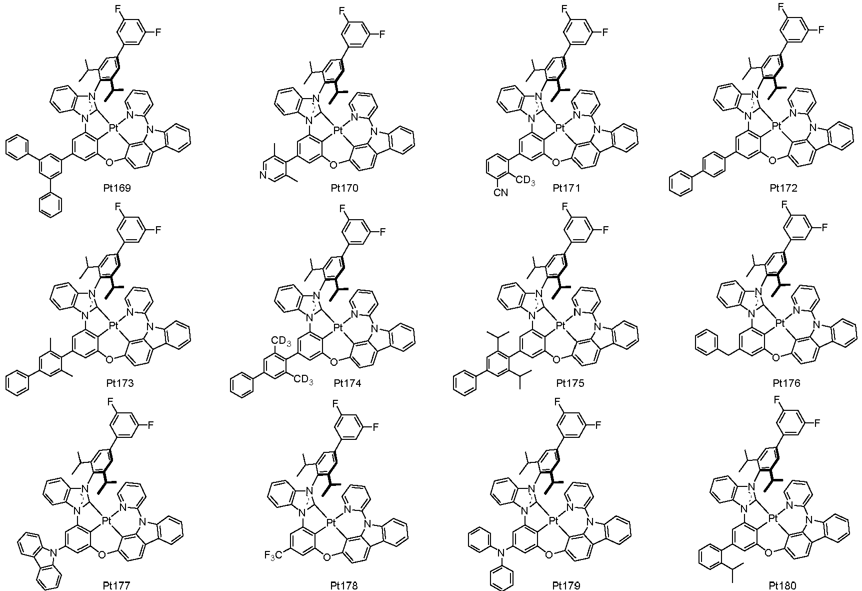 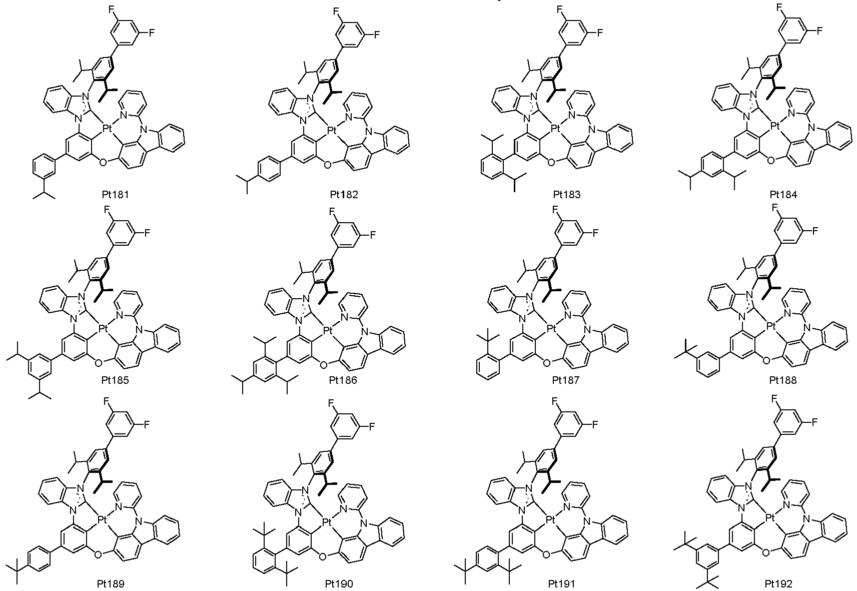 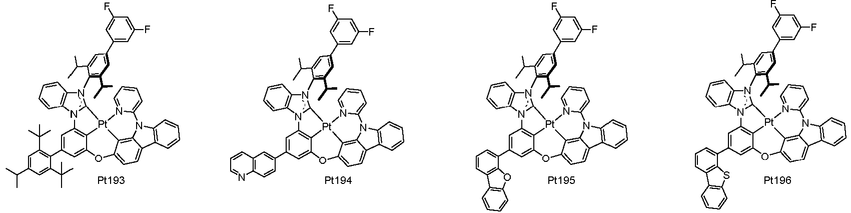 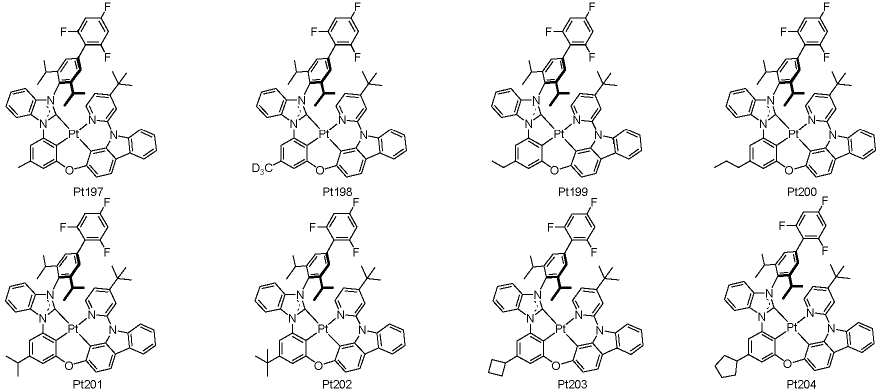 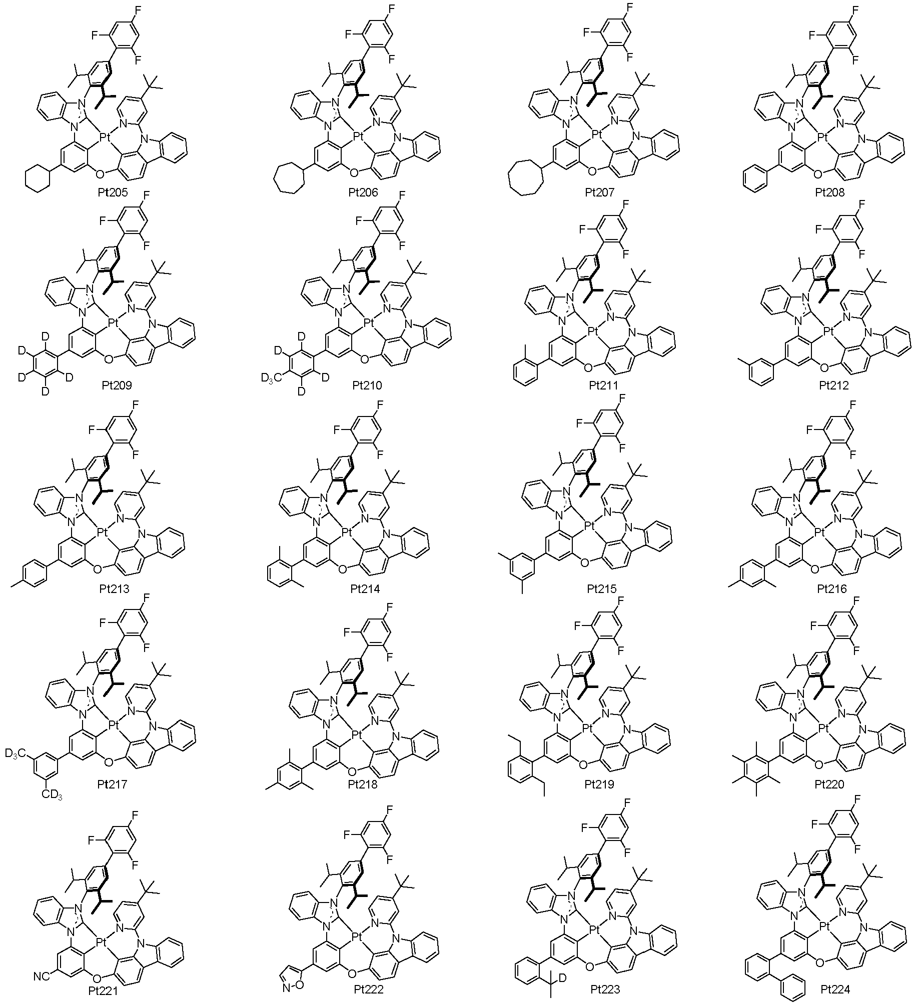 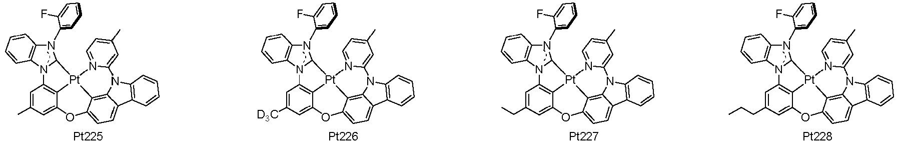 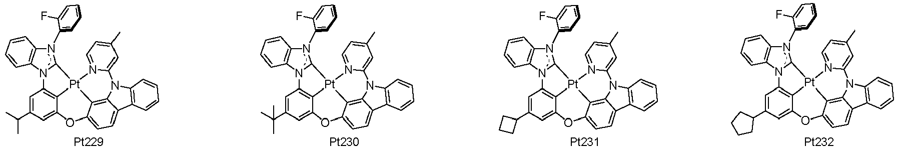 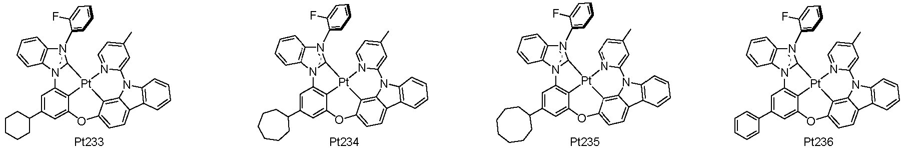 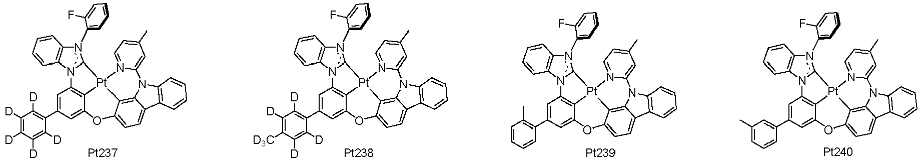 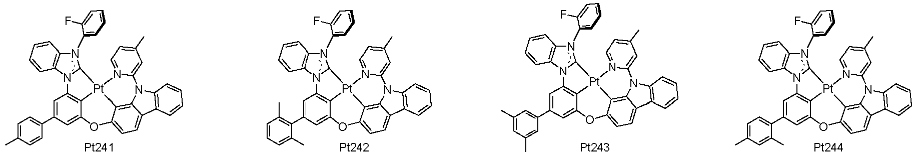 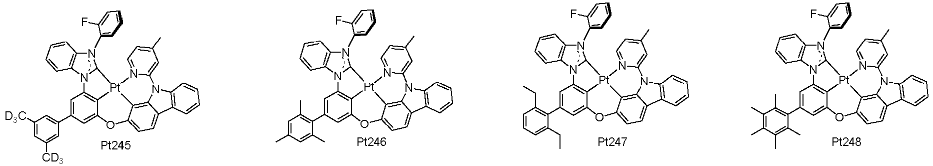 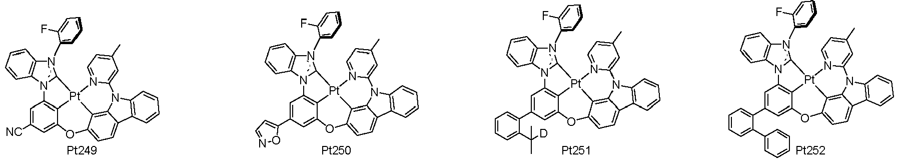 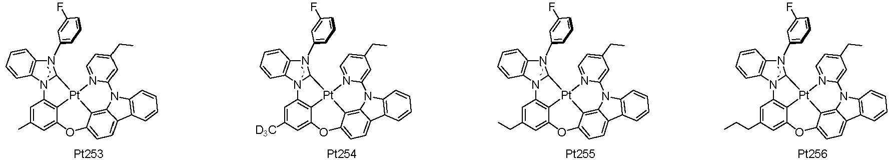 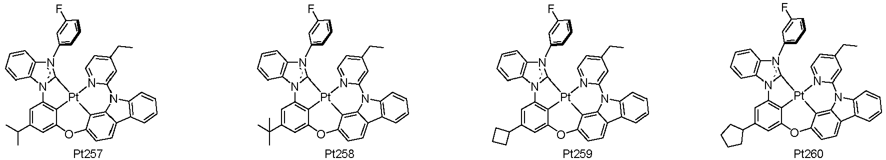 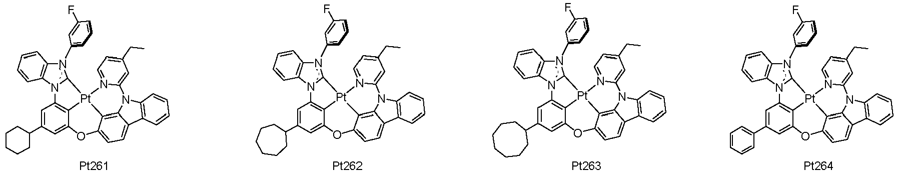 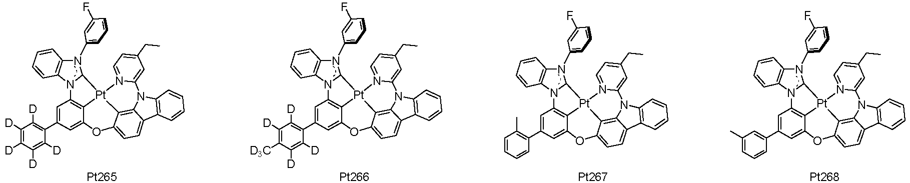 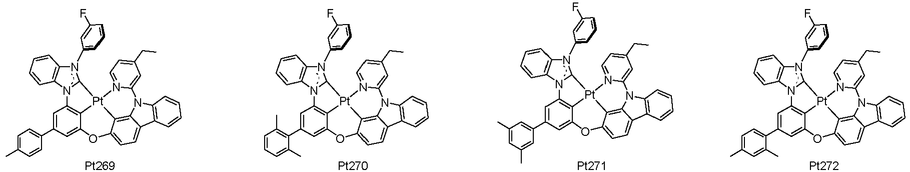 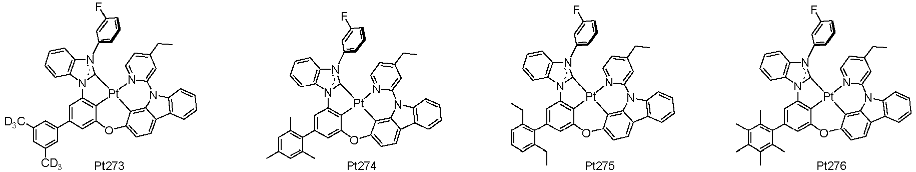 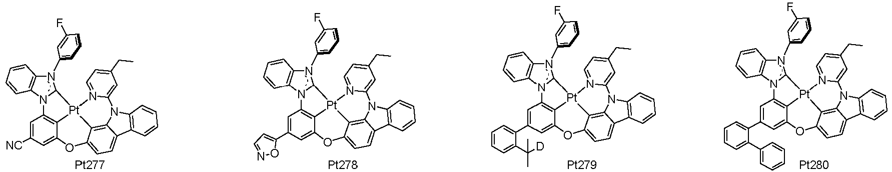 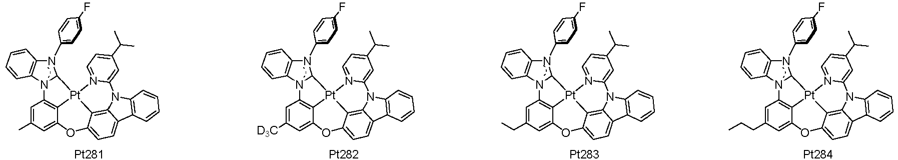 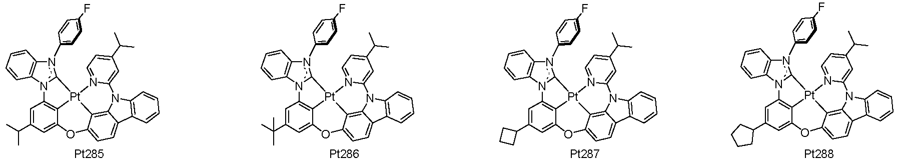 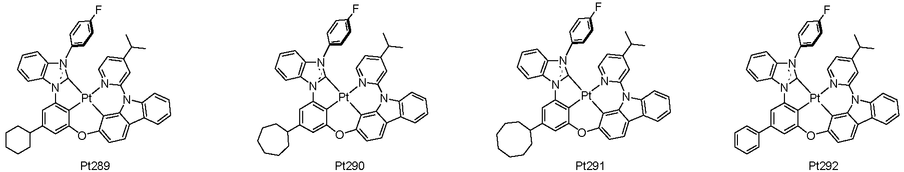 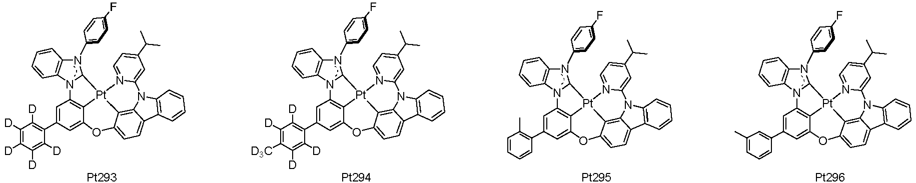 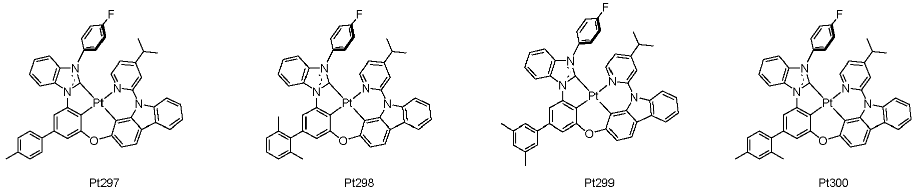 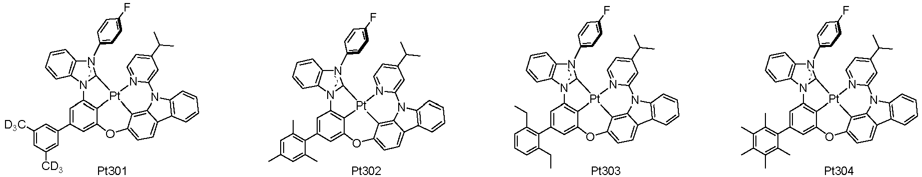 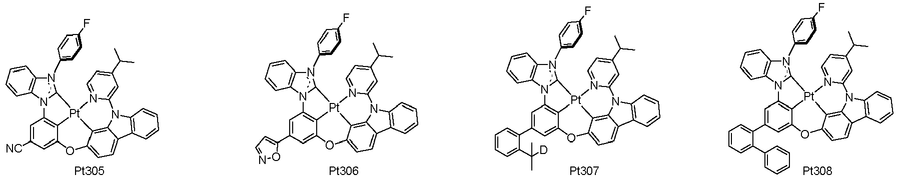 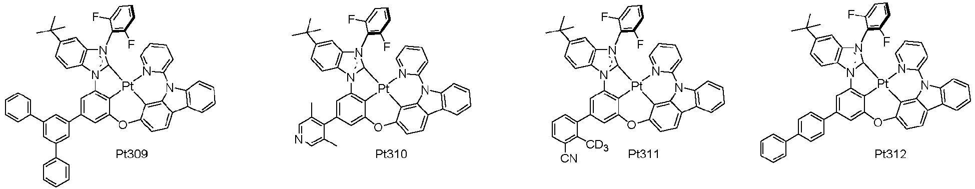 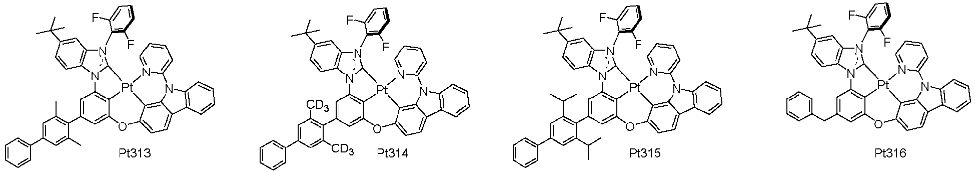 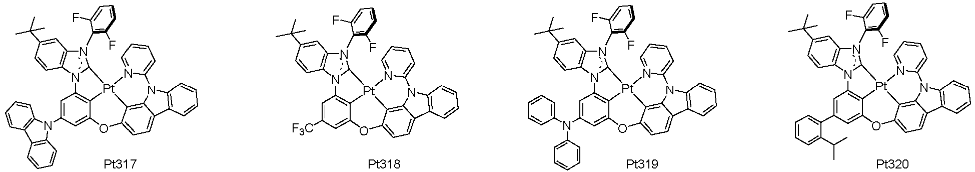 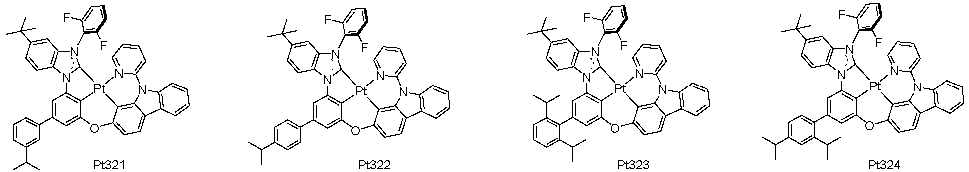 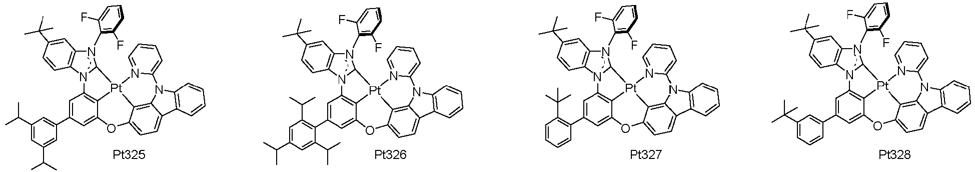 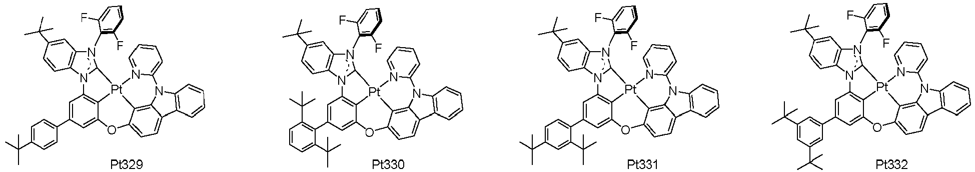 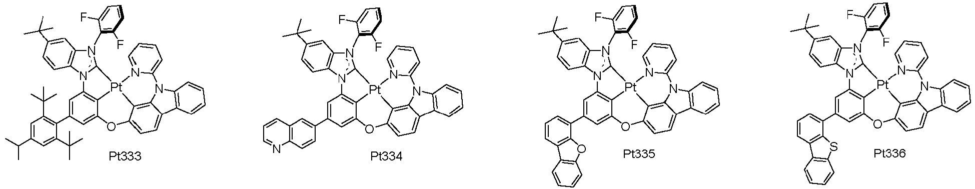 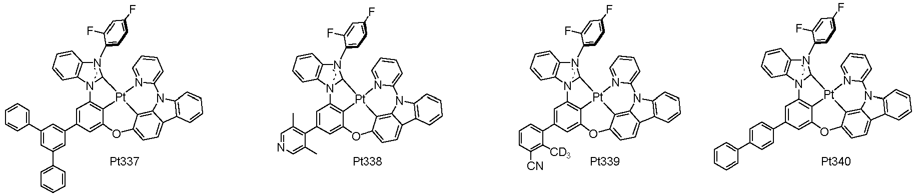 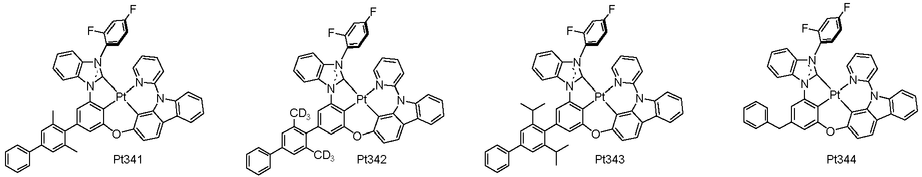 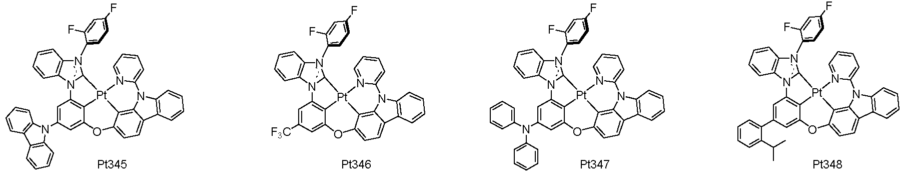 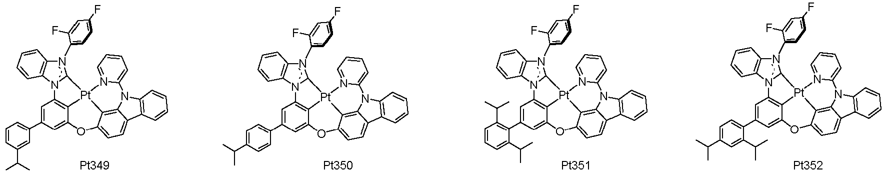 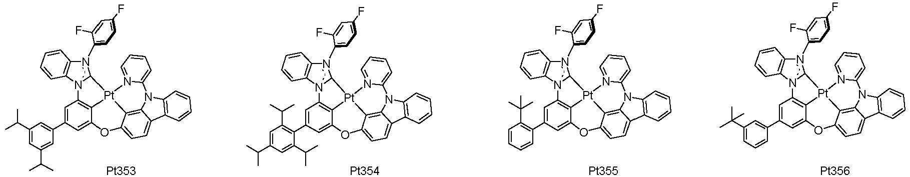 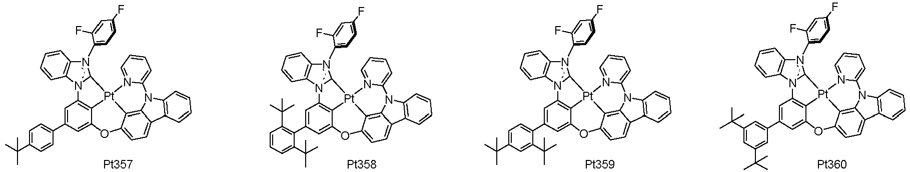 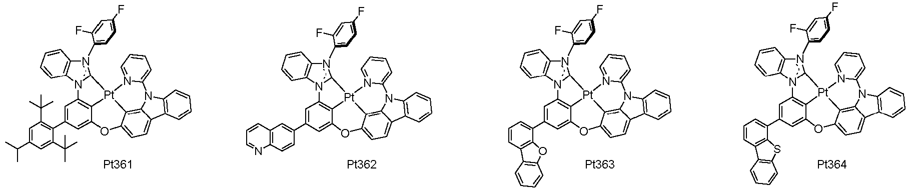 Further, application of a tetradentate cyclometalated platinum (II) complex with a structure shown in formula (I) or formula (II) in an electronic device is further provided in this disclosure.

Further, the electronic device includes an organic light-emitting device (OLED), an organic integrated circuit (O-IC), an organic field effect transistor (O-FET), an organic thin film transistor (O-TFT), an organic light emitting transistor (O-LET), an organic solar cell (O-SC), an organic optical detector, an organic field quenching device (O-FQD), a light-emitting electrochemical cell (LEC) and an organic laser diode (O-laser).

In another aspect, an organic light-emitting device is further provided in this disclosure, which includes a tetradentate cyclometalated platinum (II) complex with a structure shown in formula (I) or formula (II).

Further, the organic light-emitting device includes a cathode, an anode and an organic functional layer therebetween. The organic functional layer includes the tetradentate cyclometalated platinum (II) complex with a structure shown in formula (I) or formula (II) as described above.

Preferably, the organic functional layer includes a light-emitting layer, and the light-emitting layer includes the tetradentate cyclometalated platinum (II) complex with the structure shown in formula (I) or formula (II) as described above.

Further, the light-emitting layer further includes a fluorescent doping material. The fluorescent doping material is selected from any one or more compound represented by formulas (BN1) to (BN5): 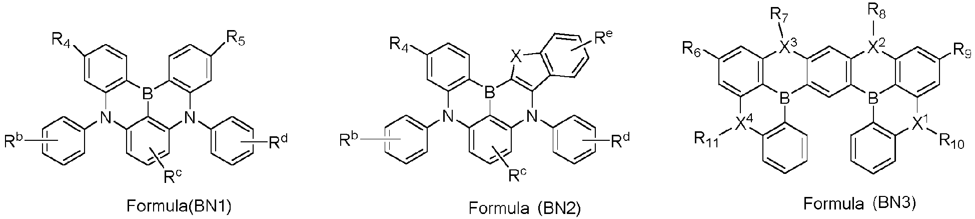 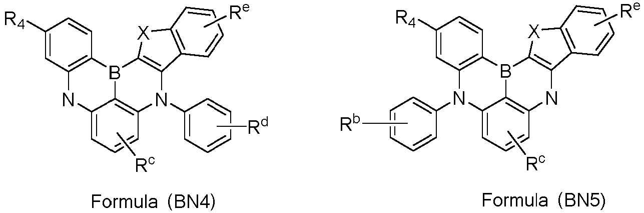
in which X is O, S, Se or NR³⁰⁰;
X¹, X², X³, x^{4r} each independently represent O, S, Se or N; and
R^{b} to R^{e} are each independently represented as monosubstituted, disubstituted, trisubstituted, tetrasubstituted or unsubstituted; R^{b} to R^{e} are independently selected from a group consisting of hydrogen, deuterium, N, C1-C30 alkyl and C6-C60 aryl; R₄ to R₁₁ are each independently selected from a group consisting of a group consisting of hydrogen, deuterium, n, C1-C30 alkyl and C6-C60 aryl.

Preferably, R₄, R₅, R₆ and R₉ are independently selected from substituted or unsubstituted diphenylamine groups, or substituted or unsubstituted carbazole groups; substitution can be multiple substitutions, and when a substituent is contained, the substituent is selected from deuterium, C1-C30 alkyl, and C6-C30 aryl.

Preferably, R₇ to R₈ and R₁₀ to R₁₁ are independently selected from a group consisting of hydrogen, C1-C30 alkyl and C6-C60 aryl.

Further preferably, at least one hydrogen in R₄ to R₁₁ can be substituted by deuterium.

Further, the fluorescent doping material is selected from any one of following chemical structures, in which Ph represents a phenyl group, and D4 and D5 respectively refers to be substituted by 4 and 5 deuterium atoms:

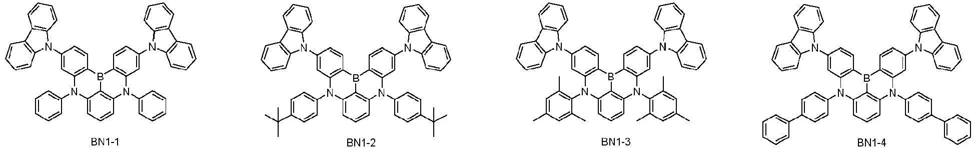

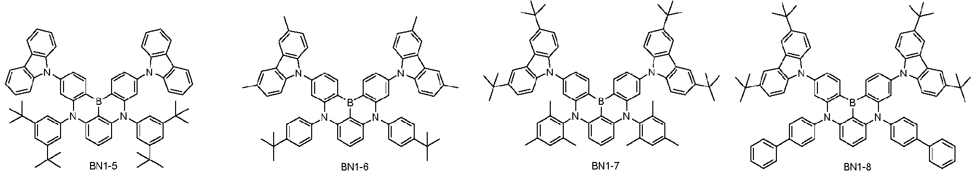

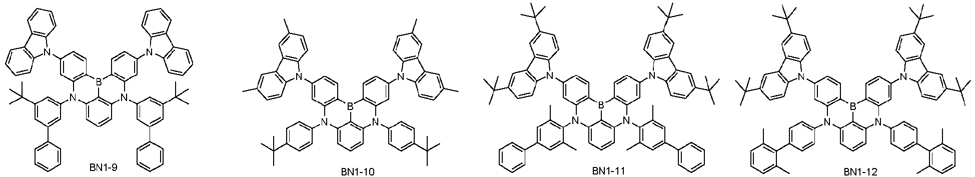

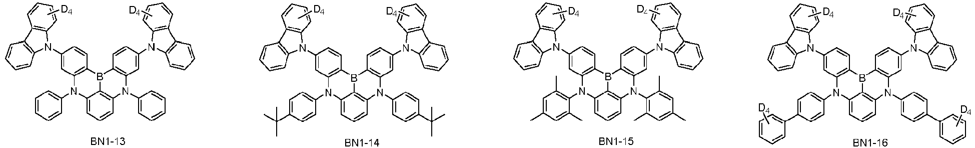

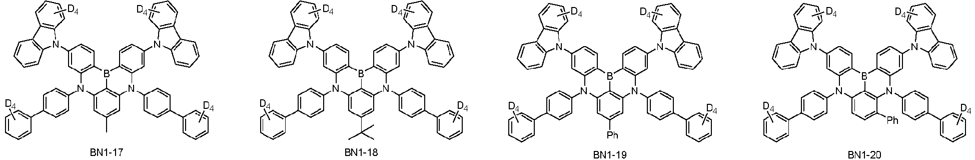

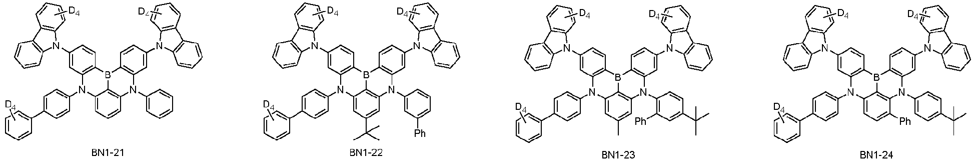

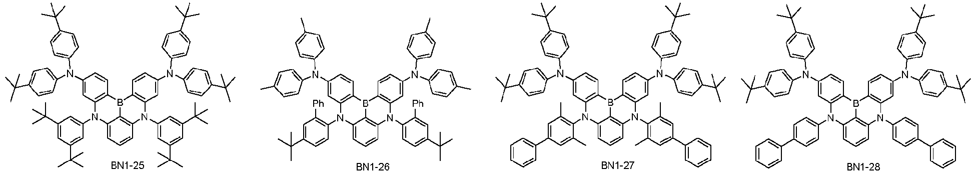

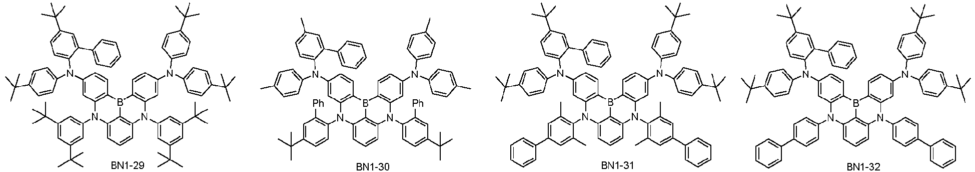

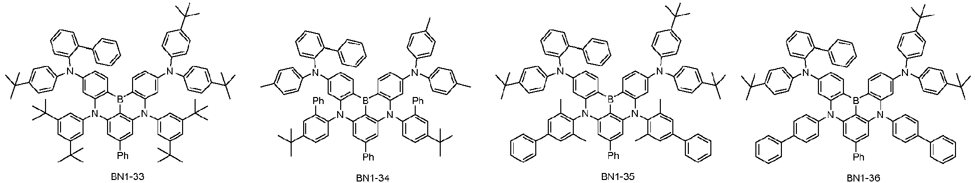

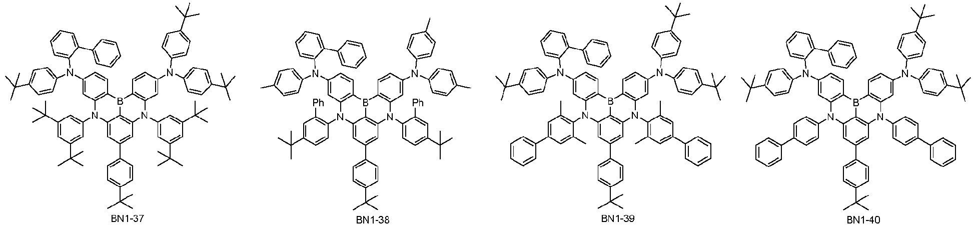

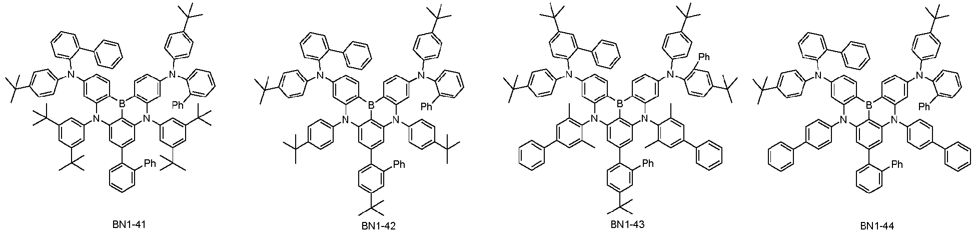

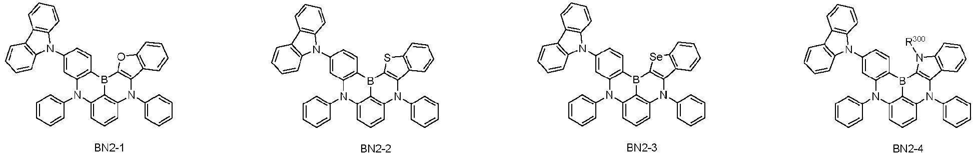

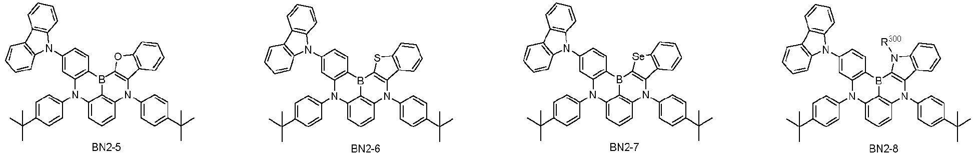

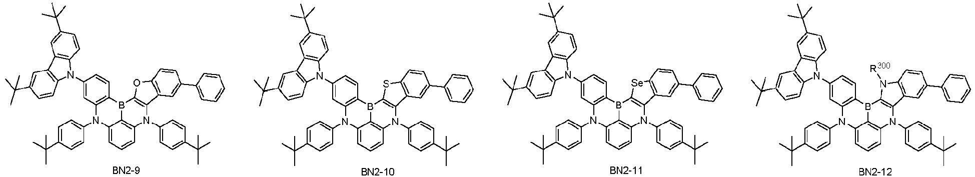

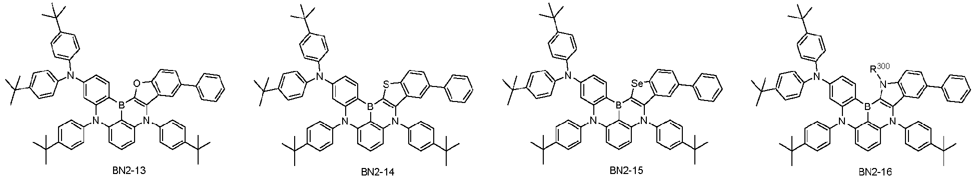

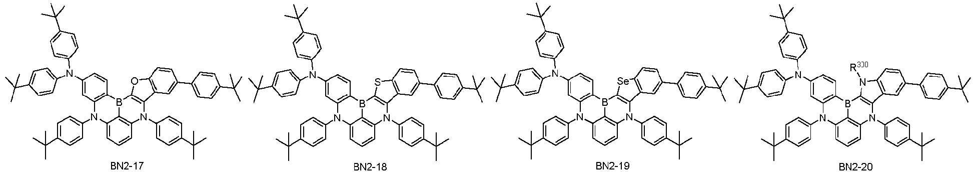

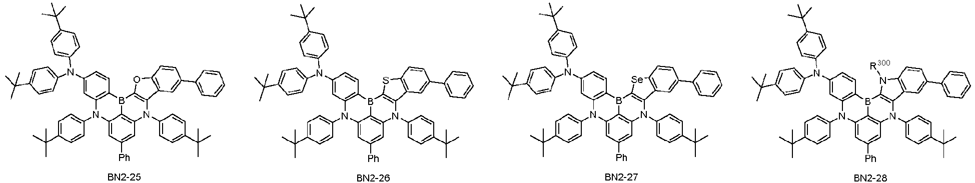

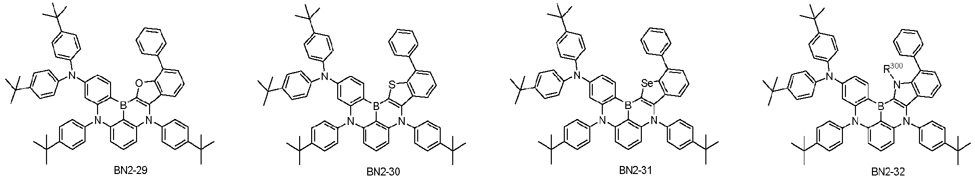

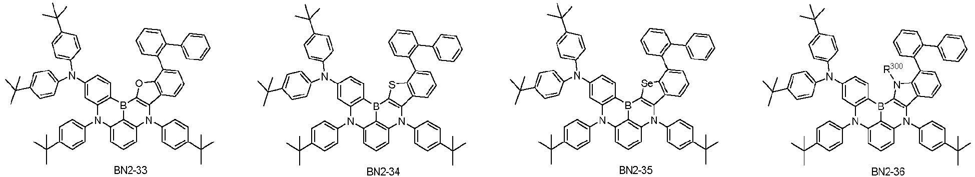

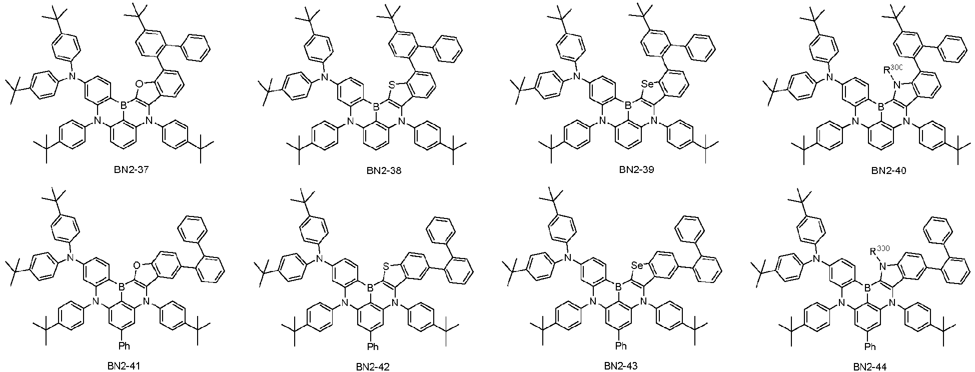

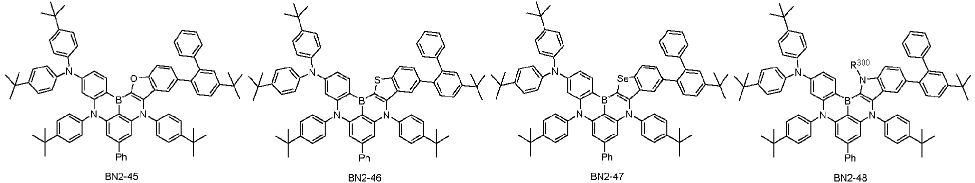

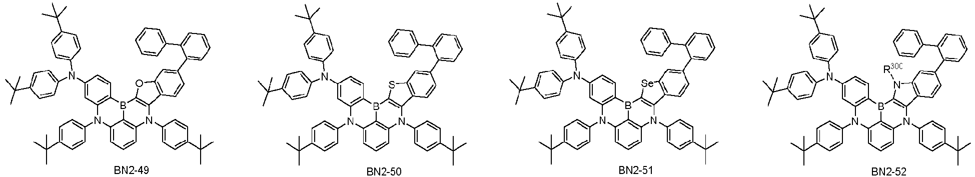

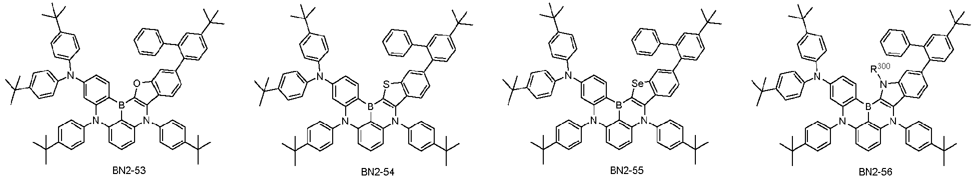

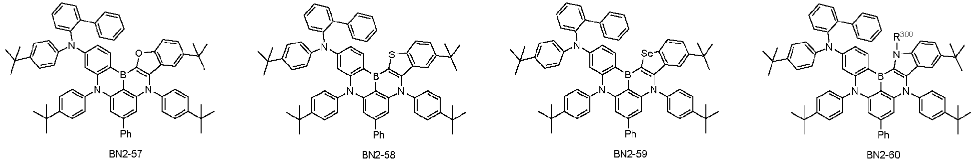

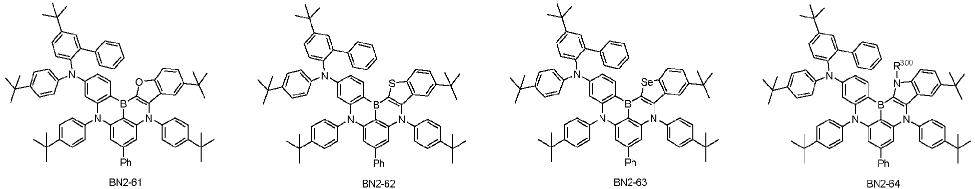

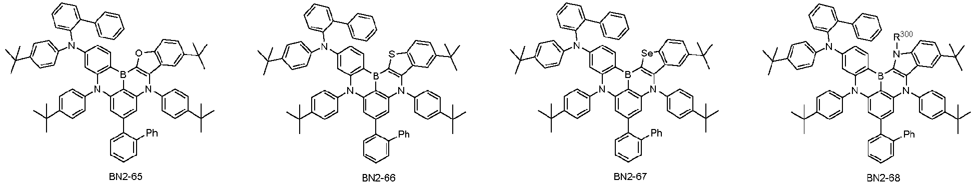

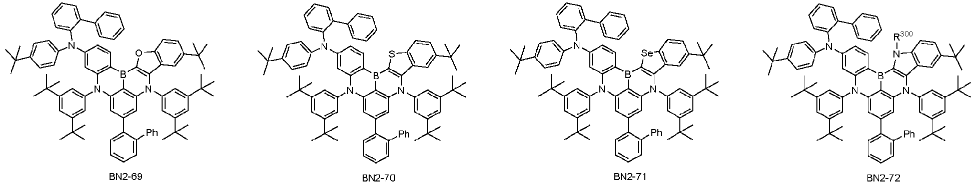

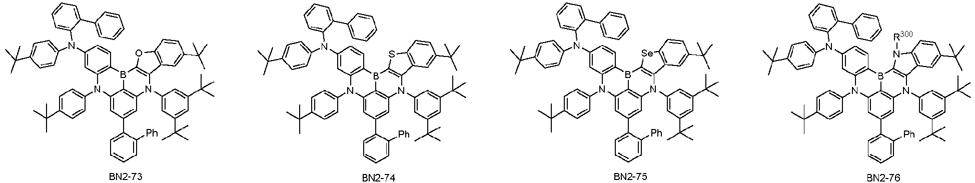

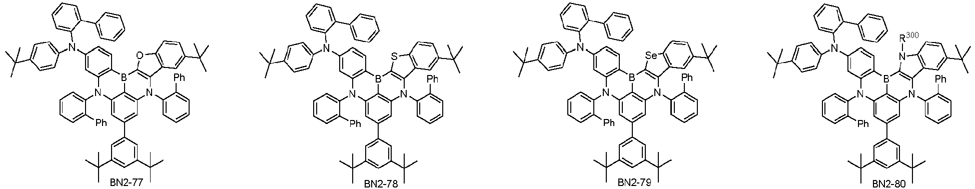

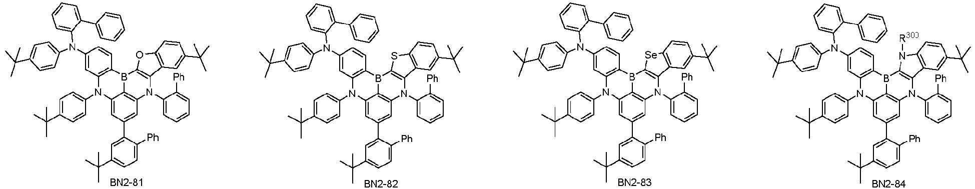

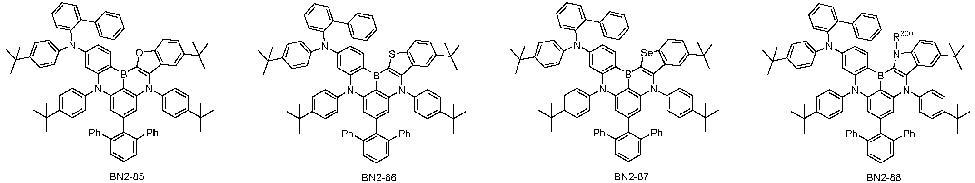

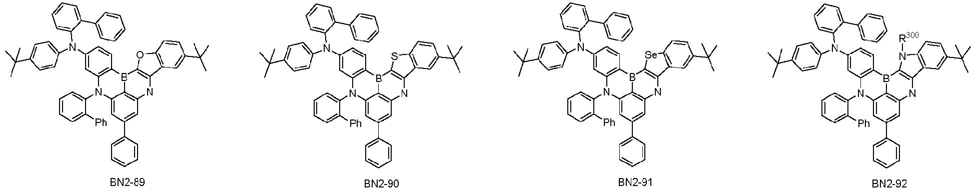

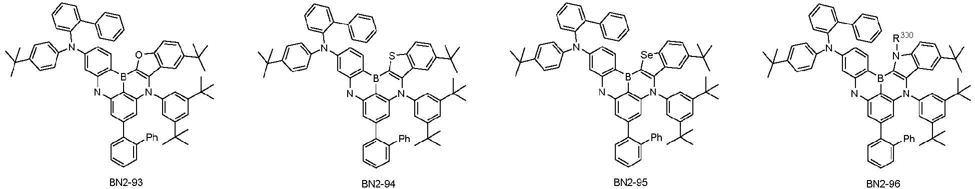

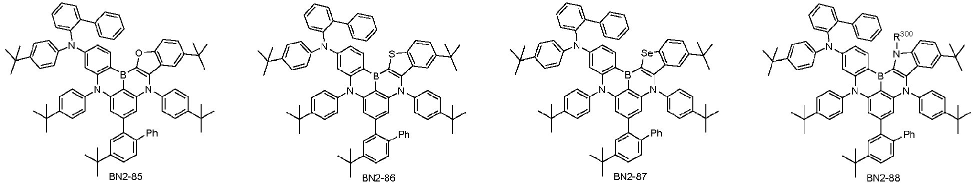

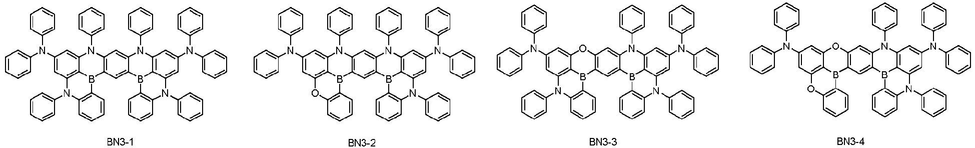

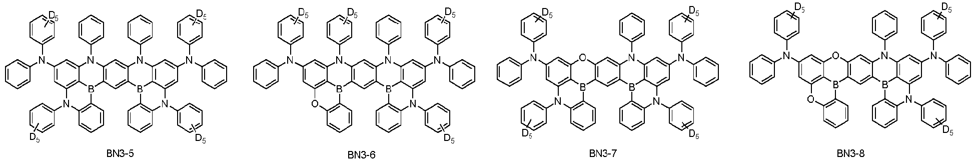

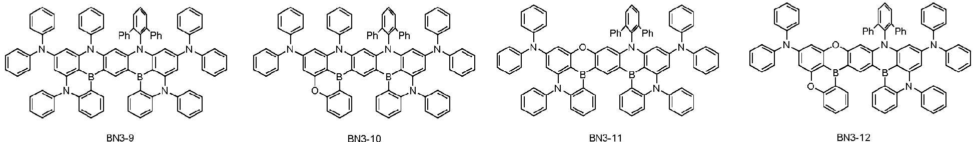

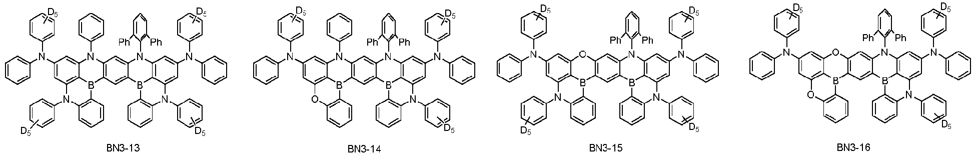

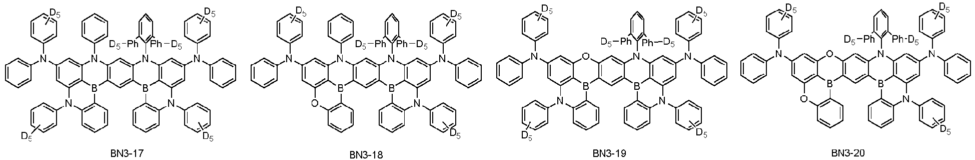

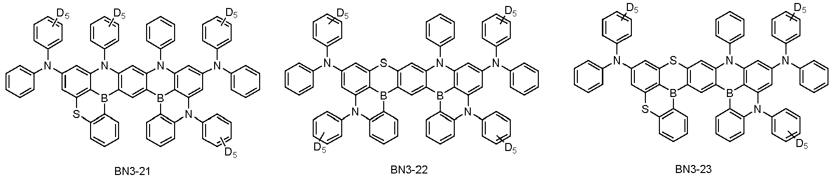

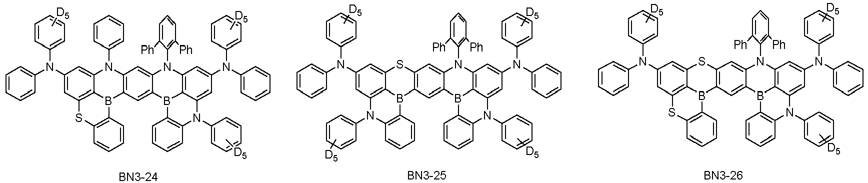

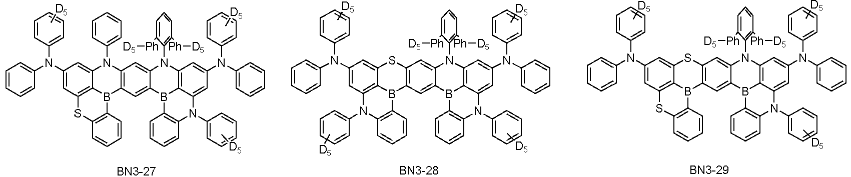

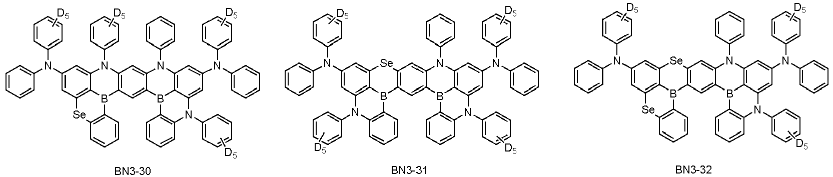

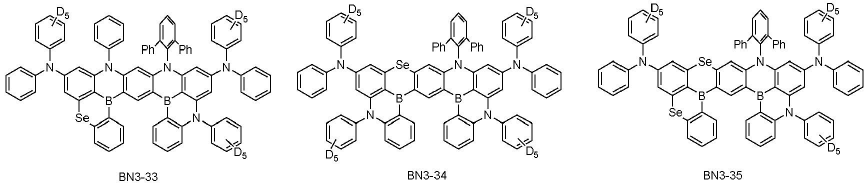

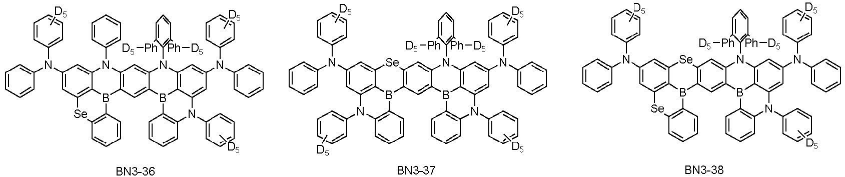

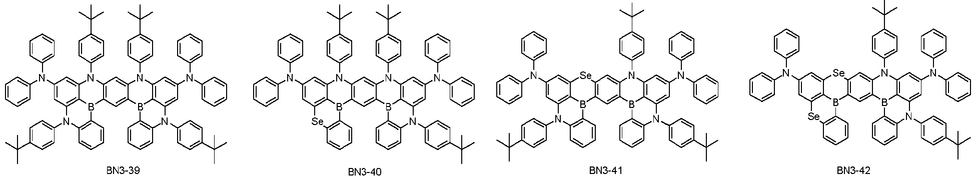

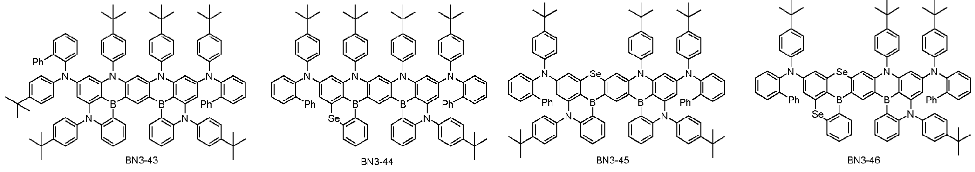

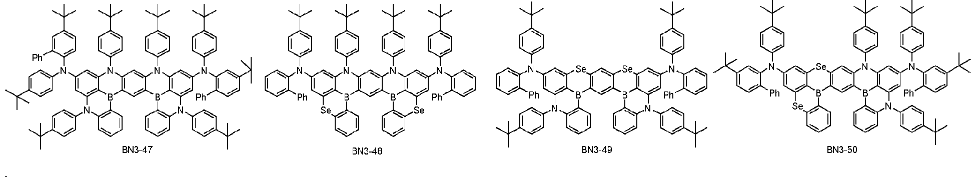

In another aspect, an organic photoelectric device is further provided in this disclosure, which includes a substrate layer; a first electrode on the substrate; an organic light-emitting functional layer on the first electrode; a second electrode on the organic light emitting functional layer. The organic light-emitting functional layer includes the tetradentate cyclometalated platinum (II) complex with the structure shown in formula (I) or formula (II) as described above. For example, the platinum (II) complex can be included as a luminescent material in the organic light-emitting functional layer.

Further, the organic light-emitting functional layer further includes a fluorescent doping material, which is any one or more of compounds represented by formulas (BN1) to (BN5).

A composition is further provided in the disclosure, which includes the tetradentate cyclometalated platinum (II) complex with the structure shown in formula (I) or formula (II) as described above. Preferably, the composition further includes a fluorescent doping material, which is any one or more of compounds represented by formulas (BN1) to (BN5).

A preparation is further provided in the disclosure, which includes the tetradentate cyclometalated platinum (II) complex with the structure shown in formula (I) or formula (II) as described above or the composition as described above and at least one solvent. The solvent is not particularly limited, and unsaturated hydrocarbon solvents such as toluene, xylene, mesitylene, tetralin, decalin, dicyclohexane, n-butylbenzene, sec-butylbenzene and tert-butylbenzene, saturated hydrocarbon solvents such as carbon tetrachloride, chloroform, dichloromethane, dichloroethane, chlorobutane, bromobutane, chloropentane, bromopentane, chlorohexane, bromohexane, chlorocyclohexane and bromocyclohexane, halogenated unsaturated hydrocarbon solvents such as chlorobenzene, dichlorobenzene and trichlorobenzene, ether solvents such as tetrahydrofuran and tetrahydropyran, and ester solvents such as benzoic acid alkyl ester, which are well known to those skilled in the art can be used.

Preferably, the composition further includes a fluorescent doping material, which is any one or more of compounds represented by formulas (BN1) to (BN5).

A display or lighting apparatus is further provided in the disclosure, which includes one or more of organic photoelectric devices as described above.

### Compared with related art, the disclosure has following beneficial effects:

The phosphorescent material of tetradentate cyclometalated platinum (II) complex is provided in this disclosure. By introducing fluorine atoms into an appropriate part of its ligand, distribution of excited charges can be improved, so that this material has more metal-to-pyridine carbene charge transfer states (³MLCT), which facilitates improvement of radiation rate and thus improvement of service life of devices. Materials involved in the disclosure have good chemical stability and thermal stability, and are easy to prepare vapor-deposited OLED devices. Combined with the fluorescent doping material, transmission of holes and electrons can be balanced and energy transfer between a donor material and an acceptor material can be more efficient. The organic light-emitting device with a light-emitting layer made of the compound according to the disclosure has obviously improved current efficiency and service life, and an obviously reduced lighting voltage. Especially, photochromatic purity of the device can be improved when it is used in combination with boron-containing phosphorescent sensitized compounds.

### BRIEF DESCRIPTION OF THE DRAWINGS

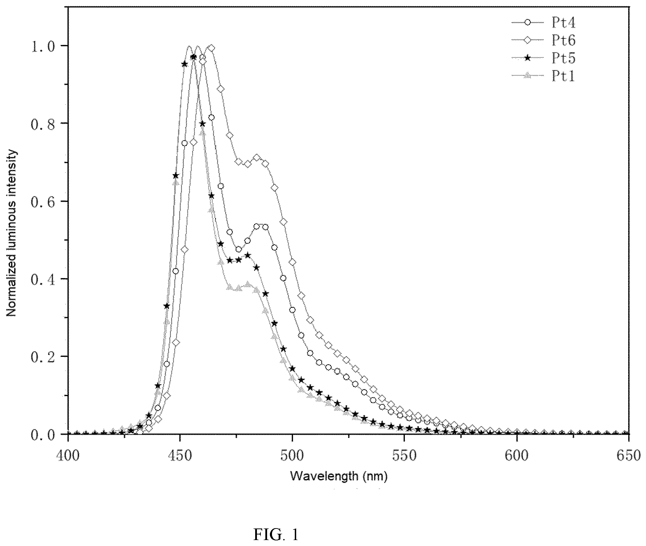

FIG. 1 is a room-temperature emission spectrum of a prepared platinum complex Pt1 to Pt6 in a dichloromethane solution according to the disclosure.

### DETAILED DESCRIPTION

Contents of the present disclosure are described in detail below. Following description of constituent elements described below is sometimes based on representative embodiments or specific examples of the present disclosure, but the present disclosure is not limited to such embodiments or specific examples.

A term "substituted" as used herein is intended to include all permissible substituents of an organic compound. In a broad aspect, permissible substituents include acyclic and cyclic, branched and unbranched, carbocyclic and heterocyclic, and aromatic and nonaromatic substituents of organic compounds. Illustrative substituents include, for example, those described below. For suitable organic compounds, the permissible substituents may be one or more, the same or different. For a purposes of the present disclosure, heteroatom (e. g., nitrogen) can have a hydrogen substituent and/or any permissible substituent of the organic compound of the present disclosure satisfying valence bonds of the heteroatom. The present disclosure is not intended to be limiting in any way with the permissible substituents of the organic compound. As such, a term "substituted" or "substituted with" encompasses an implicit condition that such a substitution conforms to permissible valence bonds of a substituted atom and the substituent, and that the substitution results in stable compounds (e. g., compounds that do not spontaneously undergo conversion (e. g., by rearrangement, cyclization, elimination, etc.)). It is also contemplated that in certain aspects, individual substituents can be further optionally substituted (i.e., further substituted or unsubstituted) unless explicitly indicated to the contrary.

In defining various terms, "R₁" to "R₁₁" are used in the present disclosure as general symbols to denote various specific substituents. These symbols can be any substituent, not limited to those disclosed in the present disclosure, and when they are defined as some substituents in one case, they can be defined as some other substituents in other cases.

"R₁", "R₂", "R₃", "Rₙ" (where n is an integer) as used herein may independently have one or more of groups listed above. For example, if R¹ is linear alkyl, one hydrogen atom of the alkyl may be optionally substituted with hydroxy, alkoxy, alkyl, halogen or the like. Depending on a selected group, a first group may be incorporated within a second group, or alternatively, the first group may be suspended, i.e., linked to the second group. For example, for a phrase "an alkyl including amino", the amino may be incorporated within a main chain of the alkyl. Alternatively, the amino may be linked to the main chain of the alkyl. Nature of the selected group may determine whether the first group is embedded in or linked to the second group.

A term "alkyl" as used herein is a branched or unbranched saturated hydrocarbon group with 1 to 60 carbon atoms, such as methyl, ethyl, n-propyl, isopropyl, n-butyl, isobutyl, sec-butyl, tert-butyl, n-pentyl, isopentyl, sec-pentyl, neopentyl, hexyl, heptyl, octyl, nonyl, decyl, dodecyl, tetradecyl, hexadecyl, eicosyl, tetracosyl and the like. The alkyl may be cyclic or acyclic. The alkyl group may be branched or unbranched. The alkyl may also be substituted or unsubstituted. For example, the alkyl may be substituted with one or more group including, but not limit to, optionally substituted alkyl, cycloalkyl, alkoxy, amino, ether, halogen, hydroxy, nitro, silyl, sulfo-oxo and thiol as described herein.

A term "aryl" as used herein is a group containing any carbon-based aromatic group with 5 to 60 carbon atoms, including but not limited to phenyl, naphthyl, phenyl, biphenyl, phenoxyphenyl, anthracenyl, phenanthrenyl, and the like. A term "aryl" also includes "heteroaryl", which is defined as a group containing an aromatic group having at least one heteroatom introduced into a ring of the aromatic group. Examples of heteroatoms include, but are not limited to, a nitrogen, oxygen, sulfur, and phosphorus atom. Likewise, a term "non-heteroaryl" (which is also included in the term "aryl") defines an aromatic-containing group that is free of heteroatoms. The aryl may be substituted or unsubstituted. The aryl may be substituted with one or more groups including, but not limited to, alkyl, cycloalkyl, alkoxy, alkenyl, cycloalkenyl, alkynyl, cycloalkynyl, aryl, heteroaryl, aldehyde, amino, carboxyl, ester, ether, halogen, hydroxy, carbonyl, azido, nitro, silyl, sulfo-oxo or thiol as described herein.

A term "amine" or "amino" as used herein is represented by the formula -NR¹R², where R₁ and R₂ may independently be selected from hydrogen, alkyl, cycloalkyl, alkenyl, cycloalkenyl, alkynyl, cycloalkynyl, aryl or heteroaryl.

The compound of that present disclosure may contain an "optionally substituted" moiety. In general, a term "substituted" (whether or not a term "optionally" exists before it) means that one or more hydrogen atoms of a given moiety are substituted with a suitable substituent. Unless otherwise stated, an "optionally substituted" group may have suitable substituents at each of substitutable positions of the group, and when more than one position in any given structure may be substituted with more than one substituent selected from groups designated, the substituents at each position may be the same or different. Combinations of substituents contemplated in the present disclosure are preferably those that form stable or chemically feasible compounds. It is also included that in certain aspects, respective substituents may be further optionally substituted (i. e., further substituted or unsubstituted) unless explicitly stated to the contrary.

A structure of the compound may be represented by a following formula: 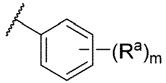 which is understood as equivalent to a following formula: 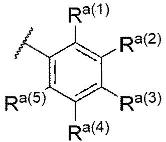 where n is typically an integer. That is, Rⁿ is understood to represent five individual substituents, namely, R^{a(1)}, Ra⁽²⁾, Ra⁽³⁾, Ra⁽⁴⁾ and R^{a(5)}. "individual substituents" means that each R substituent may be defined independently. For example, if R^{a(m)} is halogen in one case, R^{a(n)} is not necessarily halogen in this case.

The compound disclosed herein can exhibit desirable properties and have emission and/or absorption spectra that can be adjusted by selecting appropriate ligands. On the other hand, any one or more compounds, structures or parts thereof specifically described herein can be excluded in the disclosure.

The compound according to the present disclosure can be prepared in various methods, including but not limited to those described in examples provided herein.

It should be noted that both the above general description and the following detailed description are exemplary and explanatory only, but not limiting.

The present disclosure may be more readily understood by reference to the following detailed description and examples included therein.

Before compounds, devices, and/or methods of the present disclosure are disclosed and described, it should be understood that they are not limited to specific synthetic methods (unless otherwise specified) or specific reagents (unless otherwise specified), as these may vary. It should also be understood that terminologies used in the present disclosure is for a purpose of describing specific aspects only and is not intended to be limiting. While any method and material similar or equivalent to those described herein may be used in this practice or test, example methods and materials are described below. All of raw materials and solvents in synthesis embodiments can be available commercially unless otherwise specified, and the solvents are used directly without further treatment.

The substrate of the present disclosure can be any substrate used in typical organic photoelectric devices. It can be a glass substrate or transparent plastic substrate, a substrate of an opaque material such as silicon or stainless steel, or a flexible PI film. Different substrates have different mechanical strength, thermal stability, transparency, surface smoothness and waterproofness, with different use according to properties of the substrates. As materials of a hole injection layer, a hole transport layer and an electron injection layer, any material can be selected from known related materials used for OLED devices, which is not specifically limited in the present disclosure.

### Synthetic example

Following examples about compound synthesis, components, devices or methods are only to provide a general method for the industry, and are not intended to limit a protection scope of the disclosure. Data mentioned in the disclosure (number, temperature, etc.) are as accurate as possible, but there may be some errors. Unless otherwise specified, weighing is made separately, the temperature is in °C, or a normal temperature, and a pressure is close to a normal pressure.

A preparation method of a new compound is provided in following examples, but the preparation of such compounds is not limited thereto. In this technical field, because the claimed compound in this disclosure is easy to be modified and prepared, following methods or other methods can be adopted in its preparation. The following examples are only embodiments and are not intended to limit the protection scope of this disclosure. Temperature, catalyst, concentration, reactants and reaction processes can all be changed so as to select different conditions for different reactants for preparing the compound.

¹H NMR(500 MHz), ¹H NMR(400 MHz) and ¹³C NMR(126 MHz) spectra were measured on an ANANCE III (500 m) nuclear magnetic resonance spectrometer, in which, unless otherwise specified, DMSO-d₆ or CDCl₃ containing 0.1% TMS is used as a solvent, and when CDCl₃ is used as a solvent for a ¹H NMR spectrum, TMS (δ= 0.00 ppm) is used as an internal standard; and when DMSO-d₆ is used as the solvent, TMS (δ = 0.00 ppm) or a residual DMSO peak (δ= 2.50 ppm) or a residual water peak (δ = 3.33 ppm) is used as the internal standard. In a ¹³C NMR spectrum, CDCl₃ (δ= 77.00 ppm) or DMSO-d₆ (δ = 39.52 ppm) was used as the internal standard. It is measured on a HPLC-MS Agilent 6210 TOF LC/MS mass spectrometer; and a HRMS spectrum is measured on an Agilent 6210 TOF LC/MS liquid chromatography-time-of-flight mass spectrometer. In ¹H NMR spectrogram data, s means singlet, d means doublet, t means triplet, q means quart, p means quintet, m means multiplet, and br means broad.

### Synthesis of Intermediate 1

Synthetic route of intermediate 1 is as follows. 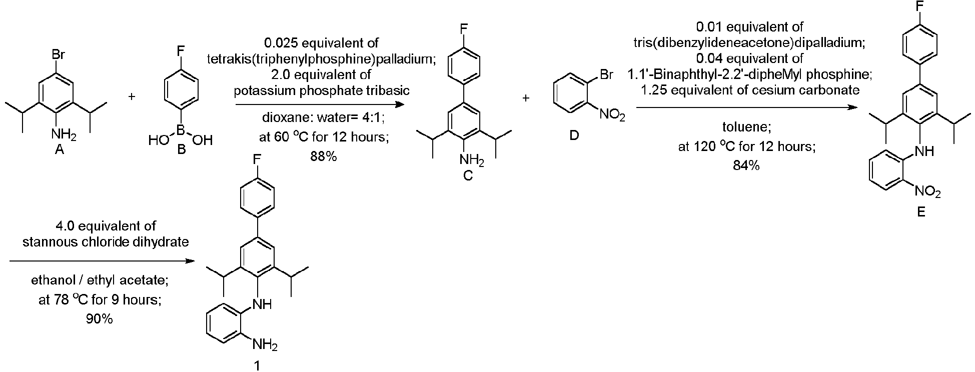
(1) A (256 mg, 1.0 mmol, 1.0 equivalent), B(210 mg, 1.5 mmol, 1.5 equivalent), tetrakis(triphenylphosphine)palladium (29mg, 0.025 mmol, 0.025 equivalent) and potassium phosphate tribasic (425 mg, 2.0 mmol, 2.0 equivalent) were added into a dry seal tube with a magnetic rotor. Nitrogen was purged for three times, dioxane (8 mL) and water (2 mL) were added under nitrogen protection, and this mixture was reacted with stirring in an oil bath at 60°C for 12 hours, and cooled to room temperature, and then solvent was distilled off at a reduced pressure. A resultant crude was separated and purified by a silica gel chromatography column with an eluent of petroleum ether/dichloromethane of 2:1 so as to obtain a product C, 183 mg as red liquid, with a yield of 88%. The liquid was directly used in a next step.
(2) C (180 mg, 0.71 mmol, 1.0 equivalent), D (130 mg, 0.65 mmol, 1.1 equivalent), tris(dibenzylideneacetone)dipalladium (6 mg, 0.065 mmol, 0.01 equivalent), 1.1'-Binaphthyl-2.2'-dipheMyl phosphine (16 mg, 0.026 mmol, 0.04 equivalent) and cesium carbonate (263 mg, 0.81 mmol, 1.25 equivalent) were added in turn into a dry seal tube with a magnetic rotor. Nitrogen was purged for three times, toluene (5 mL) was added under nitrogen protection, and this mixture was reacted with stirring in an oil bath at 120 °C for 12 hours, and cooled to room temperature, and then solvent was distilled off at a reduced pressure. A resultant crude was separated and purified by a silica gel chromatography column with an eluent of petroleum ether/dichloromethane of 10:1 so as to obtain a product E, 981 mg as yellow solid, with a yield of 84%. The solid was directly used in a next step.
(3) E (6.52 g, 17.4 mmol, 1.0 equivalent), stannous chloride dihydrate (16 g, 69.6 mmol, 4.0 equivalent) were added into a dry seal tube with a magnetic rotor. Nitrogen was purged for three times, ethanol (60 mL) and ethyl acetate (60 mL) were added under nitrogen protection, and this mixture was reacted with stirring in an oil bath at 78 °C for 9 hours, and cooled to room temperature, and then solvent was distilled off at a reduced pressure. A resultant crude was separated and purified by a silica gel chromatography column with an eluent of petroleum ether/dichloromethane of 5:1 so as to obtain a intermediate 1, 5.7 g as purple solid, with a yield of 90%.

### Synthesis of Intermediate 1-Cl

Synthetic route of intermediate 1-Cl is as follows. 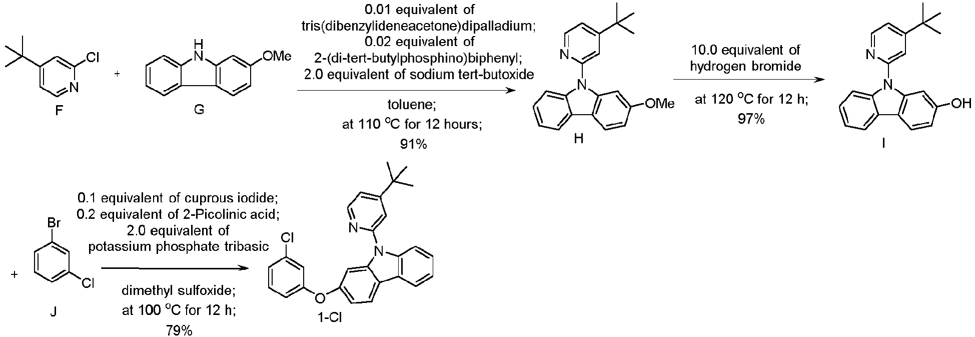
(1) F (10 g, 50.7 mmol, 1.0 equivalent), G (13 g, 60.8 mmol, 1.2 equivalent), tris(dibenzylideneacetone)dipalladium (464 mg, 0.5 mmol, 0.01 equivalent), 2-(di-tert-butylphosphino)biphenyl (303 mg, 1.0 mmol, 0.02 equivalent) and sodium tert-butoxide (9.7 g, 101 mmol, 2.0 equivalent) were added in turn into a dry seal tube with a magnetic rotor. Nitrogen was purged for three times, toluene (80 mL) was added under nitrogen protection, and this mixture was reacted with stirring in an oil bath at 110 °C for 12 hours, and cooled to room temperature, and then solvent was distilled off at a reduced pressure. A resultant crude was separated and purified by a silica gel chromatography column with an eluent of petroleum ether/ethyl acetate of 30: 1 so as to obtain a product **H,** 15 g as yellow oily liquid , with a yield of 91%.
(2) **H** (28 g, 84.7 mmol, 1.0 equivalent), hydrogen bromide (69 g, 0.847 mmol, 10.0 equivalent) were added into a dry seal tube with a magnetic rotor. This mixture was reacted with stirring in an oil bath at 120 °C for 12 hours, and cooled to room temperature, and then solvent was distilled off at a reduced pressure. A resultant crude product was pulped and filtered to obtain a product**I,** 26 g as white solid, with a yield of 97%.
(3) **I (5** g, 15.8 mmol, 1.0 equivalent), J (3.3 g, 17.4 mmol, 1.1 equivalent), cuprous iodide (300 mg, 1.58 mmol, 0.1 equivalent), 2-picolinic acid (389 mg, 3.16 mmol, 0.2 equivalent) and potassium phosphate tribasic (6.7 g, 31.6 mmol, 2.0 equivalent) were added in turn into a dry seal tube with a magnetic rotor. Nitrogen was purged for three times, dimethyl sulfoxide (50 mL) was added under nitrogen protection, and this mixture was reacted with stirring in an oil bath at 100 °C for 12 hours, and cooled to room temperature, and then solvent was distilled off at a reduced pressure. A resultant crude was separated and purified by a silica gel chromatography column with an eluent of petroleum ether/ethyl acetate of 20: 1 so as to obtain the intermediate **1-Cl,** 5.3 g as white solid, with a yield of 79%.

It is noted that the above only provides a feasible preparation scheme of one of intermediates in the present disclosure, and intermediates needed in respective examples can be prepared by referred to a synthesis process of intermediate 1 or intermediate 1-Cl. Preparation of this kind of intermediate compound is not limited to this method. Methods listed above or other methods known in the art can be adopted in its preparation. A scope of protection of the present disclosure is not limited thereto.

### Example 1: Synthesis of Pt1

Synthesis route of tetradentate cyclometalated platinum (II) complex-based phosphorescent luminescent material Pt1 is as follows:

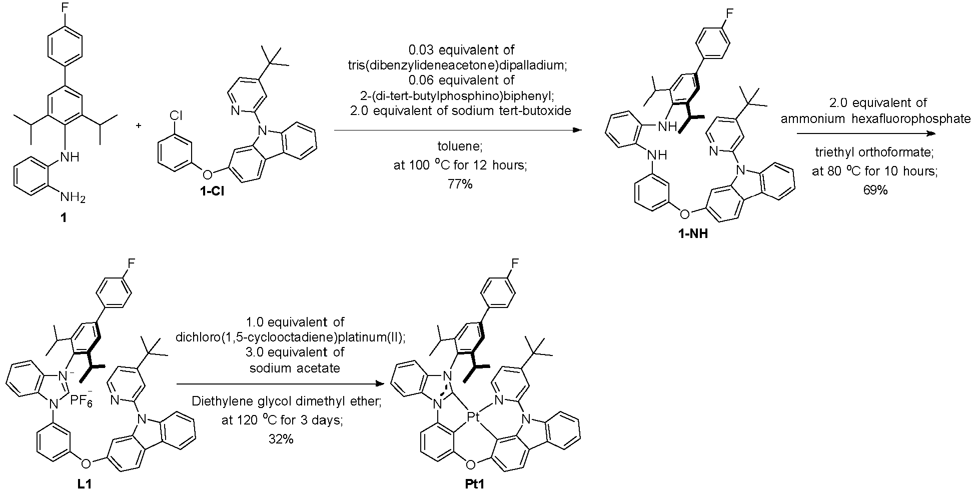

Synthesis of intermediate (1-NH); 1 (363 mg, 1.0 mmol, 1.0 equivalent), 1-Cl (470 mg, 1.1 mmol, 1.1 equivalent), tris(dibenzylideneacetone)dipalladium (27 mg, 0.03 mmol, 0.03 equivalent), 2-(di-tert-butylphosphino)biphenyl (18 mg, 0.06 mmol, 0.06 equivalent) and sodium tert-butoxide (192 mg, 2.0 mmol, 2.0 equivalent) were added in turn into a dry seal tube with a magnetic rotor. Nitrogen was purged for three times, toluene (5 mL) was added under nitrogen protection, and this mixture was reacted with stirring in an oil bath at 100 °C for 12 hours, and cooled to room temperature, and then solvent was distilled off at a reduced pressure. The crude was separated and purified by a silica gel chromatography column with an eluent of petroleum ether/ethyl acetate of 30: 1 so as to obtain a product 1-NH, 580 mg as pale green foamy solid, with a yield of 77%. The solid was directly used in a next step.

Synthesis of ligand L1; 1-NH (580 mg, 0.77 mmol, 1.0 equivalent), ammonium hexafluorophosphate (251 mg, 1.54 mmol, 2.0 equivalent) were added into a dry seal tube with a magnetic rotor. Nitrogen was purged for three times, triethyl orthoformate (10 mL) was added under nitrogen protection, and this mixture was reacted with stirring in an oil bath at 80 °C for 10 hours, and cooled to room temperature, and then solvent was distilled off at a reduced pressure. A resultant crude was separated and purified by a silica gel chromatography column with an eluent of dichloromethane so as to obtain a product L1, 483 mg as pale green foamy solid, with a yield of 69%. ¹H NMR (500 MHz, DMSO-d₆): δ 1.09 (d, *J* = 7.0 Hz, 6H), 1.19 (d, *J* = 7.0 Hz, 6H), 1.32 (s, 9H), 2.36-2.42 (m, 2H), 7.24 (dd, *J* = 8.5, 6.0 Hz, 1H), 7.33 - 7.40 (m, 3H), 7.45 - 7.51 (m, 3H), 7.55 (d, *J* = 2.5 Hz, 1H), 7.62 (d, *J* = 8.0 Hz, 1H), 7.69 - 7.76 (m, 5H), 7.79 (q, *J* = 3.0 Hz, 4H), 7.88 - 7.93 (m, 2H), 8.01 (d, *J* = 8.0 Hz, 1H), 8.26 (d, *J* = 8.0 Hz, 1H), 8.35 (d, *J* = 8.5 Hz, 1H), 8.60 (d, *J* = 5.5 Hz, 1H), 10.62 (s, 1H).

Synthetic of Pt1: L1 (483 mg, 0.53 mmol, 1.0 equivalent), dichloro(1,5-cyclooctadiene)platinum(II) (198 mg, 0.53 mmol, 1.0 equivalent) and sodium acetate (216 mg, 1.59 mmol, 3.0 equivalent) were added in turn into a dry seal tube with a magnetic rotor. Nitrogen was purged for three times, and diethylene glycol dimethyl ether (30 mL) was added under nitrogen protection. After bubbling with nitrogen for 30 minutes, the tube was wrapped with tin foil paper to avoid light, and this mixture was reacted with stirring in an oil bath at 120°C for 3 days, cooled to room temperature, and stirred for 5 to 10 minutes with deionized water added for quenching, and then dichloromethane was added for extracting, and organic phases were combined and dried with anhydrous sodium sulfate, and solvent was distilled off at a reduced pressure. A resultant crude was separated and purified by a silica gel chromatography column with an eluent of petroleum ether/dichloromethane of 2: 1 so as to obtain a product Pt1, 162 mg as yellow solid, with a yield of 32%. ¹H NMR (500 MHz, DMSO-d₆): δ 0.97 (s, 9H), 1.14 (d, *J* = 6.5 Hz, 6H), 1.17 (d, *J* = 6.5 Hz, 6H), 2.84 - 2.92 (m, 2H), 6.36 (dd, *J* = 6.5, 4.5 Hz, 1H), 6.78 (*d, J* = 1.0 Hz, 1H), 7.14 (d, *J* = 8.0 Hz, 1H), 7.27 (d, *J* = 8.0 Hz, 1H),7.30 (d, *J* = 7.5 Hz, 2H), 7.37-7.41 (m, 5H), 7.46-7.52 (m, 2H), 7.54(s, 1H), 7.86 (d, *J =* 8.0 Hz, 2H), 7.89 (d, *J* = 8.5 Hz, 1H), 7.97 (dd, *J =* 9.0, 5.5 Hz, 2H), 8.14 (d, *J* = 7.0 Hz, 1H), 8.27 (d, *J* = 8.5 Hz, 1H), 8.65 (d, *J* = 6.0 Hz, 1H).

### Example 2: Synthesis of Pt2

Synthesis route of tetradentate cyclometalated platinum (II) complex-based phosphorescent luminescent material Pt2 is as follows:

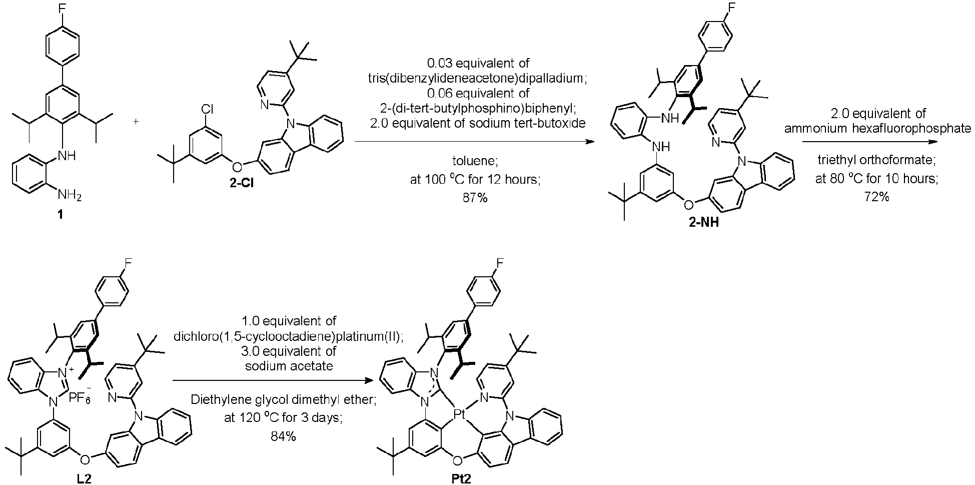

Synthesis of intermediate (2-NH); 1 (363 mg, 1.0 mmol, 1.0 equivalent), 2-Cl (531 mg, 1.1 mmol, 1.1 equivalent), tris(dibenzylideneacetone)dipalladium (27 mg, 0.03 mmol, 0.03 equivalent), 2-(di-tert-butylphosphino)biphenyl (18 mg, 0.06 mmol, 0.06 equivalent) and sodium tert-butoxide (192 mg, 2.0 mmol, 2.0 equivalent) were added in turn into a dry seal tube with a magnetic rotor. Nitrogen was purged for three times, toluene (5 mL) was added under nitrogen protection, and this mixture was reacted with stirring in an oil bath at 100 °C for 12 hours, and cooled to room temperature, and then solvent was distilled off at a reduced pressure. The crude was separated and purified by a silica gel chromatography column with an eluent of petroleum ether/ethyl acetate of 30: 1 so as to obtain a product 2-NH, 530 mg as pale green foamy solid, with a yield of 87%. The solid was directly used in a next step.

Synthesis of ligand L2: 2-NH (702 mg, 0.64 mmol, 1.0 equivalent), ammonium hexafluorophosphate (203 mg, 1.84 mmol, 2.0 equivalent) were added into a dry seal tube with a magnetic rotor. Nitrogen was purged for three times, triethyl orthoformate (10 mL) was added under nitrogen protection, and this mixture was reacted with stirring in an oil bath at 80 °C for 10 hours, and cooled to room temperature, and then solvent was distilled off at a reduced pressure. A resultant crude was separated and purified by a silica gel chromatography column with an eluent of dichloromethane so as to obtain a product L2, 600 mg as pale green foamy solid, with a yield of 72%. ¹H NMR (500 MHz, DMSO): δ 1.15 (d, *J =* 5.0 Hz, 6H), 1.24 (d, *J =* 5.0 Hz, 6H), 1.37 (s, 9 H), 1.43 (s, 9 H), 2.39 - 2.48 (m, 2H), 7.29 (dd, *J =* 8.0, 6.0 Hz, 1H), 7.37 - 7.47 (m, 3H), 7.49 - 7.58 (m, 3H), 7.58 (t, *J =* 2.5 Hz, 1H), 7.59 (d, *J =* 2.5 Hz, 1H), 7.69 (d, *J =* 8.0 Hz, 1H), 7.74 (q, *J =* 2.0 Hz, 2H), 7.77-7.82 (m, 3H), 7.84 (s, 2H), 7.94-7.98 (m, 2H), 8.02 (d, *J =* 8.0 Hz, 1H), 8.30 (d, *J* = 8.0 Hz, 1H), 8.39 (d, *J* = 8.5 Hz, 1H), 8.64 (d, *J* = 5.0 Hz, 1H), 10.70 (s, 1H).

Synthetic route of Pt2: L2 (600 mg, 0.62 mmol, 1.0 equivalent), dichloro(1,5-cyclooctadiene)platinum(II) (221 mg, 0.59 mmol, 1.0 equivalent) and sodium acetate (153 mg, 1.87 mmol, 3.0 equivalent) were added in turn into a dry seal tube with a magnetic rotor. Nitrogen was purged for three times, and diethylene glycol dimethyl ether (30 mL) was added under nitrogen protection. After bubbling with nitrogen for 30 minutes, the tube was wrapped with tin foil paper to avoid light, and this mixture was reacted with stirring in an oil bath at 120°C for 3 days, cooled to room temperature, and stirred for 5 to 10 minutes with deionized water added for quenching, and then dichloromethane was added for extracting, and organic phases were combined and dried with anhydrous sodium sulfate, and solvent was distilled off at a reduced pressure. A resultant crude was separated and purified by a silica gel chromatography column with an eluent of petroleum ether/dichloromethane of 2:1 so as to obtain a product Pt2, 100 mg as yellow solid, with a yield of 84%. ¹H NMR (500 MHz, DMSO-d₆): δ 0.94 - 1.29 (m, 21H), 1.49 (s, 9H), 2.70-3.01 (m, 2H), 6.34 (dd, *J* = 6.0, 4.0 Hz, 1H), 7.06 (d, *J* = 1.5 Hz, 1H), 7.14 (d, *J* = 8.5 Hz, 1H), 7.26 (d, *J* = 8.5 Hz, 1H), 7.35-7.45 (m, 5H), 7.49 (t*, J* = 6.0 Hz, 1H), 7.59 (t*, J* = 8.5 Hz, 1H), 7.66 (s, 1H), 7.73 (d, *J* = 1.5 Hz, 1H), 7.84 (d, *J* = 8.5 Hz, 2H), 7.87 (d, *J* = 8.5 Hz, 1H), 7.93 - 8.01 (m, 2H), 8.13 (d, *J* = 8.0 Hz, 1H), 8.36 (d, *J* = 8.5 Hz, 1H), 8.59 (d, *J* = 6.5 Hz, 1H).

### Example 3: Synthesis of Pt3

Synthesis route of tetradentate cyclometalated platinum (II) complex-based phosphorescent luminescent material Pt3 is as follows:

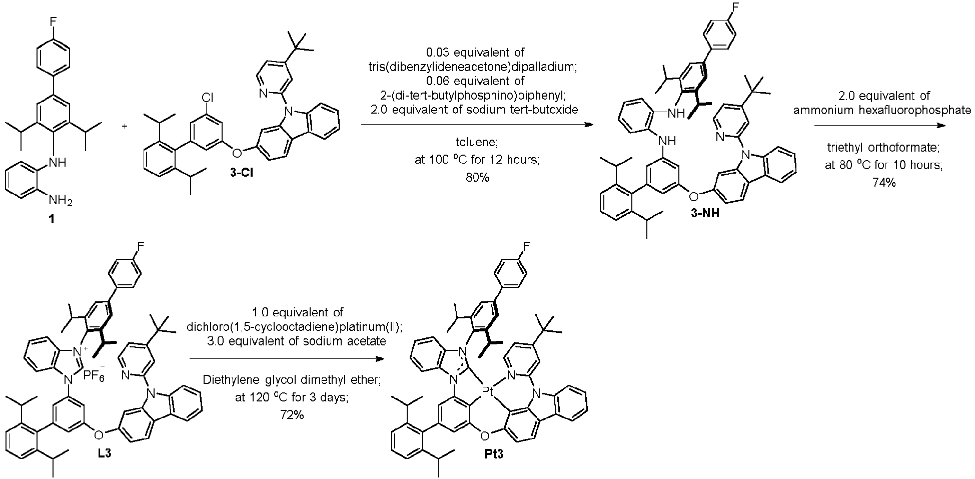

Synthesis of intermediate (3-NH); 1 (363 mg, 1.0 mmol, 1.0 equivalent), 3-Cl (646 mg, 1.1 mmol, 1.1 equivalent), tris(dibenzylideneacetone)dipalladium (27 mg, 0.03 mmol, 0.03 equivalent), 2-(di-tert-butylphosphino)biphenyl (18 mg, 0.06 mmol, 0.06 equivalent) and sodium tert-butoxide (192 mg, 2.0 mmol, 2.0 equivalent) were added in turn into a dry seal tube with a magnetic rotor. Nitrogen was purged for three times, toluene (5 mL) was added under nitrogen protection, and this mixture was reacted with stirring in an oil bath at 100 °C for 12 hours, and cooled to room temperature, and then solvent was distilled off at a reduced pressure. The crude was separated and purified by a silica gel chromatography column with an eluent of petroleum ether/ethyl acetate of 30: 1 so as to obtain a product 3-NH, 730 mg as pale green foamy solid, with a yield of 80%. The solid was directly used in a next step.

Synthesis of ligand L3: 3-NH (730 mg, 0.64 mmol, 1.0 equivalent), ammonium hexafluorophosphate (261 mg, 1.60 mmol, 2.0 equivalent) were added into a dry seal tube with a magnetic rotor. Nitrogen was purged for three times, triethyl orthoformate (10 mL) was added under nitrogen protection, and this mixture was reacted with stirring in an oil bath at 80 °C for 10 hours, and cooled to room temperature, and then solvent was distilled off at a reduced pressure. A resultant crude was separated and purified by a silica gel chromatography column with an eluent of dichloromethane so as to obtain a product L3, 633 mg as pale green foamy solid, with a yield of 74%. ¹H NMR (500 MHz, DMSO-d₆): δ 0.93 (d, *J* = 4.5 Hz, 6H), 1.10 (t, *J* = 6.5 Hz, 12H), 1.20 (d, *J* = 6.5 Hz, 6H), 1.34 (s, 9H), 2.39-2.45 (m, 2H), 2.58-2.64 (m, 2H), 7.09 (dd, *J* = 2.0, 1.0 Hz, 1H), 7.22 (d, *J* =7.5 Hz, 2H), 7.28 (dd, *J* = 8.5, 6.0 Hz, 1H), 7.33-7.40 (m, 4H), 7.46-7.53 (m, 3H), 7.57 (d, *J* = 2.5 Hz, 1H), 7.66 (d, *J* = 8.5 Hz, 1H), 7.71-7.79 (m, 3H), 7.80 (s, 2H), 7.83 (t, *J* = 8.5 Hz, 1H), 7.87 (t, *J =* 2.5 Hz, 1H), 7.89-7.93 (m, 2H), 8.02 (d, *J =* 8.0 Hz, 1H), 8.26 (d, *J =* 7.5 Hz, 1H), 8.36 (d, *J =* 8.5 Hz, 1H), 8.60 *(d, J=* 5.5 Hz, 1H), 10.65 (s, 1H).

Synthesis of Pt3: L3 (633 mg, 0.59 mmol, 1.0 equivalent), dichloro(1,5-cyclooctadiene)platinum(II) (222 mg, 0.59 mmol, 1.0 equivalent) and sodium acetate (241 mg, 1.78 mmol, 3.0 equivalent) were added in turn into a dry seal tube with a magnetic rotor. Nitrogen was purged for three times, and diethylene glycol dimethyl ether (30 mL) was added under nitrogen protection. After bubbling with nitrogen for 30 minutes, the tube was wrapped with tin foil paper to avoid light, and this mixture was reacted with stirring in an oil bath at 120°C for 3 days, cooled to room temperature, and stirred for 5 to 10 minutes with deionized water added for quenching, and then dichloromethane was added for extracting, and organic phases were combined and dried with anhydrous sodium sulfate, and solvent was distilled off at a reduced pressure. A resultant crude was separated and purified by a silica gel chromatography column with an eluent of petroleum ether/dichloromethane of 2:1 so as to obtain a product Pt3, 476 mg as yellow solid, with a yield of 72%. ¹H NMR (500 MHz, DMSO-d₆): δ 0.70 - 1.64 (m, 33H), 2.77 - 3.21 (m, 4H), 6.34 (dd, *J* = 6.0, 4.0 Hz, 1H), 7.06 (d, *J* = 8.0 Hz, 1H), 7.13 (d, *J* = 8.0 Hz, 1H), 7.26 (d, *J* = 8.0 Hz, 1H), 7.31-7.79 (m, 11H), 7.80-7.91 (m, 4H), 7.97 (dd, *J* = 5.5, 3.0 Hz, 2H), 8.13 (d, *J= 6.5 Hz,* 1H), 8.45 (d, *J* =8.0 Hz, 1H), 8.61 (d, *J* = 5.0 Hz, 1H).

### Example 4: Synthesis of Pt4

Synthesis route of tetradentate cyclometalated platinum (II) complex-based phosphorescent luminescent material Pt4 is as follows:

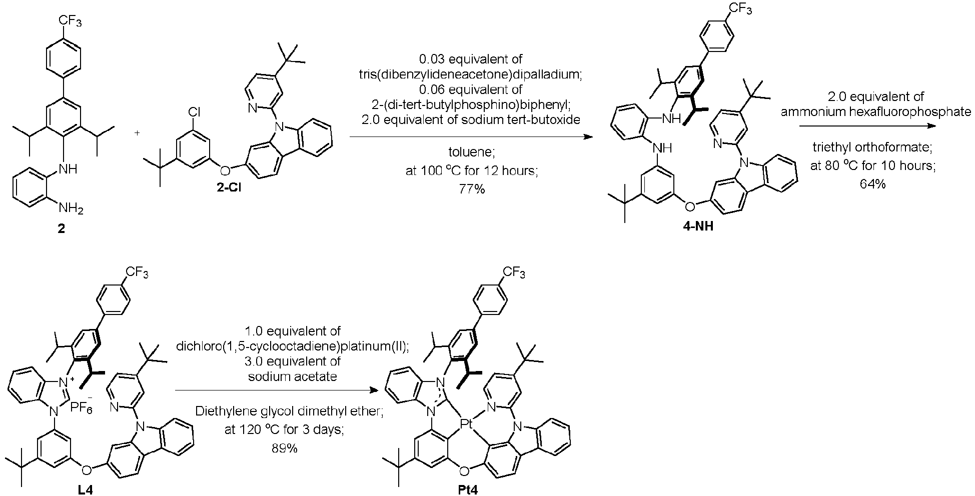

Synthesis of Intermediate 4-NH 2 (413 mg, 1.0 mmol, 1.0 equivalent), 2-Cl (531 mg, 1.1 mmol, 1.1 equivalent), tris(dibenzylideneacetone)dipalladium (27 mg, 0.03 mmol, 0.03 equivalent), 2-(di-tert-butylphosphino)biphenyl (18 mg, 0.06 mmol, 0.06 equivalent) and sodium tert-butoxide (192 mg, 2.0 mmol, 2.0 equivalent) were added in turn into a dry seal tube with a magnetic rotor. Nitrogen was purged for three times, toluene (5 mL) was added under nitrogen protection, and this mixture was reacted with stirring in an oil bath at 100 °C for 12 hours, and cooled to room temperature, and then solvent was distilled off at a reduced pressure. The crude was separated and purified by a silica gel chromatography column with an eluent of petroleum ether/ethyl acetate of 30: 1 so as to obtain a product 4-NH, 661 mg as pale green foamy solid, with a yield of 77%. Because the solid is easy to be oxidized and unstable, it is directly used in a next step.

Synthesis of ligand L4: 4-NH (661 mg, 0.77 mmol, 1.0 equivalent), ammonium hexafluorophosphate (251 mg, 1.54 mmol, 2.0 equivalent) were added into a dry seal tube with a magnetic rotor. Nitrogen was purged for three times, triethyl orthoformate (10 mL) was added under nitrogen protection, and this mixture was reacted with stirring in an oil bath at 80 °C for 10 hours, and cooled to room temperature, and then solvent was distilled off at a reduced pressure. A resultant crude was separated and purified by a silica gel chromatography column with an eluent of dichloromethane so as to obtain a product L4, 500 mg as pale green foamy solid, with a yield of 64%. ¹H NMR (500 MHz, DMSO-d₆): δ 1.10 (d, *J* = 7.0 Hz, 6H), 1.19 (d, *J* = 6.5 Hz, 6H), 1.30 (s, 9H), 1.36 (s, 9H), 2.36-2.43 (m, 2H), 7.24 (dd, *J* = 8.5, 6.5 Hz,1H), 7.34 (t, *J* = 8.0 Hz, 1H), 7.45 - 7.54 (m, 5H), 7.65 (d, *J* =7.5 Hz, 1H),7.66 - 7.69 (m, 2H), 7.72 - 7.78 (m, 3H), 7.87 (s, 2H), 7.89 (d, *J* = 8.5 Hz, 2H), 7.96 (dd, *J* =8.0, 6.5 Hz,1H), 8.07 (d, *J* = 8.0 Hz, 2H), 8.24 (d, *J* = 7.5 Hz, 1H), 8.33 (d, *J* = 8.5 Hz, 1H), 8.58 (d, *J* = 5.5 Hz, 1H), 10.65 (s, 1H).

Synthesis of Pt4: L4 (500 mg, 0.49 mmol, 1.0 equivalent), dichloro(1,5-cyclooctadiene)platinum(II) (184 mg, 0.49 mmol, 1.0 equivalent) and sodium acetate (201 mg, 1.48 mmol, 3.0 equivalent) were added in turn into a dry seal tube with a magnetic rotor. Nitrogen was purged for three times, and diethylene glycol dimethyl ether (30 mL) was added under nitrogen protection. After bubbling with nitrogen for 30 minutes, the tube was wrapped with tin foil paper to avoid light, and this mixture was reacted with stirring in an oil bath at 120°C for 3 days, cooled to room temperature, and stirred for 5 to 10 minutes with deionized water added for quenching, and then dichloromethane was added for extracting, and organic phases were combined and dried with anhydrous sodium sulfate, and solvent was distilled off at a reduced pressure. A resultant crude was separated and purified by a silica gel chromatography column with an eluent of petroleum ether/dichloromethane of 2:1 so as to obtain a product Pt4, 466 mg as yellow solid, with a yield of 89%. ¹H NMR (500 MHz, DMSO-d₆): δ 0.92-1.25 (m, 21H), 1.48 (s, 9H), 2.9-3.15 (m, 2H), 6.34 (dd, *J* = 4.0, 2.0 Hz, 1H), 7.06 (d, *J* = 1.5 Hz, 1H), 7.15 (d, *J =* 8.5 Hz, 1H), 7.25 (d, *J =* 8.5 Hz, 1H), 7.36 (t, *J =* 7.5 Hz, 1H), 7.43 (t, *J =* 7.5 Hz, 1H), 7.44-7.51 (m, 1H), 7.59 (t, *J* = 7.5 Hz, 1H), 7.67-7.84 (m, 5H), 7.87 (d, *J* = 8.5 Hz, 1H), 7.90 (d, *J* = 8.0 Hz, 2H), 8.11 (d, *J* = 7.5 Hz, 1H), 8.15 (d, *J* = 8.5 Hz, 2H), 8.36 (d, *J* = 8.0 Hz, 1H), 8.57 (d, *J* = 6.5 Hz, 1H).

### Example 5: Synthesis of Pt5

Synthesis route of tetradentate cyclometalated platinum (II) complex-based phosphorescent luminescent material Pt5 is as follows:

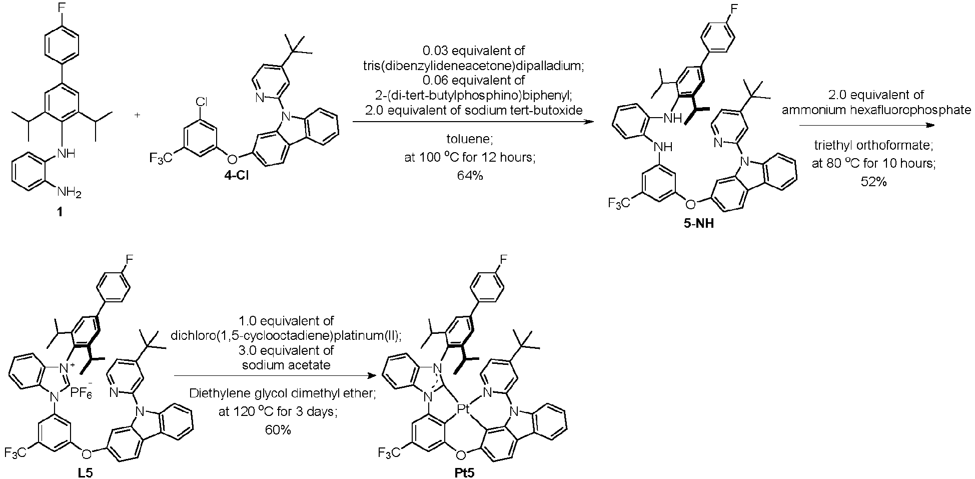

Synthesis of intermediate 5-NH; 1 (363 mg, 1.0 mmol, 1.0 equivalent), 4-Cl (545 mg, 1.1 mmol, 1.1 equivalent), tris(dibenzylideneacetone)dipalladium (27 mg, 0.03 mmol, 0.03 equivalent), 2-(di-tert-butylphosphino)biphenyl (18 mg, 0.06 mmol, 0.06 equivalent) and sodium tert-butoxide (192 mg, 2.0 mmol, 2.0 equivalent) were added in turn into a dry seal tube with a magnetic rotor. Nitrogen was purged for three times, toluene (5 mL) was added under nitrogen protection, and this mixture was reacted with stirring in an oil bath at 100 °C for 12 hours, and cooled to room temperature, and then solvent was distilled off at a reduced pressure. The crude was separated and purified by a silica gel chromatography column with an eluent of petroleum ether/ethyl acetate of 30: 1 so as to obtain a product 5-NH, 525 mg as pale green foamy solid, with a yield of 64%. The solid was directly used in reaction in a next step.

Synthesis of ligand L5: 5-NH (525 mg, 0.64 mmol, 1.0 equivalent), ammonium hexafluorophosphate (208 mg, 1.28 mmol, 2.0 equivalent) were added into a dry seal tube with a magnetic rotor. Nitrogen was purged for three times, triethyl orthoformate (10 mL) was added under nitrogen protection, and this mixture was reacted with stirring in an oil bath at 80 °C for 10 hours, and cooled to room temperature, and then solvent was distilled off at a reduced pressure. A resultant crude was separated and purified by a silica gel chromatography column with an eluent of dichloromethane so as to obtain a product L5, 325 mg as pale green foamy solid, with a yield of 52%. ¹H NMR (500 MHz, DMSO-d₆): δ 1.08 (d, *J =* 6.5 Hz, 6H), 1.18 (d, *J =* 7.0 Hz, 6H), 1.33 (s, 9H), 2.40-2.46 (m, 2H), 7.31 (dd, *J* = 8.0, 6.0 Hz, 1H), 7.36 (dd, *J* =5.0, 3.0 Hz, 1H), 7.39 (d, *J* = 2.0 Hz, 2H), 7.47-7.50 (m, 1H), 7.52 (dd, *J* =5.5, 4.0 Hz, 1H), 7.64 (t, *J* =3.5 Hz, 2H), 7.72 (d, *J* = 8.5 Hz, 2H), 7.74 - 7.79 (m, 2H), 7.80 (s, 2H), 7.83 (s, 1H), 7.88-7.95 (m, 2H), 8.03 (d, *J* = 8.5 Hz, 1H), 8.07 (t, *J* = 2.0 Hz, 1H), 8.19 (s, 1H), 8.28 (d, *J* = 8.0 Hz, 1H), 8.39 (d, *J* = 8.5 Hz, 1H), 8.61 (d, *J* =5.0 Hz, 1H), 10.64 (s, 1H).

Synthesis of Pt5: L5 (325 mg, 0.33 mmol, 1.0 equivalent), dichloro(1,5-cyclooctadiene)platinum(II) (124 mg, 0.33 mmol, 1.0 equivalent) and sodium acetate (136 mg, 1.0 mmol, 3.0 equivalent) were added in turn into a dry seal tube with a magnetic rotor. Nitrogen was purged for three times, and diethylene glycol dimethyl ether (30 mL) was added under nitrogen protection. After bubbling with nitrogen for 30 minutes, the tube was wrapped with tin foil paper to avoid light, and this mixture was reacted with stirring in an oil bath at 120°C for 3 days, cooled to room temperature, and stirred for 5 to 10 minutes with deionized water added for quenching, and then dichloromethane was added for extracting, and organic phases were combined and dried with anhydrous sodium sulfate, and solvent was distilled off at a reduced pressure. A resultant crude was separated and purified by a silica gel chromatography column with an eluent of petroleum ether/dichloromethane of 2:1 so as to obtain a product Pt5, 205 mg as yellow solid, with a yield of 60%. ¹H NMR (500 MHz, DMSO-d₆): δ 0.96-1.27 (m, 21H), 2.81-3.01 (m, 2H), 6.37 (dd, *J =* 6.0, 2.0 Hz, 1H), 7.17 (d, *J =* 8.5 Hz, 1H), 7.29 (d, *J* =8.5 Hz, 1H), 7.33 - 7.41 (m, 6H), 7.46 (t, *J* = 7.5 Hz, 1H), 7.51 (td, *J* = 8.5, 7.0 Hz, 1H), 7.59 (td, *J* =7.0, 6.0 Hz, 1H), 7.86 (d, *J* = 2.0 Hz, 1H), 7.88 (d, *J* =8.0 Hz, 2H), 7.95 - 7.99 (m, 3H), 8.15 (d, *J =* 6.5 Hz, 1H), 8.42 (d, *J =* 8.5 Hz, 1H), 8.59 (d, *J =* 6.0 Hz, 1H).

### Example 6: Synthesis of Pt6

Synthesis route of tetradentate cyclometalated platinum (II) complex-based phosphorescent luminescent material Pt6 is as follows:

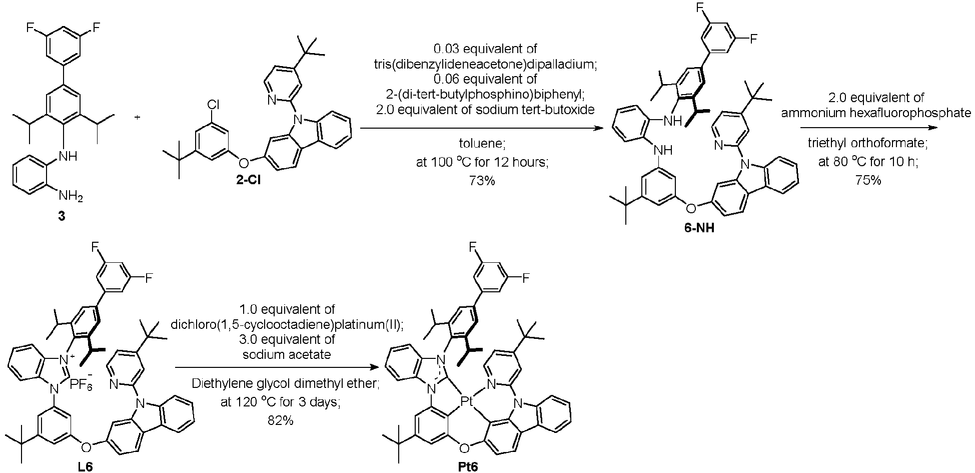

Synthesis of Intermediate 6-NH 3 (380 mg, 1.0 mmol, 1.0 equivalent), 2-Cl (531 mg, 1.1 mmol, 1.1 equivalent), tris(dibenzylideneacetone)dipalladium (27 mg, 0.03 mmol, 0.03 equivalent), 2-(di-tert-butylphosphino)biphenyl (18 mg, 0.06 mmol, 0.06 equivalent) and sodium tert-butoxide (192 mg, 2.0 mmol, 2.0 equivalent) were added in turn into a dry seal tube with a magnetic rotor. Nitrogen was purged for three times, toluene (5 mL) was added under nitrogen protection, and this mixture was reacted with stirring in an oil bath at 100 °C for 12 hours, and cooled to room temperature, and then solvent was distilled off at a reduced pressure. The crude was separated and purified by a silica gel chromatography column with an eluent of petroleum ether/ethyl acetate of 30: 1 so as to obtain a product 6-NH, 604 mg as pale green foamy solid, with a yield of 73%. The solid was directly used in reaction in a next step.

Synthesis of ligand L6: 6-NH (604 mg, 0.73 mmol, 1.0 equivalent), ammonium hexafluorophosphate (238 mg, 1.46 mmol, 2.0 equivalent) were added into a dry seal tube with a magnetic rotor. Nitrogen was purged for three times, triethyl orthoformate (10 mL) was added under nitrogen protection, and this mixture was reacted with stirring in an oil bath at 80 °C for 10 hours, and cooled to room temperature, and then solvent was distilled off at a reduced pressure. A resultant crude was separated and purified by a silica gel chromatography column with an eluent of dichloromethane so as to obtain a product L6, 538 mg as pale green foamy solid, with a yield of 75%. ¹H NMR (500 MHz, DMSO-d₆): δ 1.09 (d, *J* = 6.5 Hz, 6H), 1.18 (d, *J* = 7.0 Hz, 6H), 1.30 (s, 9H), 1.36 (s, 9H), 2.35-2.40 (m, 2H), 7.23 (dd, *J* = 8.5, 6.0 Hz, 1H), 7.31- 7.37 (m, 2H), 7.44-7.49 (m, 3H), 7.52 (t, *J* = 2.0 Hz, 1H), 7.53 (d, *J* = 2.5 Hz, 1H), 7.61 (d, *J* = 8.0 Hz, 1H), 7.66 - 7.79 (m, 7H), 7.89 (s, 2H), 7.96 (dd, *J* = 8.0, 6.5 Hz, 1H), 8.24 (dd, *J* = 7.5, 7.0 Hz, 1H), 8.33 (d, *J* = 8.5 Hz, 1H), 8.58 (d, *J* = 5.5 Hz, 1H), 10.64 (s, 1H).

Synthesis of Pt6: L6 (538 mg, 0.55 mmol, 1.0 equivalent), dichloro(1,5-cyclooctadiene)platinum(II) (206 mg, 0.55 mmol, 1.0 equivalent) and sodium acetate (223 mg, 1.64 mmol, 3.0 equivalent) were added in turn into a dry seal tube with a magnetic rotor. Nitrogen was purged for three times, and diethylene glycol dimethyl ether (30 mL) was added under nitrogen protection. After bubbling with nitrogen for 30 minutes, the tube was wrapped with tin foil paper to avoid light, and this mixture was reacted with stirring in an oil bath at 120°C for 3 days, cooled to room temperature, and stirred for 5 to 10 minutes with deionized water added for quenching, and then dichloromethane was added for extracting, and organic phases were combined and dried with anhydrous sodium sulfate, and solvent was distilled off at a reduced pressure. A resultant crude was separated and purified by a silica gel chromatography column with an eluent of petroleum ether/dichloromethane of 2:1 so as to obtain a product Pt6, 463 mg as yellow solid, with a yield of 82%. ¹H NMR (500 MHz, DMSO-d₆): δ 0.96-1.3 (m, 21H), 1.47 (s, 9H), 3.9-4.20 (m, 2H), 6.34 (dd, *J* =6.5, 6.0 Hz, 1H), 7.04 (d, *J* = 2.0 Hz, 1H), 7.11 (d, *J =* 8.5 Hz, 1H), 7.24 (d, *J =* 8.5 Hz, 1H), 7.28 - 7.33 (m, 1H), 7.36 (t, *J* = 7.5 Hz, 1H), 7.43 (t, *J =* 7.5 Hz, 1H), 7.47 (t, *J* =7.5 Hz, 1H), 7.58 (t, *J* =8.0 Hz, 1H), 7.68 - 7.88 (m, 8H), 8.10 (d, *J* = 8.0 Hz, 1H), 8.34 (d, *J* = 8.5 Hz, 1H), 8.53 (d, *J* = 6.5 Hz, 1H).

The prepared platinum complexes Pt1 and Pt4 to Pt6 were subjected to spectral testing experiments. FIG. 1 shows a room-temperature emission spectrum of the prepared platinum complexes Pt1 and Pt4 to Pt6 in a dichloromethane solution. As can be seen from FIG. 1, Pt1 and Pt4 to Pt6 all exhibit dark blue emission with high color purity. A maximum emission peak of Pt1 is 454 nm, which is dark blue emission with a peak half width of 19 nm. It can be seen in the disclosure that by introducing fluorine atoms into an appropriate part of a ligand, distribution of excited charges can be improved, so that this material has more metal-to-pyridine carbene charge transfer states (³MLCT), which facilitates improvement of radiation rate and thus improvement of service life of devices. It provides an effective way to design high-quality platinum (II) complexes of blue phosphorescent materials.

### Example 7: Synthesis of Pt225

Synthesis route of tetradentate cyclometalated platinum (II) complex-based phosphorescent luminescent material Pt225 is as follows:

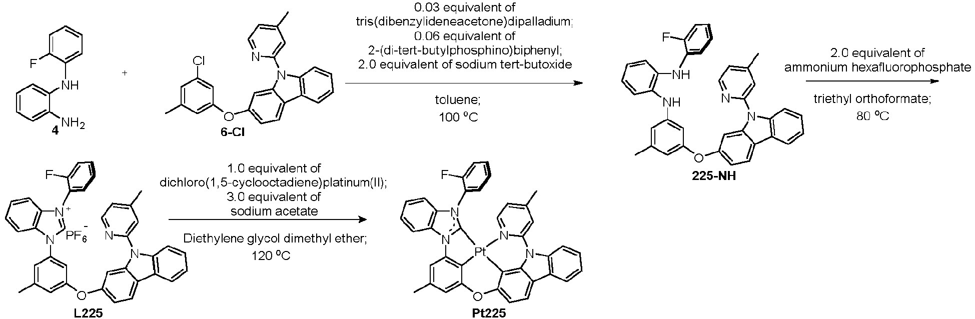

Referring to synthesis steps and reaction conditions of compound Pt1, Pt225 was synthesized. A target product 225-NH, 804 mg as pale green foamy solid, was synthesized with a yield of 77%. A target product L225, 705 mg as pale green foamy solid, was obtained with a yield of 63% and a molecular weight [M]⁺ of 721.6. A target product Pt225, 606 mg as yellow solid, was obtained with a yield of 82% and a molecular weight [M+H]⁺ of 767.7.

### Example 8: Synthesis of Pt16

Synthesis route of tetradentate cyclometalated platinum (II) complex-based phosphorescent luminescent material Pt16 is as follows:

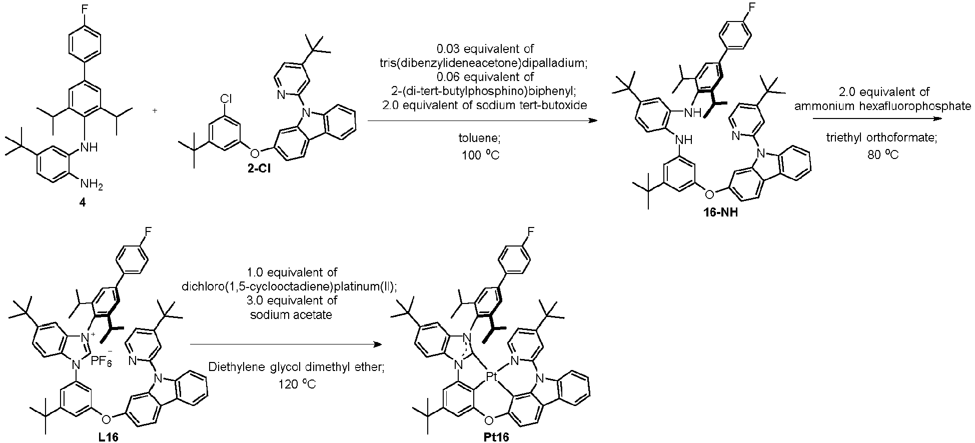

Referring to synthesis steps and reaction conditions of compound Pt1, Pt16 was synthesized. A target product 16-NH, 804 mg as pale green foamy solid, was synthesized with a yield of 77%. A target product L16, 705 mg as pale green foamy solid, was obtained with a yield of 63% and a molecular weight [M]⁺ of 876.4. A target product Pt16, 606 mg as yellow solid, was obtained with a yield of 82% and a molecular weight [M+H]⁺ of 1068.4.

### Example 9: Synthesis of Pt19

Synthesis route of tetradentate cyclometalated platinum (II) complex-based phosphorescent luminescent material Pt19 is as follows:

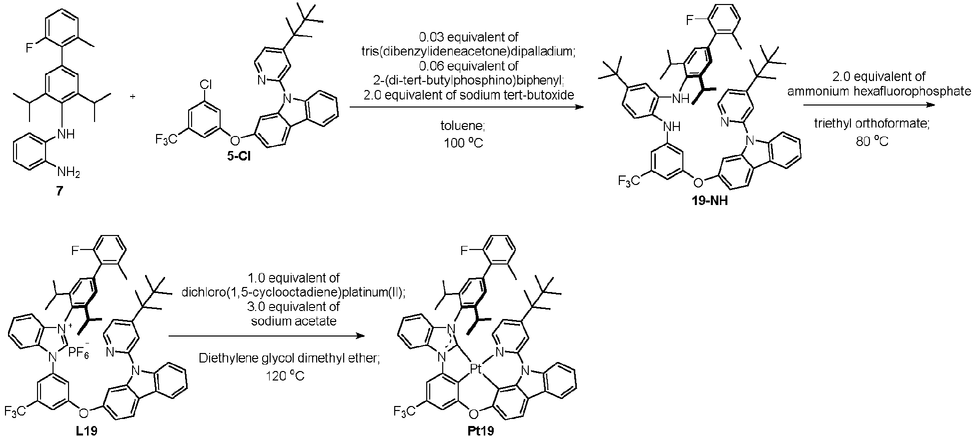

Referring to synthesis steps and reaction conditions of compound Pt1, Pt19 was synthesized. A target product 19-NH, 906 mg as pale green foamy solid, was synthesized with a yield of 79%. A target product L19, 509 mg as pale green foamy solid, was synthesized with a yield of 59% and a molecular weight [M]⁺ of 888.5. A target product Pt19, 203 mg as yellow solid, was obtained with a yield of 48% and a molecular weight [M+H]⁺ of 1080.2.

### Example 10: Synthesis of Pt21

Synthesis route of tetradentate cyclometalated platinum (II) complex-based phosphorescent luminescent material Pt21 is as follows:

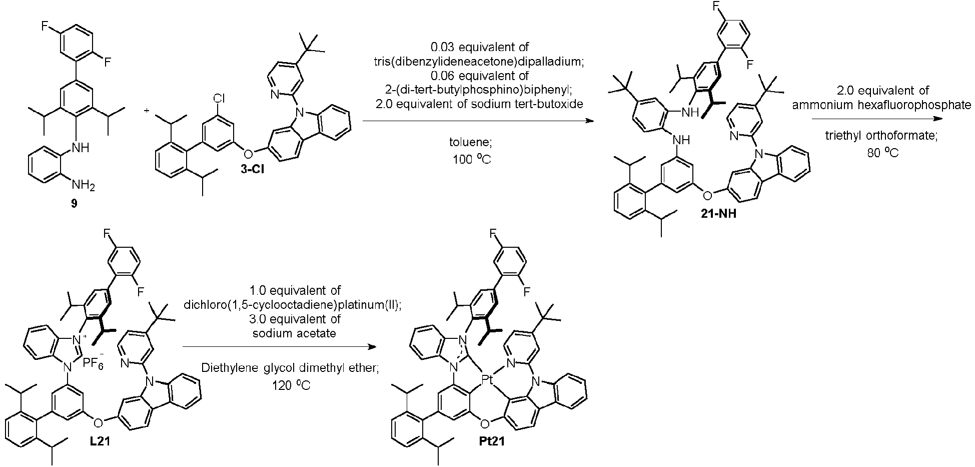

Referring to synthesis steps and reaction conditions of compound Pt1, Pt21 was synthesized. A target product 21-NH, 1.56 g as pale green foamy solid, was obtained with a yield of 61%. A target product L21, 705 mg as pale green foamy solid, was synthesized with a yield of 70% and a molecular weight [M]⁺ of 942.4. A target product **Pt21,** 432 mg as yellow solid, was obtained with a yield of 55% and a molecular weight [M+H]⁺ of 1134.5.

### Example 11: Synthesis of Pt24

Synthesis route of tetradentate cyclometalated platinum (II) complex-based phosphorescent luminescent material Pt24 is as follows:

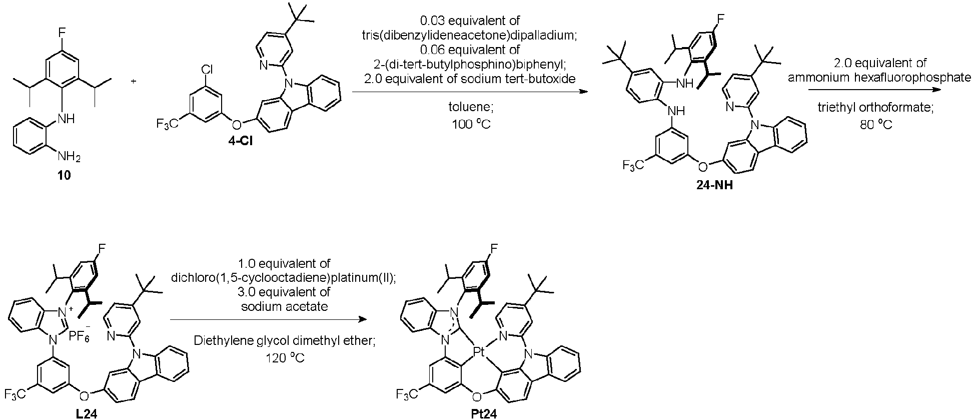

Referring to synthesis steps and reaction conditions of compound Pt1, Pt24 was synthesized. A target product 24-NH, 1.02 g as pale green foamy solid, was obtained with a yield of 75%. A target product L24, 708 mg as pale green foamy solid, was obtained with a yield of 63% and a molecular weight [M]⁺ of 756.4. A target product **Pt24,** 201 mg as yellow solid, was obtained with a yield of 50% and a molecular weight [M+H]⁺ of 948.3.

### Example 12: Synthesis of Pt37

Referring to synthesis steps and reaction conditions of compound Pt1, Pt37 was synthesized. A target product, 562 mg as yellow solid, was obtained with a yield of 70% and a molecular weight [M+H]⁺ of 1065.1.

### Example 13: Synthesis of Pt39

Referring to synthesis steps and reaction conditions of compound Pt1, Pt39 was synthesized. A target product, 624mg as yellow solid, was obtained with a yield of 56% and a molecular weight [M+H]⁺ of 1067.1.

### Example 14: Synthesis of Pt65

Referring to synthesis steps and reaction conditions of compound Pt1, Pt65 was synthesized. A target product, 661 mg as yellow solid, was obtained with a yield of 82% and a molecular weight [M+H]⁺ of 996.1.

### Example 15: Synthesis of Pt81

Referring to synthesis steps and reaction conditions of compound Pt1, Pt81 was synthesized. A target product, 484 mg as yellow solid, was obtained with a yield of 67% and a molecular weight [M+H]⁺ of 939.0.

### Example 16: Synthesis of Pt82

Referring to synthesis steps and reaction conditions of compound Pt1, Pt82 was synthesized. A target product, 455 mg as yellow solid, was obtained with a yield of 60% and a molecular weight [M+H]⁺ of 981.0.

### Example 17: Synthesis of Pt86

Referring to synthesis steps and reaction conditions of compound Pt1, Pt86 was synthesized. A target product, 410 mg as yellow solid, was obtained with a yield of 66% and a molecular weight [M+H]⁺ of 1019.1.

### Example 18: Synthesis of Pt111

Referring to synthesis steps and reaction conditions of compound Pt1, Pt111 was synthesized. A target product, 369mg as yellow solid, was obtained with a yield of 58% and a molecular weight [M+H]⁺ of 1080.2.

### Example 19: Synthesis of Pt112

Referring to synthesis steps and reaction conditions of compound Pt1, Pt112 was synthesized. A target product, 492 mg as yellow solid, was obtained with a yield of 82% and a molecular weight [M+H]⁺ of 1096.2.

### Example 20: Synthesis of Pt210

Referring to synthesis steps and reaction conditions of compound Pt1, Pt210 was synthesized. A target product, 471mg as yellow solid, was obtained with a yield of 80% and a molecular weight [M+H]⁺ of 1089.2.

### Example 21: Synthesis of Pt233

Referring to synthesis steps and reaction conditions of compound Pt1, Pt233 was synthesized. A target product, 596 mg as yellow solid, was obtained with a yield of 74% and a molecular weight [M+H]⁺ of 835.9.

### Example 22: Synthesis of Pt311

Referring to synthesis steps and reaction conditions of compound Pt1, Pt311 was synthesized. A target product, 615 mg as yellow solid, was obtained with a yield of 68% and a molecular weight [M+H]⁺ of 931.9.

### Example 23: Synthesis of Pt318

Referring to synthesis steps and reaction conditions of compound Pt1, Pt318 was synthesized. A target product, 582mg as yellow solid, was obtained with a yield of 66% and a molecular weight [M+H]⁺ of 881.8.

### Theoretical calculation

A geometric structure of molecules in a ground state (S₀) was optimized using density functional theory (DFT) . DFT calculation was performed by using B3LYP functional. 6-31G(d) basic sets were used for C, H, O and N atoms, while LANL2DZ basic sets were used for Pt atoms.

**Table 1. Frontier orbital energy levels of part of metal complexes**

| Metal complex | LUMO/eV | HOMO /eV | Gap/eV |
|---|---|---|---|
| Pt1 | 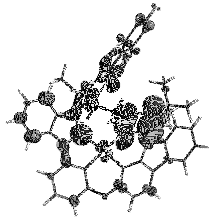 -1.25 eV | 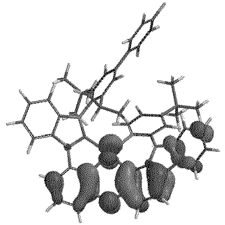 -4.71 eV | 3.46 eV |
| Pt2 | 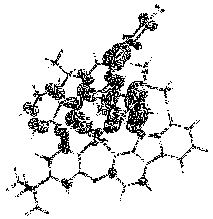 -1.23 eV | 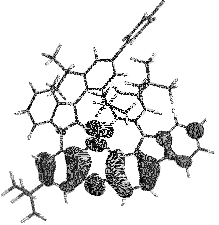 -4.67 eV | 3.44 eV |
| Pt3 | 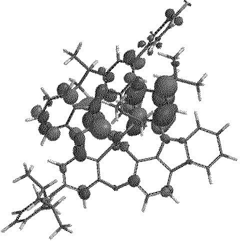 -1.29eV | 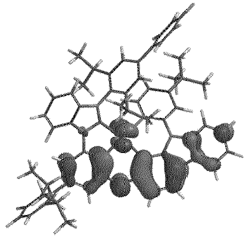 -4.76eV | 3.47 eV |
| Pt7 | 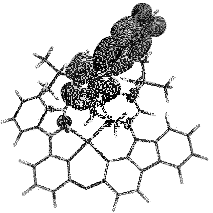 -1.42 eV | 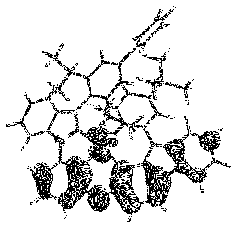 -4.73 eV | 3.31 eV |
| Pt8 | 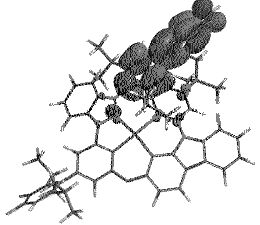 -1.47 eV | 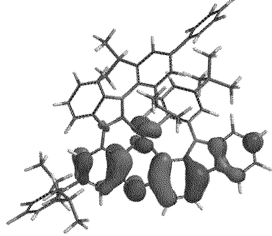 -4.83 eV | 3.36 eV |
| Pt9 | 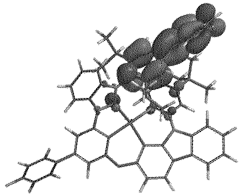 -1.47 eV | 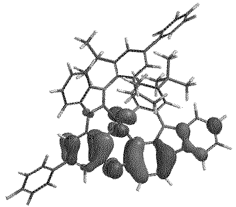 -4.80 eV | 3.33 eV |
| Pt10 | 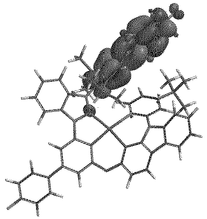 -1.59 eV | 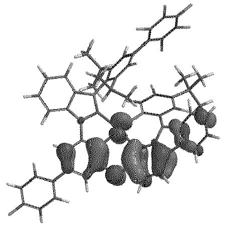 -4.80 eV | 3.21eV |
| Pt11 | 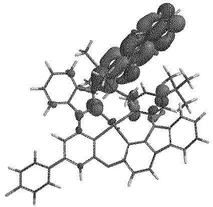 -1.34 eV | 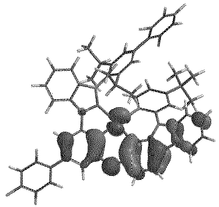 -4.73eV | 3.39 eV |
| Pt12 | 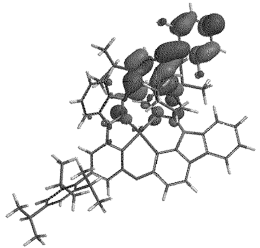 -1.29 eV | 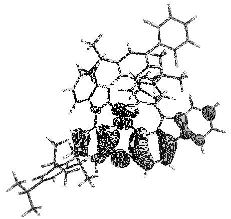 -4.70 eV | 3.41 eV |
| Pt13 | 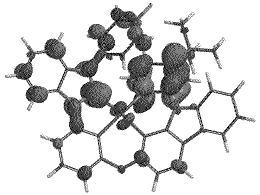 -1.27eV | 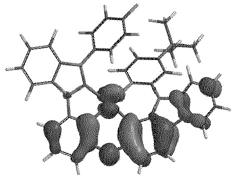 -4.72eV | 3.45 eV |
| Pt14 | 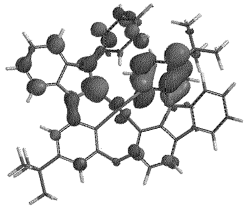 -1.24 eV | 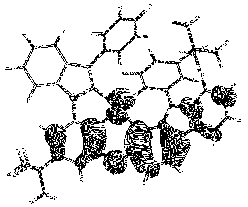 -4.67 eV | 3.43 eV |
| Pt15 | 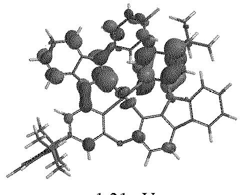 -1.31 eV | 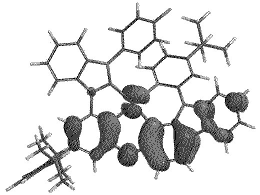 -4.76 eV | 3.45 eV |

According to calculation data shown in Table 1, all of the compound materials according to the disclosure have large energy gaps (> 3.20 eV), which can meet requirements of blue light materials. In addition, it can be seen that frontier orbital energy levels (HOMO and LUMO) of platinum (II) complexes can be adjusted by modulating their ligand structures. A LUMO of a pyridocarbene platinum (II) complex mostly originates from its pyridocarbene part, and in the disclosure, by introducing fluorine atoms into an appropriate part of a ligand, distribution of excited charges can be improved, so that this material has more metal-to-pyridine carbene charge transfer states (³MLCT). Because there are both coordination bonds and π backbonding between carbene and platinum (II), its stability is higher than that between pyridine and platinum (II), which facilitates improvement of radiation rate and thus improvement of service life of devices.

### Manufacturing of OLED devices:

As a reference preparation method of an embodiment of a device, in this disclosure, a hole injection layer (HIL) of 5 to 100 nm and a hole transport layer (HTL) of 5 to 200nm were formed by evaporating a p-doped material on a surface or anode of ITO glass with a light-emitting area of 2 mm×2 mm or by co-evaporating a p-doped material with a hole injection material at a concentration of 1% to 50%, and then a light-emitting layer (EML) (which may contain the compound according to the disclosure) of 10 to 100 nm was formed on the hole transport layer. An electron transport layer (ETL) with a thickness of 20 to 200 nm and a cathode with a thickness of 50 to 200 nm were formed; an electron blocking mayer (EBL) was added between the HTL and the EML layer, and an Electron Injection Layer (EIL) is added between the ETL and the cathode if necessary, so as to fabricate an OLED device. Then the OLED device is tested with a standard method. Unless otherwise specified, device materials involved in the present disclosure can be obtained by known synthesis methods.

In a preferred embodiment, a structure of Device Example 1 according to the disclosure is ITO/P-4 (10 nm)/NPD (60 nm)/HTH-85 (5 nm)/platinum (II) complex: HTH-85: ETH-45 (25 nm) (with a mass ratio of Pt-1: HTH-85: ETH-45 of 10: 60: 30)/ETH-5 (5 nm)/ET-14 (40 nm)/LiQ (1 nm)/Al (100 nm).

Device Examples 2 to 22 and Comparative Example 1 were prepared by using a structure similar to that of Device Example 1, only with difference that Pt-1 in Device Example 1 was replaced with Pt-2, Pt-3, Pt-4, Pt-5, Pt-225, Pt-16, Pt-19, Pt-21, Pt-24, Pt-37, Pt-39, Pt-65, Pt-81, Pt-82, Pt-86, Pt-111, Pt-112, Pt-210, Pt-233, Pt-311, Pt-318 and R1, respectively. Luminescent characteristics of Comparative Examples and each Device Example prepared above were tested by standard methods, with data shown in Table 2. Structures of the devices involved are as follows in which P-4 indicates HATCN and ET-14 indicates BPyTP.

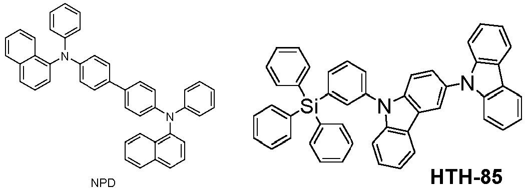

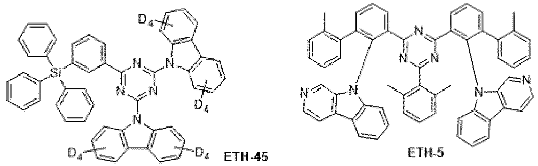

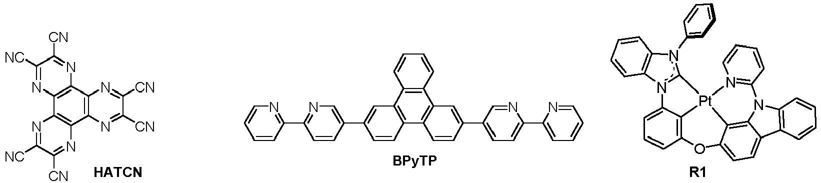

**Table 2. Data sheet of luminescence characteristics of devices**

| Examples | Driving voltage (volt) @10mA/cm² (Relative value, %) | Current efficiency (cd/A) @1000 cd/m² (Relative value, %) | Service life (h) @1000 cd/m² (Relative value, %) |
|---|---|---|---|
| Comparative Example 1 | 100 | 100 | 100 |
| Device Example 1 | 96 | 109 | 122 |
| Device Example 2 | 98 | 111 | 131 |
| Device Example 3 | 97 | 123 | 137 |
| Device Example 4 | 98 | 120 | 115 |
| Device Example 5 | 97 | 124 | 119 |
| Device Example 6 | 96 | 119 | 126 |
| Device Example 7 | 97 | 117 | 130 |
| Device Example 8 | 97 | 125 | 134 |
| Device Example 9 | 98 | 118 | 127 |
| Device Example 10 | 96 | 119 | 130 |
| Device Example 11 | 97 | 120 | 135 |
| Device Example 12 | 97 | 122 | 129 |
| Device Example 13 | 95 | 126 | 138 |
| Device Example 14 | 96 | 120 | 125 |
| Device Example 15 | 98 | 125 | 130 |
| Device Example 16 | 96 | 123 | 128 |
| Device Example 17 | 96 | 119 | 130 |
| Device Example 18 | 97 | 117 | 130 |
| Device Example 19 | 96 | 120 | 132 |
| Device Example 20 | 96 | 122 | 127 |
| Device Example 21 | 96 | 123 | 124 |
| Device Example 22 | 97 | 117 | 121 |

It can be seen from Table 2 that, compared with Comparative Example 1, Device Example 1 to Device Example 22 prepared in this disclosure show good device performance in driving voltage, current efficiency and service life. Performance improvement of respective device examples is based on a fact that a specific compound material according to the disclosure has better electron transport ability. Therefore, it can be seen that the electronic device with the compound material as a light-emitting layer material has higher current efficiency and longer service life as well as with a reduced driving voltage. It shows that the compound according to the disclosure has certain commercial application value.

In a preferred embodiment, a structure of Device Example 23 according to the disclosure is ITO/P-4 (10 nm)/NPD (60 nm)/HTH-85 (5 nm)/platinum (II) complex: boron-containing compound: HTH-85: ETH-45 (25 nm) (with a mass ratio of Pt1: BN1-8: HTH-85: ETH-45 of 10: 1: 59: 30)/ETH-5 (5 nm)/ET-14 (40 nm)/LiQ (1 nm)/Al (100 nm).

Device Example 24 to Device Example 30 were prepared by using structures similar to that of Device Example 23, with only difference in that the platinum (II) complex and boron-containing compound in Device Example 23 were replaced with compounds listed in Table 3. Device structures and luminous characteristics are shown in Table 3.

**Table 3. Data sheet of device structure and luminescence characteristics**

| Examples | Platinum (II) Complex: boron-containing compound | Driving voltage (volt) @10mA/cm² (Relative value, %) | Current efficiency (cd/A) @1000 cd/m² (Relative value, %) | Service life (h) @1000 cd/m² (Relative value, %) |
|---|---|---|---|---|
| Comparative Example 1 | R1 | 100 | 100 | 100 |
| Device Example 23 | Pt-1: BN1-8 | 97 | 113 | 125 |
| Device Example 24 | Pt-170: BN1-23 | 97 | 118 | 132 |
| Device Example 25 | Pt-172: BN2-1 | 96 | 123 | 135 |
| Device Example 26 | Pt-4: BN2-26 | 96 | 124 | 119 |
| Device Example 27 | Pt-52: BN2-63 | 98 | 126 | 122 |
| Device Example 28 | Pt-86: BN2-80 | 96 | 122 | 127 |
| Device Example 29 | Pt-144: BN3-1 | 97 | 128 | 133 |
| Device Example 30 | Pt-171: BN3-10 | 96 | 130 | 139 |

It can be seen from Table 3 that when the compound according to the present disclosure was used as a sensitizing material and applied as a luminescent material together with the boron-containing compound in the devices, performance of respective devices was also significantly improved. It further shows that the compound according to the disclosure has certain commercial application value.

In addition, devices prepared in the disclosure are all dark blue devices, with all of CIEy values less than 0.20. The structure of the device is sensitized by adding the boron-containing compound, which can further reduce a CIEy value and thus improve purity of the luminescent color of the device.

It is declared that the above is only specific implementations of the present disclosure, but the protection scope of the present disclosure is not limited to this. It should be clear to those skilled in the art that any change or substitution that can easily occur to those skilled in the art within the technical scope disclosed by the present application should within the protection scope of the present disclosure.

## Claims

1. A fluorine-containing tetradentate cyclometalated platinum (II) complex, which has a structure shown in formula (I) or formula (II): 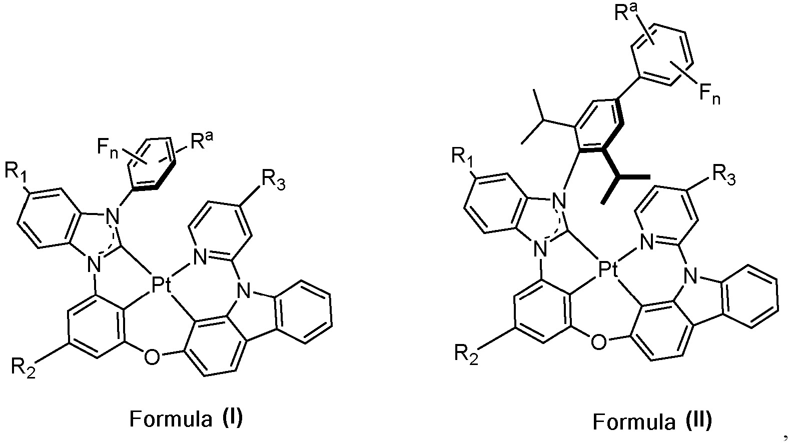
in the formula (I) or formula (II), Fₙ indicates that there are one or more F substituted on a benzene ring where it is located, where n is a positive integer from 1 to 5;
R^{a} is represented as monosubstituted, disubstituted, trisubstituted, tetrasubstituted or unsubstituted; R^{a} is selected from H or C1-C30 alkyl;
R₁, R₂ and R₃ are independently selected from a group consisting of hydrogen, F, N, O, S, CN, C1-C30 alkyl, C1-C30 cycloalkyl, C1-C30 heterocycloalkyl, C1-C30 haloalkyl, C6-C60 aryl and C6-C60 heteroaryl.

2. The fluorine-containing tetradentate cyclometalated platinum (II) complex according to claim 1, wherein at least one hydrogen in R₁, R₂ and R₃ is substituted by deuterium or F.

3. The fluorine-containing tetradentate cyclometalated platinum (II) complex according to claim 1, wherein R₁ and R₃ are independently selected from hydrogen or C1-C30 alkyl.

4. The fluorine-containing tetradentate cyclometalated platinum (II) complex according to claim 1, wherein R₂ is selected from hydrogen, deuterium, CN, substituted or unsubstituted C1-C30 alkyl, substituted or unsubstituted C1-C30 heteroalkyl, substituted or unsubstituted C1-C30 cycloalkyl, substituted or unsubstituted C1-C30 heterocycloalkyl, substituted or unsubstituted C1-C30 haloalkyl, substituted or unsubstituted C6-C60 aryl, and substituted or unsubstituted C6-C60; wherein heteroatoms on the heteroalkyl, heterocycloalkyl or heteroaryl are selected from one or more of O, S and/or N.

5. The fluorine-containing tetradentate cyclometalated platinum (II) complex according to claim 1, wherein the fluorine-containing tetradentate cyclometalated platinum (II) complex is selected from ones with any one of following chemical structures, wherein "D" represents deuterium:

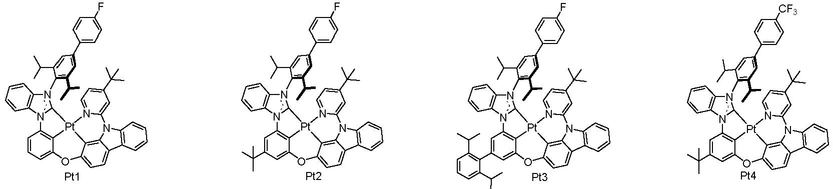

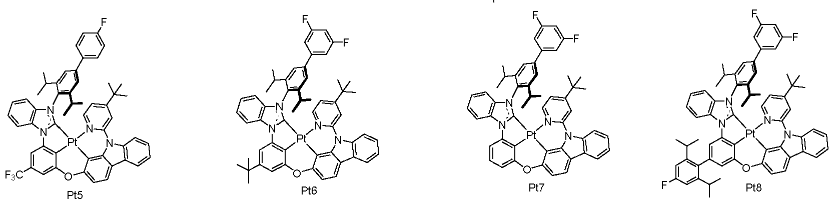

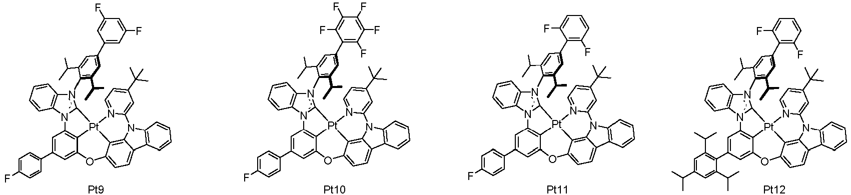

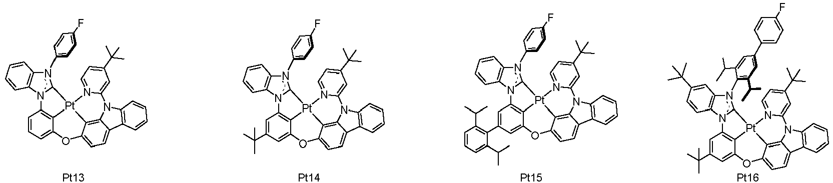

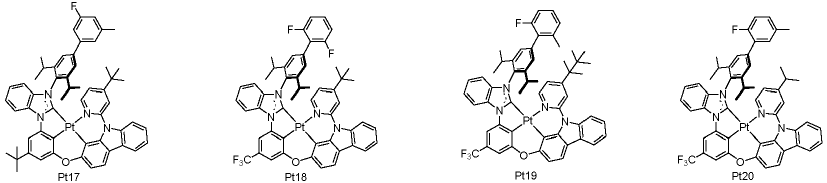

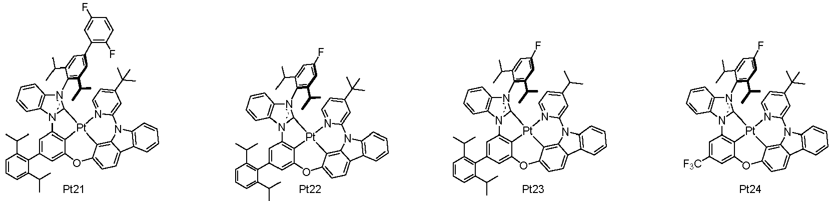

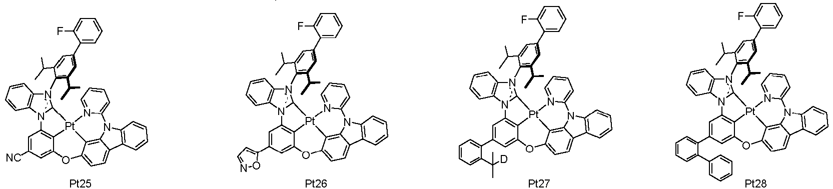

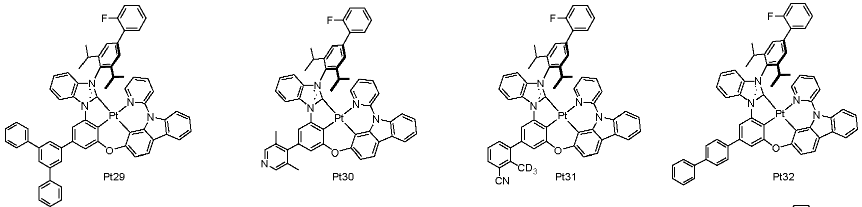

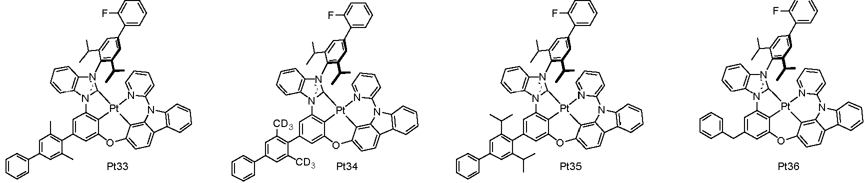

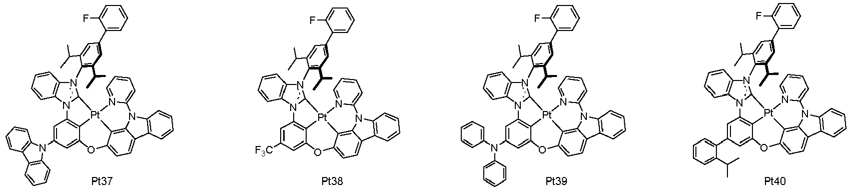

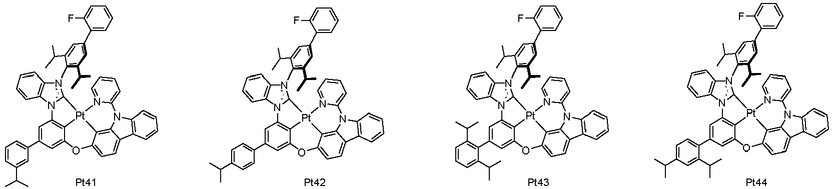

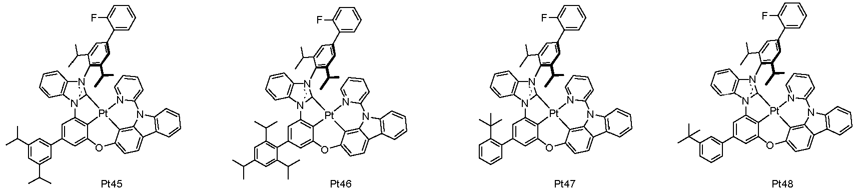

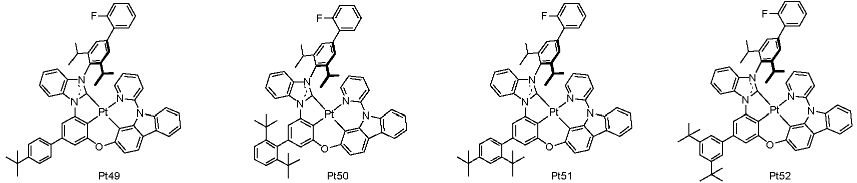

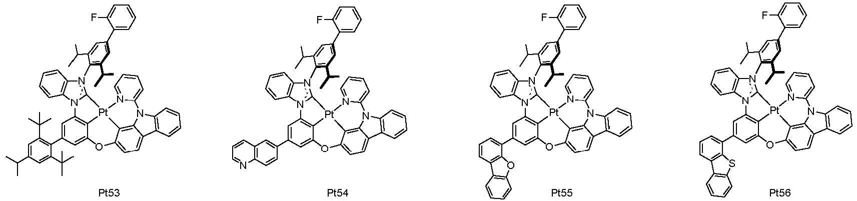

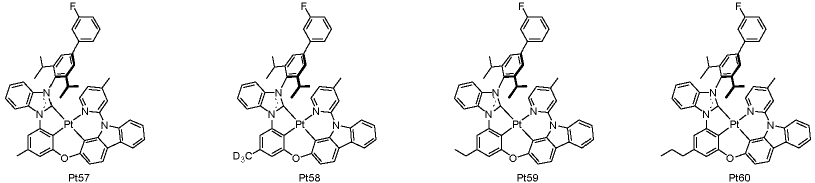

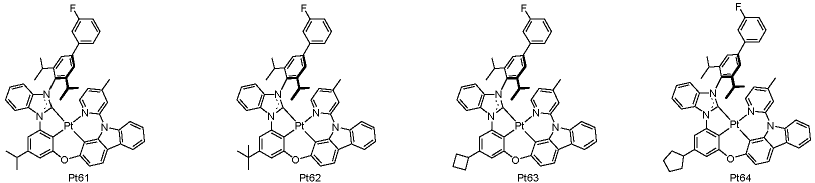

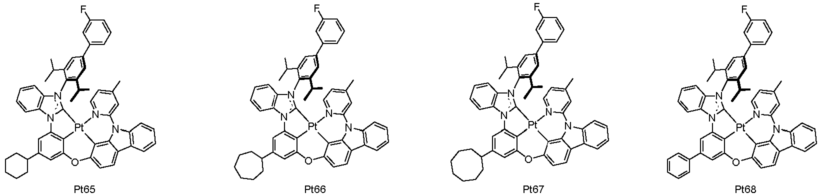

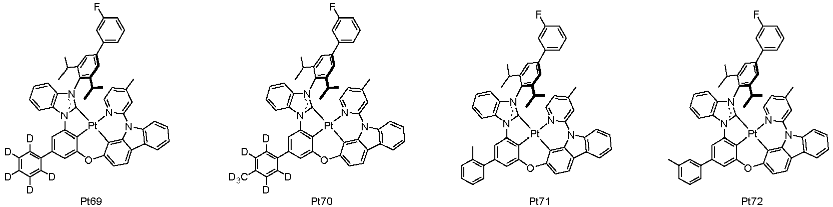

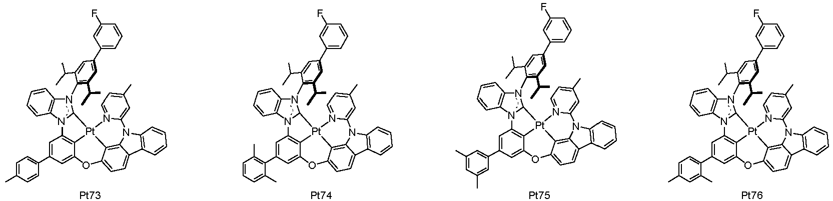

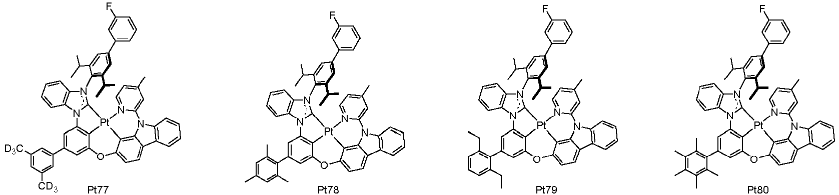

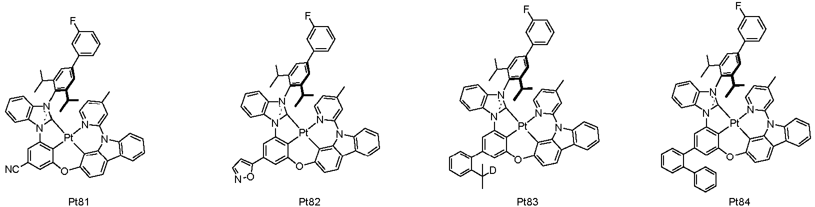

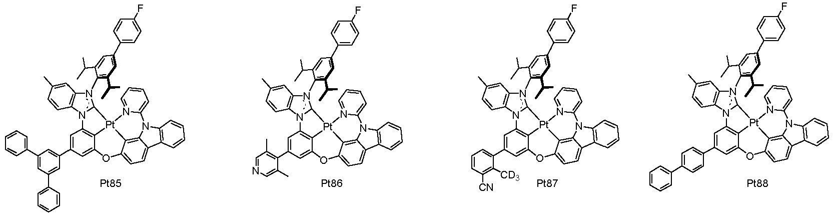

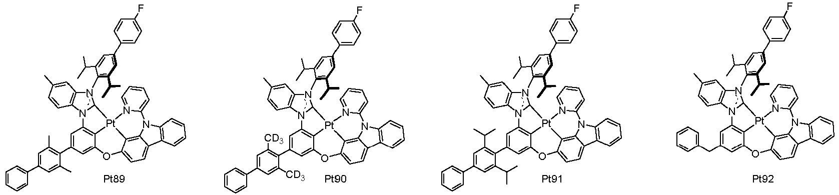

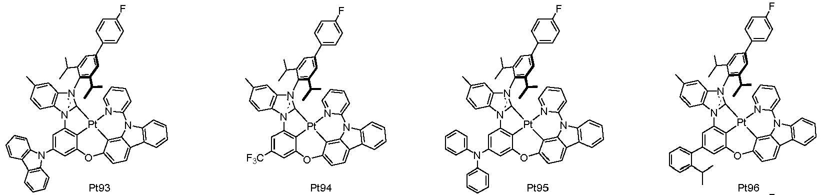

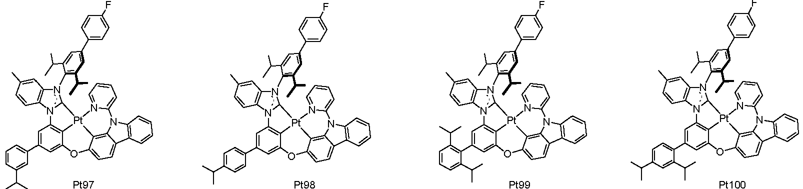

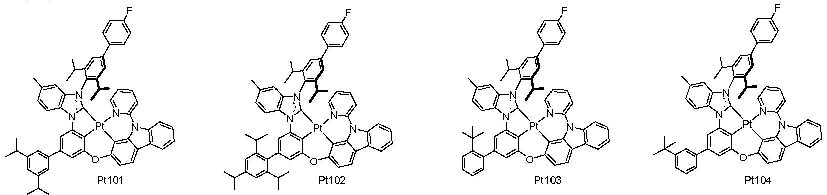

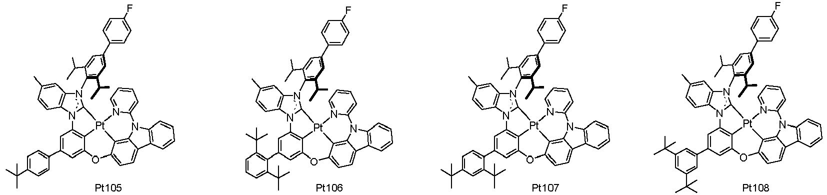

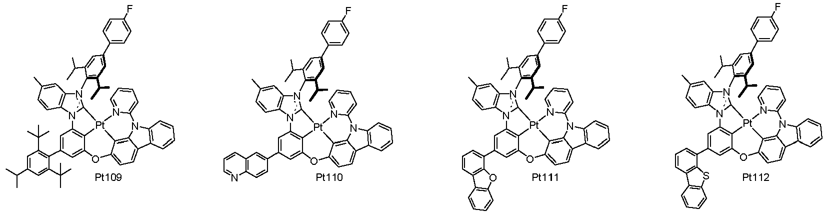

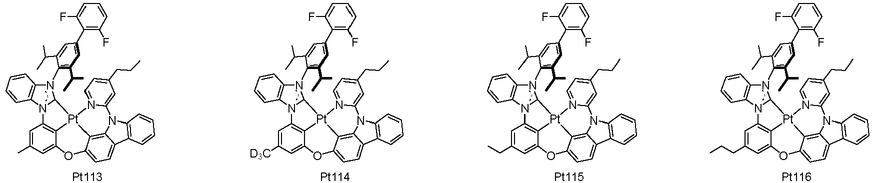

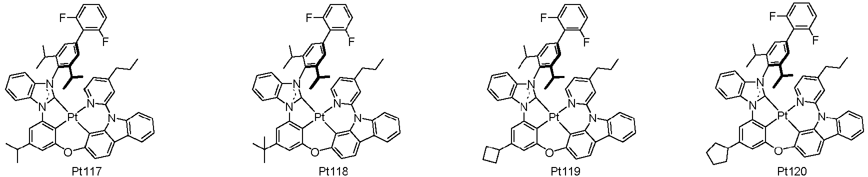

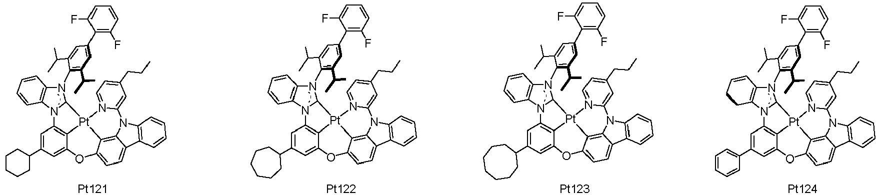

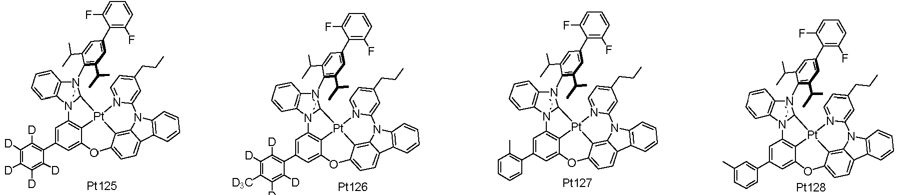

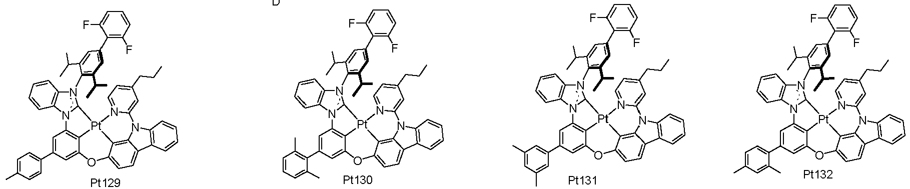

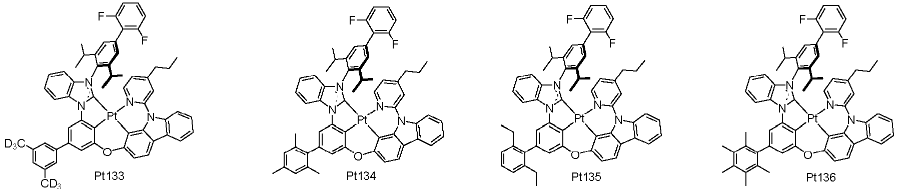

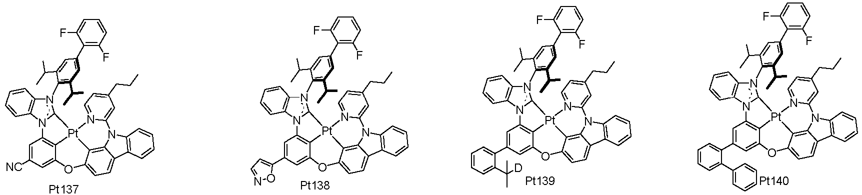

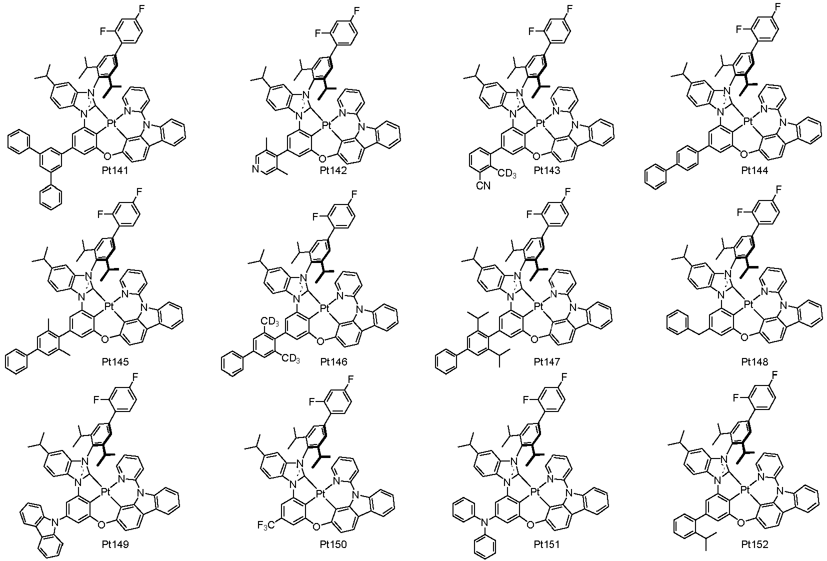

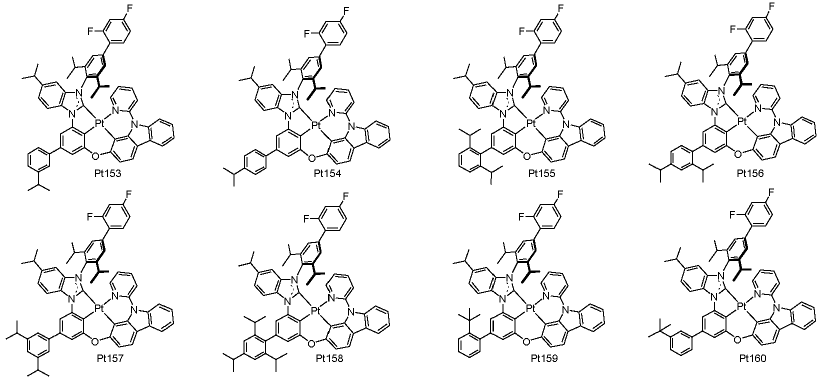

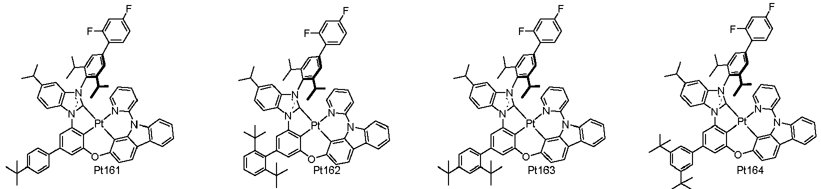

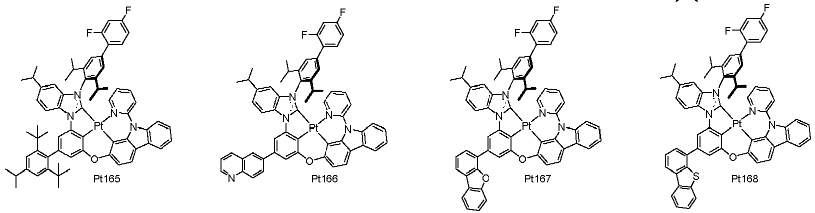

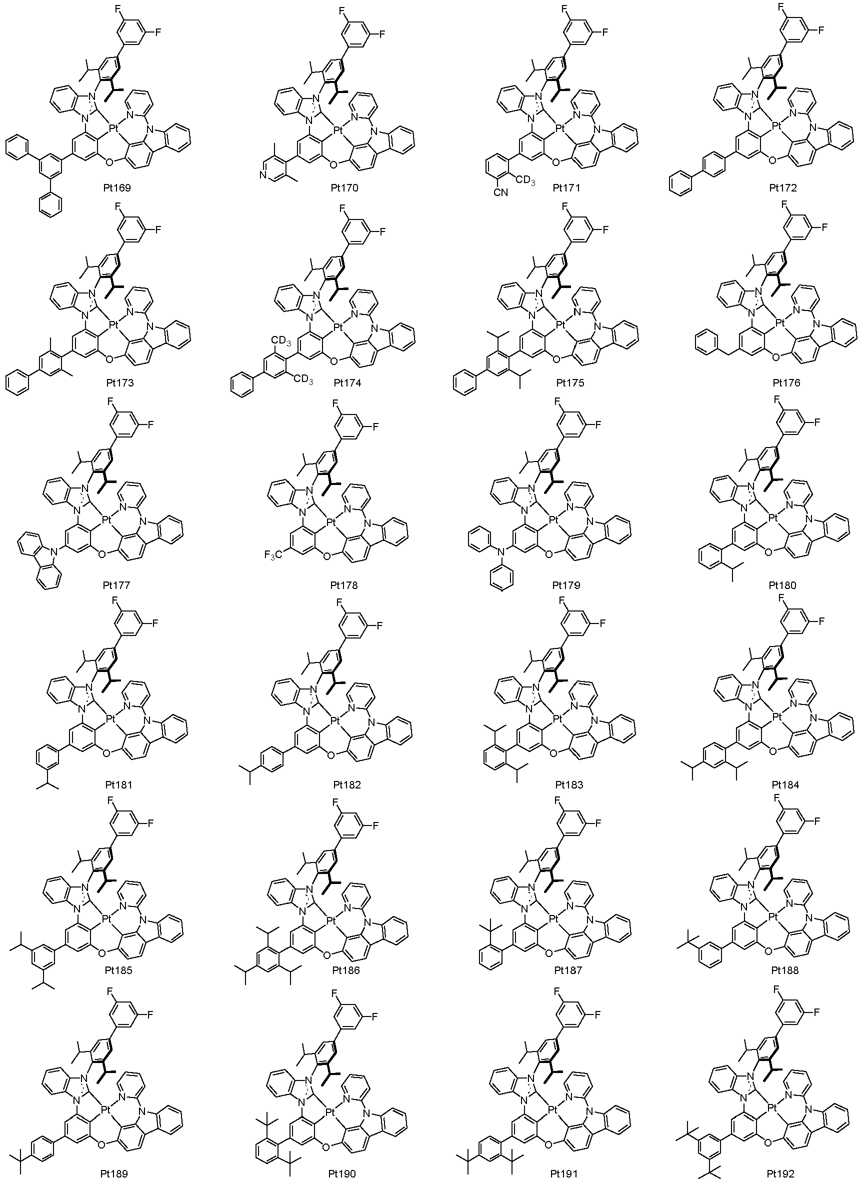

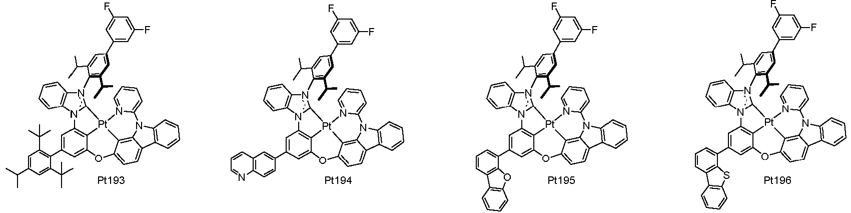

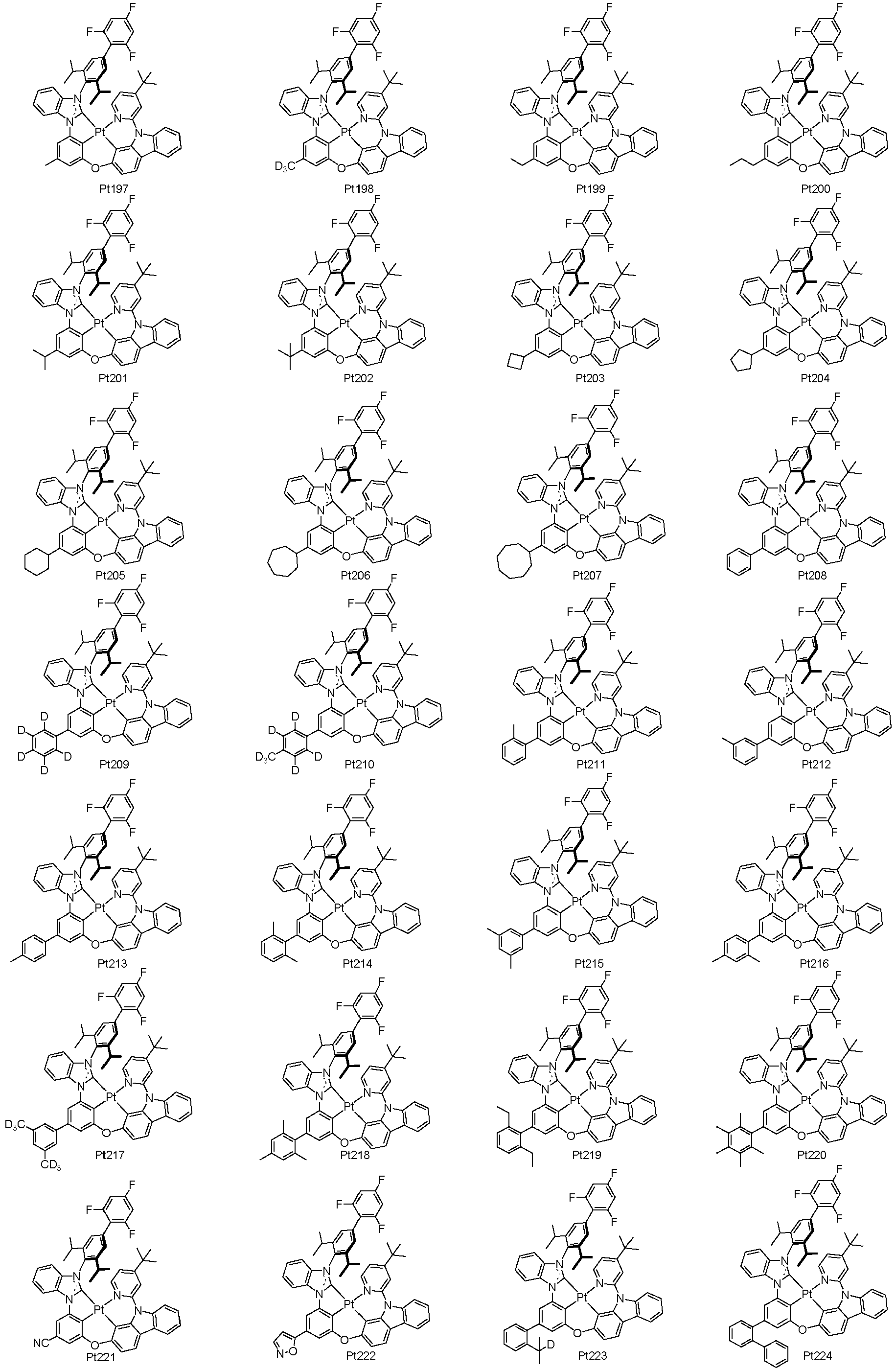

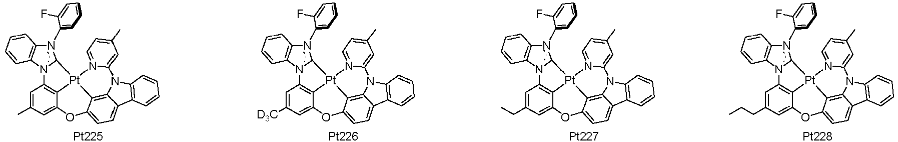

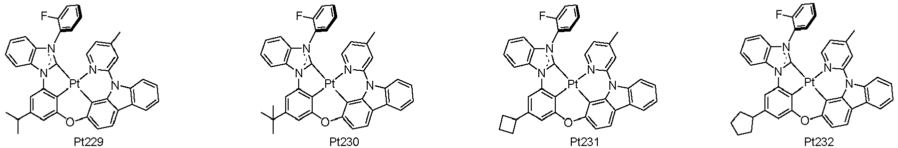

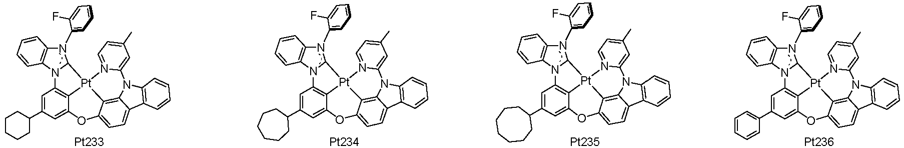

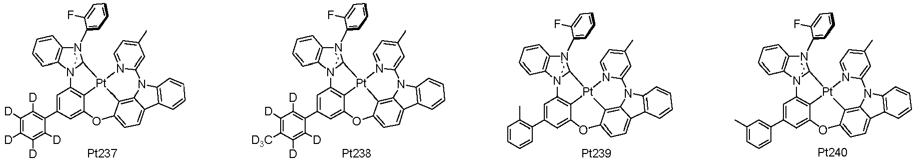

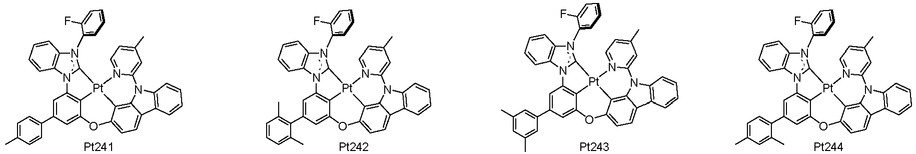

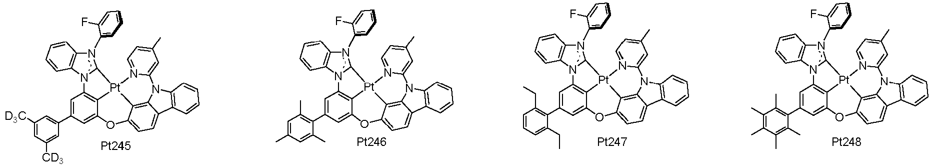

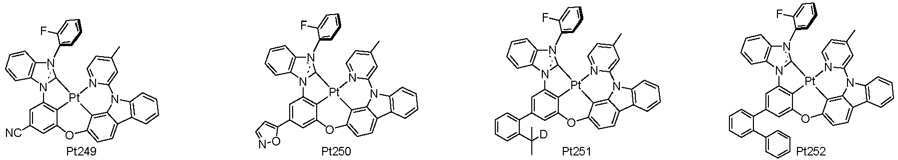

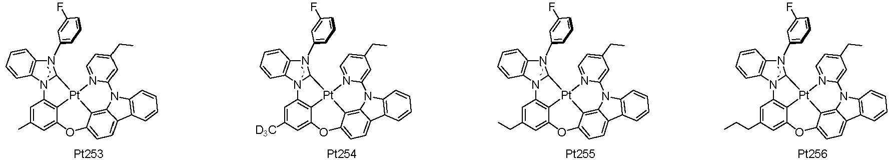

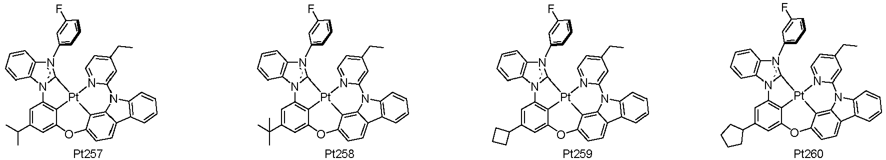

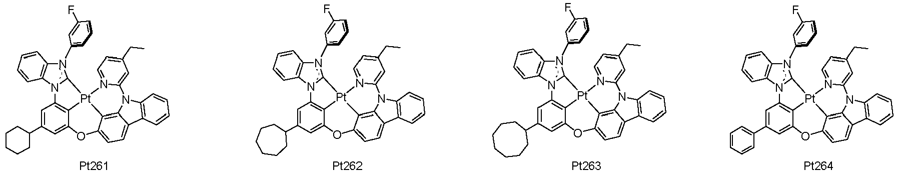

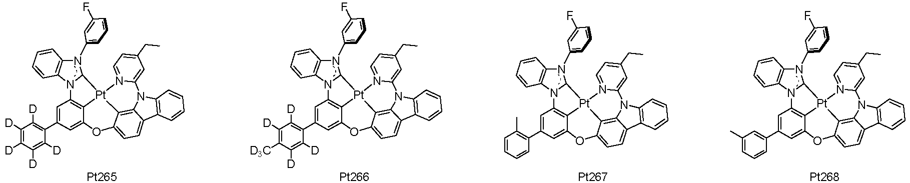

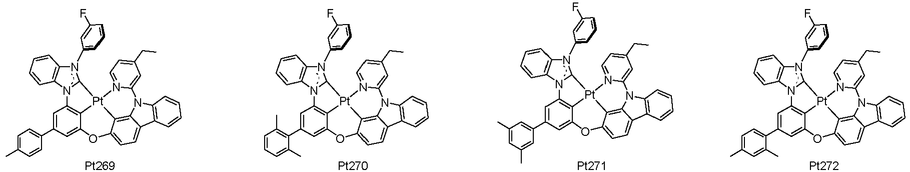

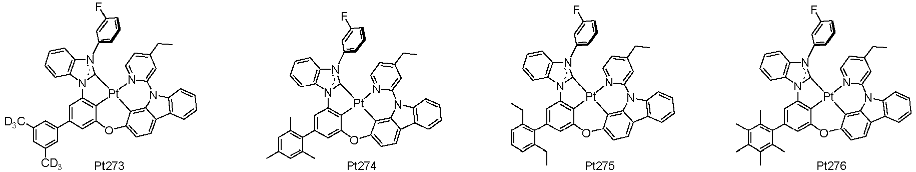

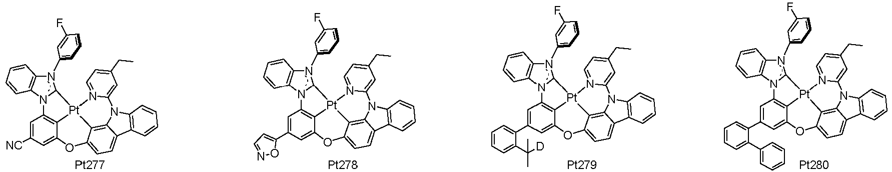

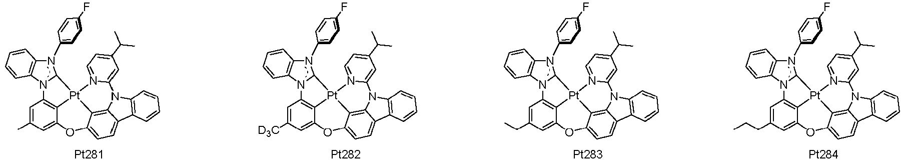

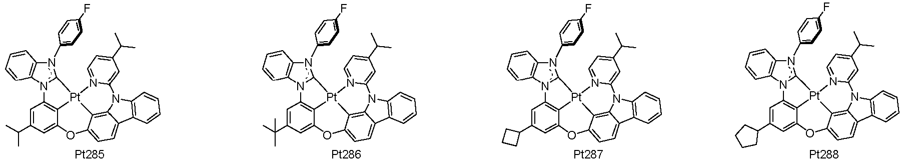

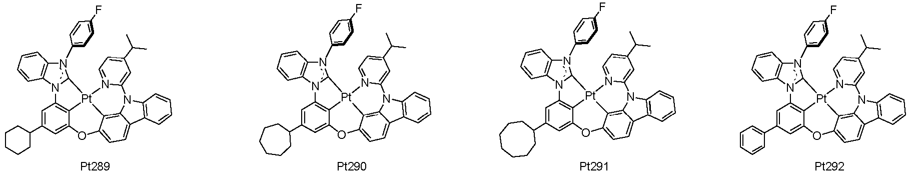

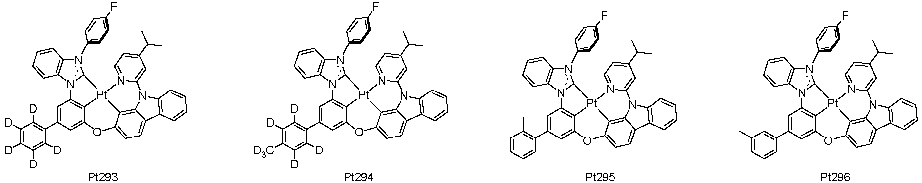

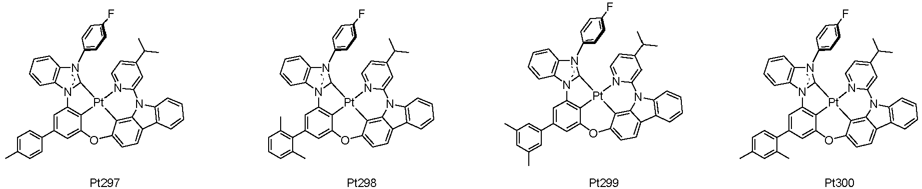

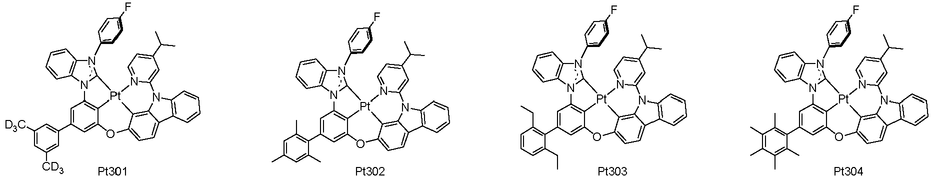

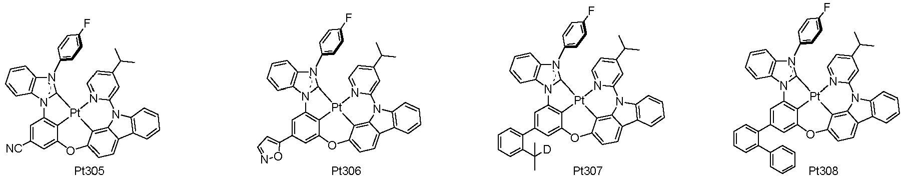

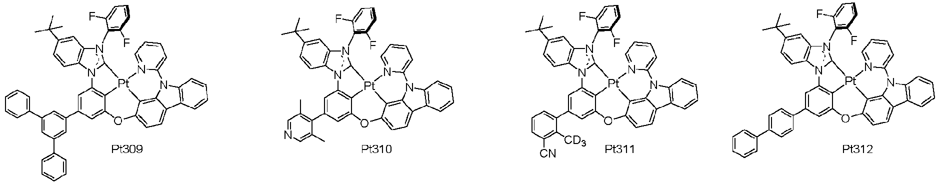

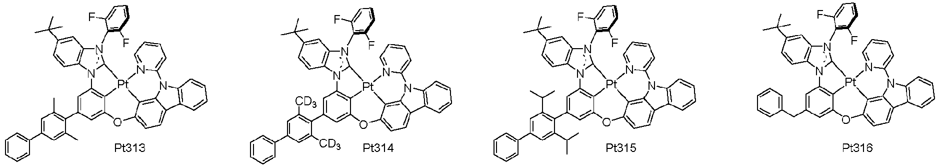

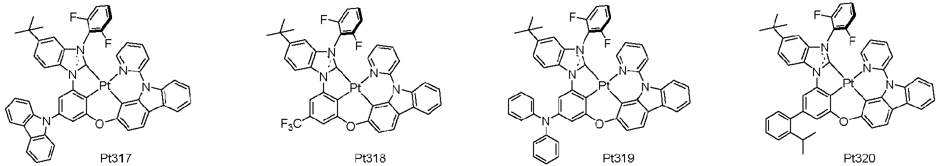

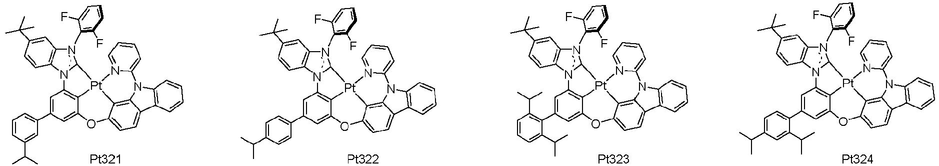

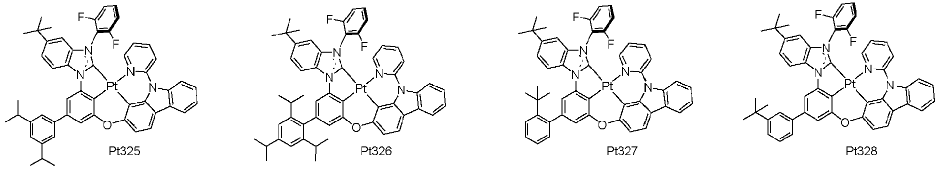

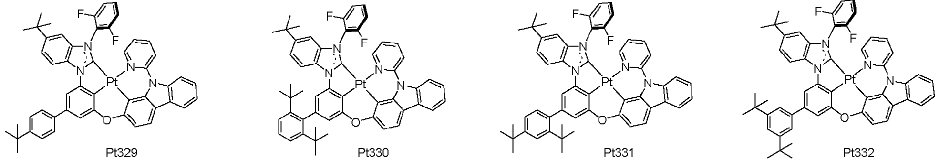

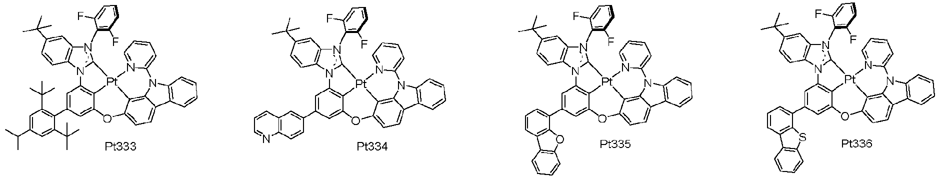

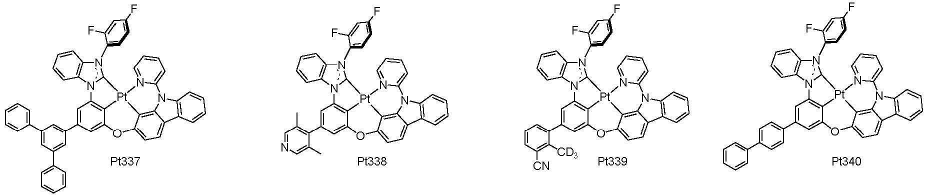

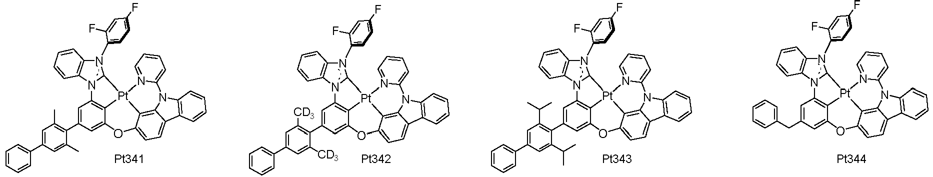

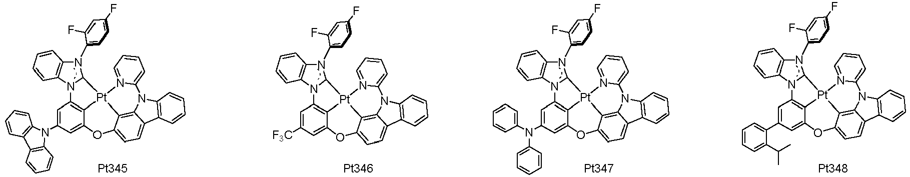

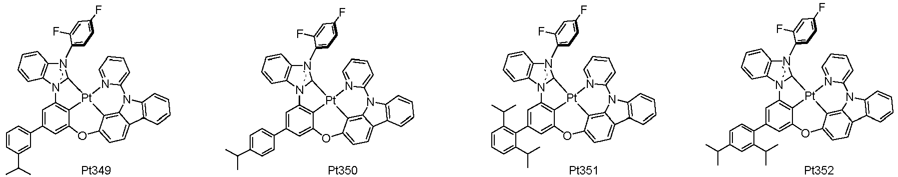

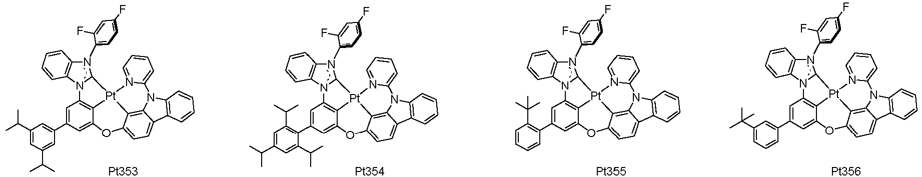

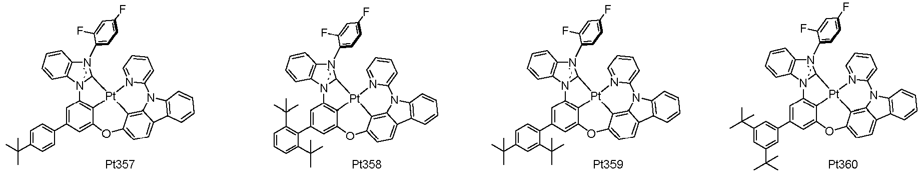

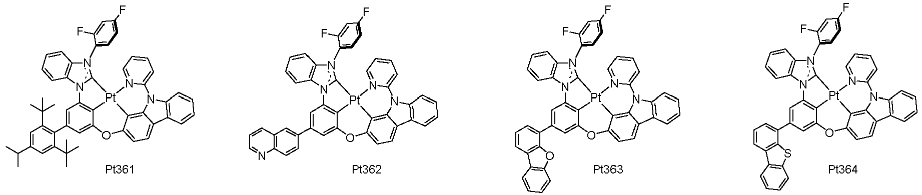

6. Application of the fluorine-containing tetradentate cyclometalated platinum (II) complex according to any one of claims 1 to 5 in an electronic device.

7. The application according to claim 6, wherein the electronic device comprises an organic light-emitting device, an organic integrated circuit, an organic field effect transistor, an organic thin film transistor, an organic light emitting transistor, an organic solar cell, an organic optical detector, an organic field quenching device, a light-emitting electrochemical cell and an organic laser diode.

8. An organic light-emitting device, comprising a cathode, an anode, and an organic functional layer therebetween, wherein the organic functional layer comprises the fluorine-containing tetradentate cyclometalated platinum (II) complex according to any one of claims 1 to 5.

9. An organic light-emitting device, comprising a light-emitting layer, wherein the light-emitting layer comprises the fluorine-containing tetradentate cyclometalated platinum (II) complex according to any one of claims 1 to 5.

10. The organic light-emitting device according to claim 9, wherein the light-emitting layer further comprises a fluorescent doping material, the fluorescent doping material being selected from any one or more compound represented by formulas (BN1) to (BN5): 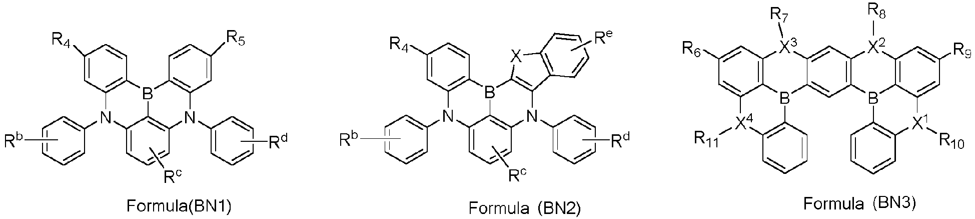 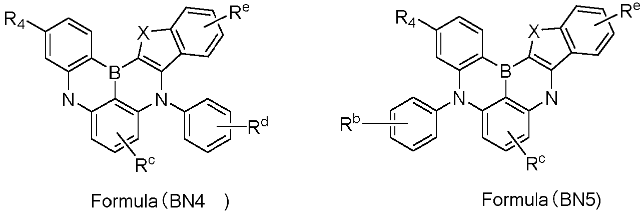
wherein X is O, S, Se or NR³⁰⁰;
X¹, X², X³, x^{4r} each independently represent O, S, Se or N; and
R^{b} to R^{e} are each independently represented as monosubstituted, disubstituted, trisubstituted, tetrasubstituted or unsubstituted; R^{b} to R^{e} are independently selected from a group consisting of hydrogen, deuterium, N, C1-C30 alkyl and C6-C60 aryl; R₄ to R₁₁ are each independently selected from a group consisting of a group consisting of hydrogen, deuterium, n, C1-C30 alkyl and C6-C60 aryl.

11. The organic light-emitting device according to claim 10, wherein R₄ to R₆ and R₉ are independently selected from substituted or unsubstituted diphenylamine groups, or substituted or unsubstituted carbazole groups; substitution can be multiple substitutions, and when a substituent is contained, the substituent is selected from deuterium, C1-C30 alkyl, and C6-C30 aryl.

12. The organic light-emitting device according to claim 10, wherein R₇ to R₈ and R₁₀ to R₁₁ are independently selected from a group consisting of hydrogen, C1-C30 alkyl and C6-C60 aryl.

13. The organic light-emitting device according to claim 10, wherein the fluorescent doping material is selected from any one of following chemical structures, wherein Ph represents a phenyl group, and D4 and D5 respectively refers to be substituted by 4 and 5 deuterium atoms:

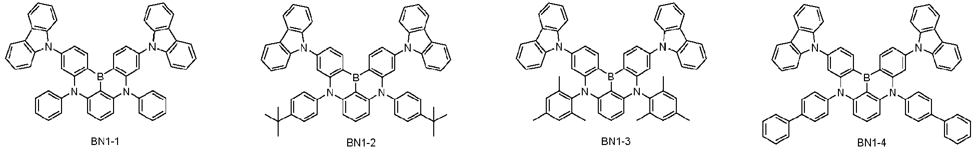

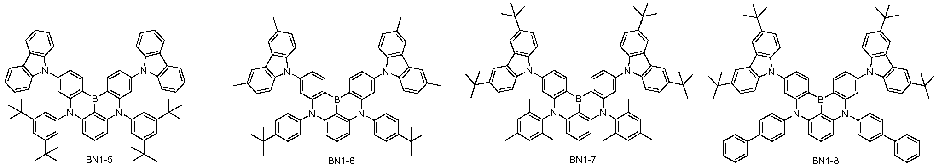

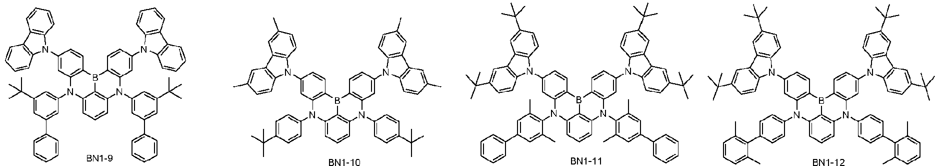

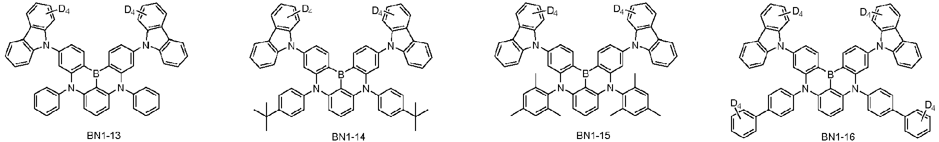

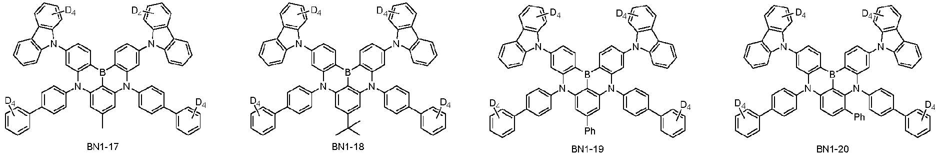

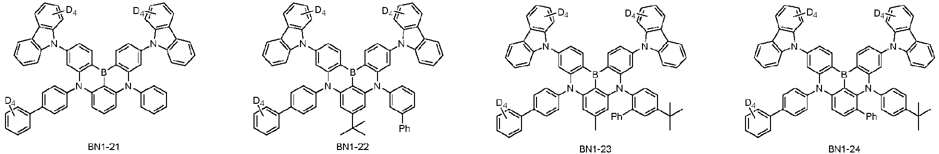

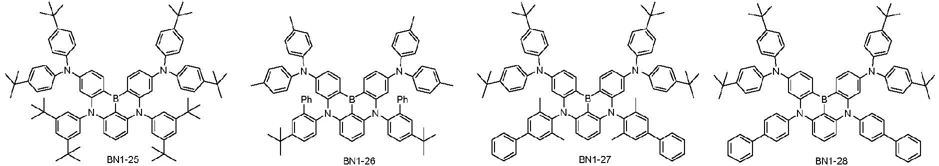

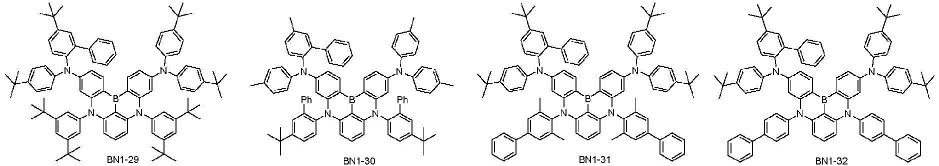

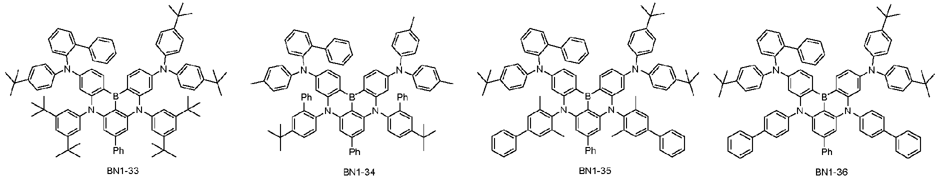

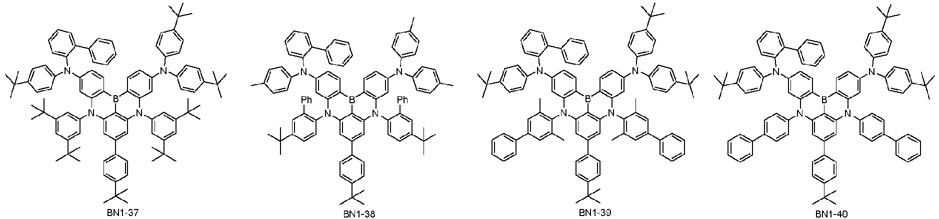

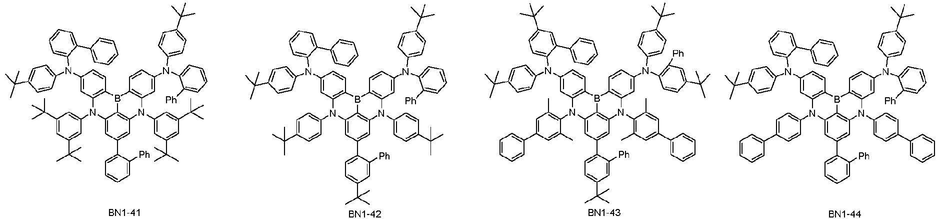

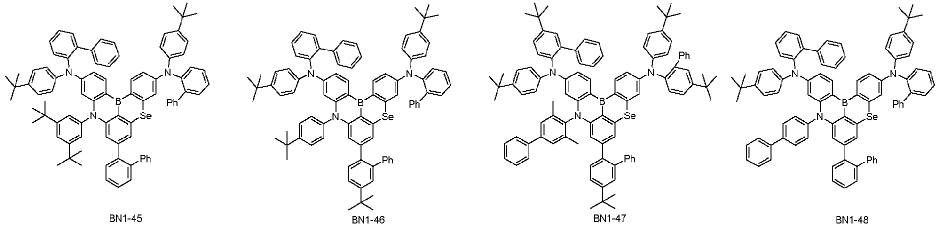

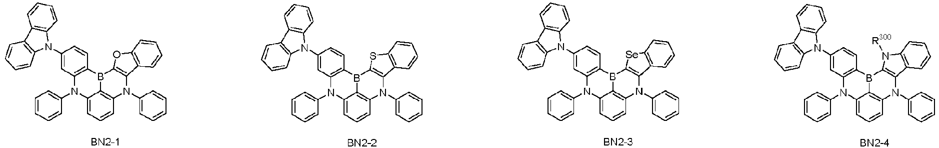

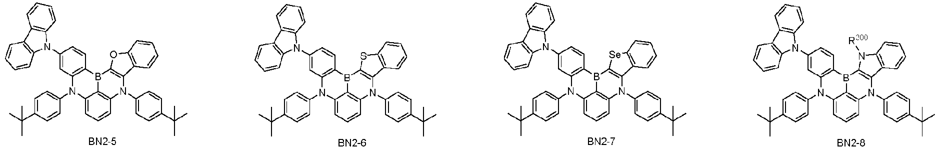

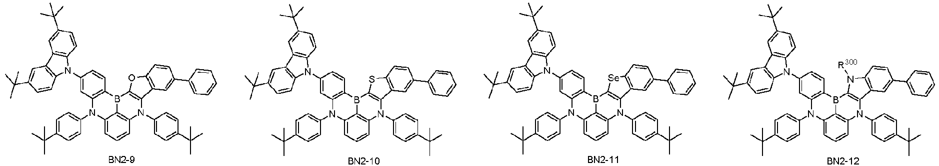

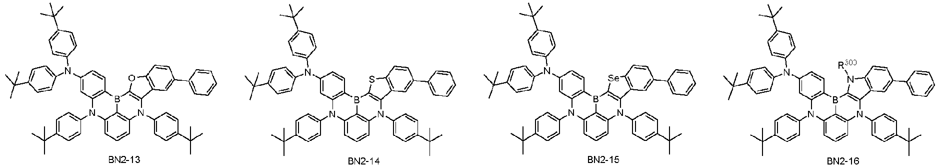

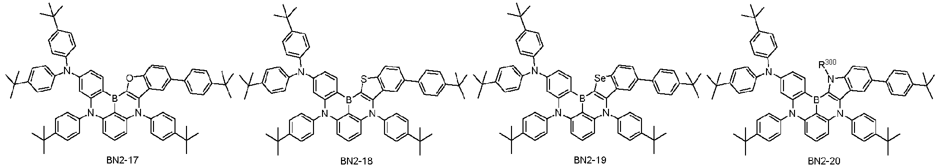

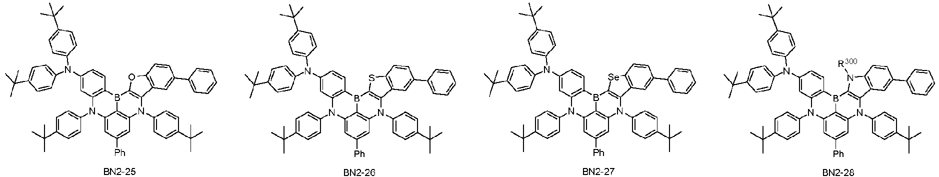

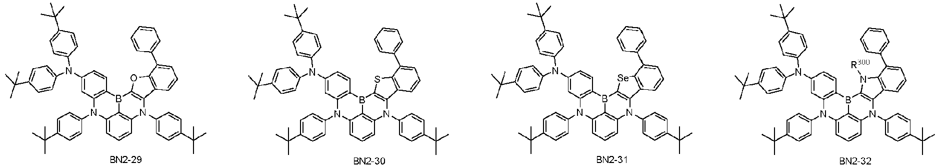

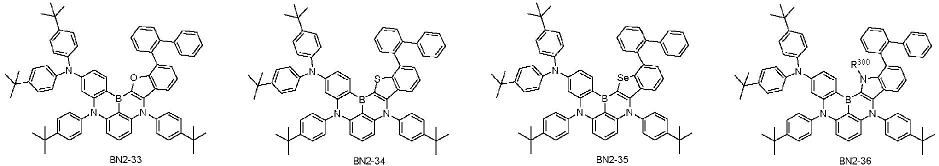

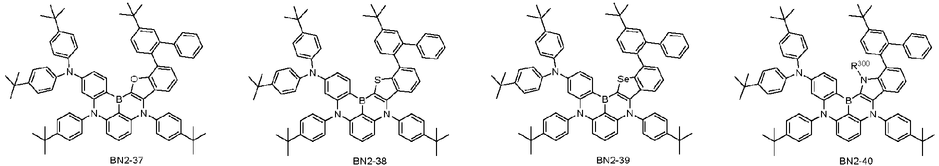

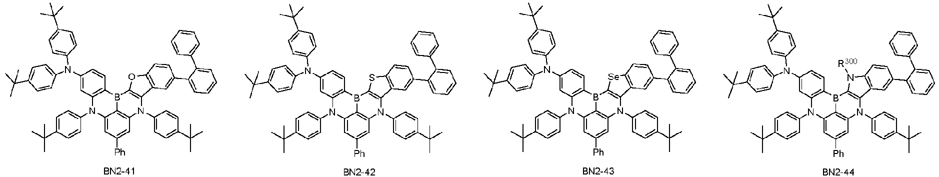

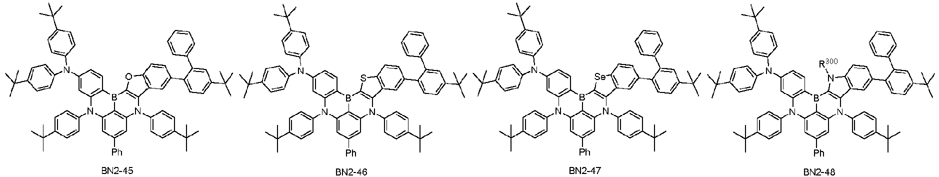

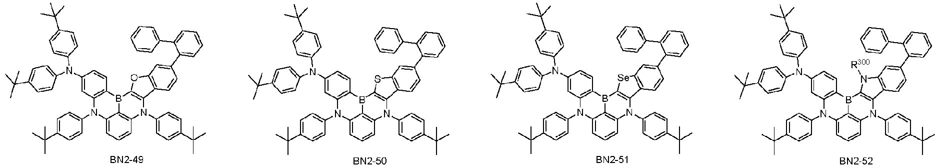

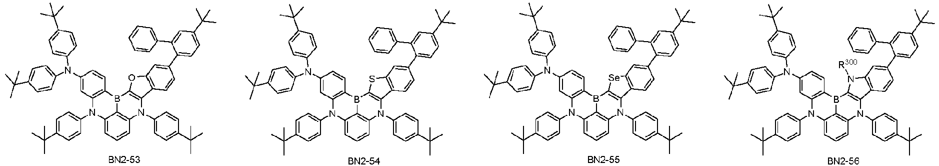

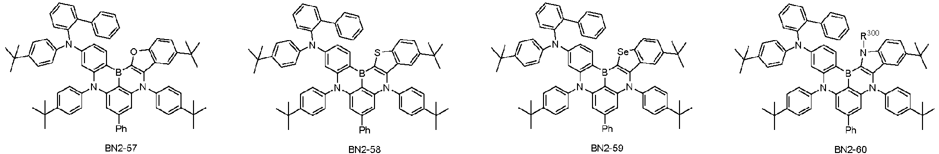

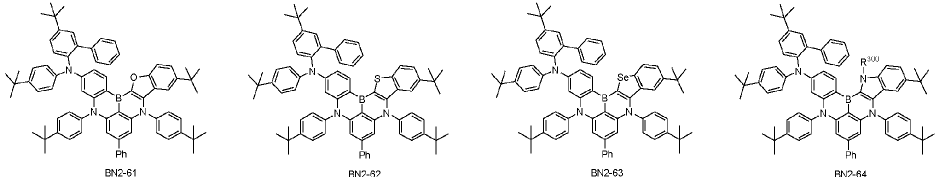

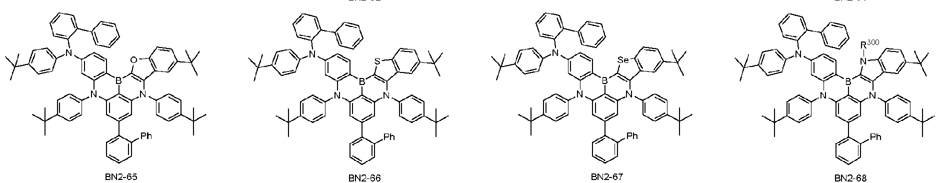

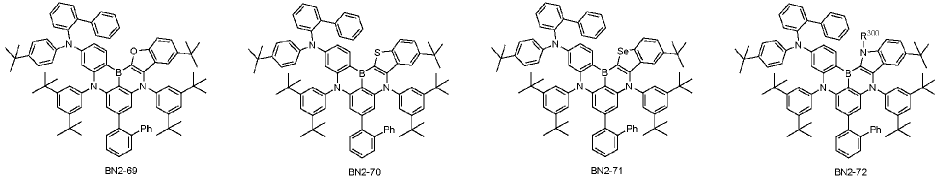

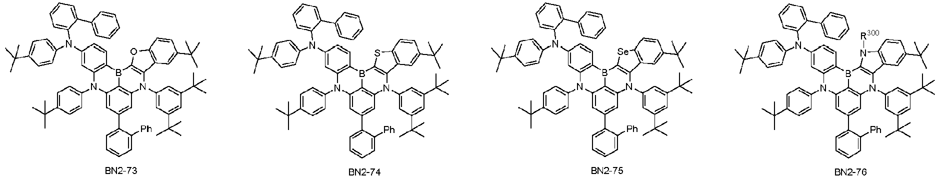

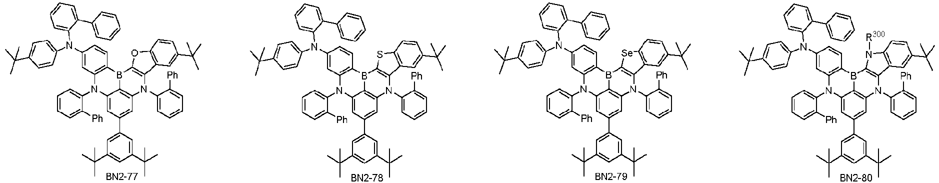

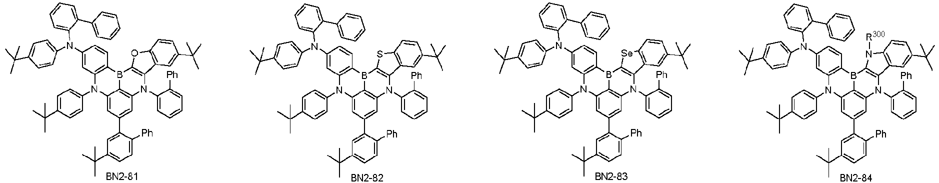

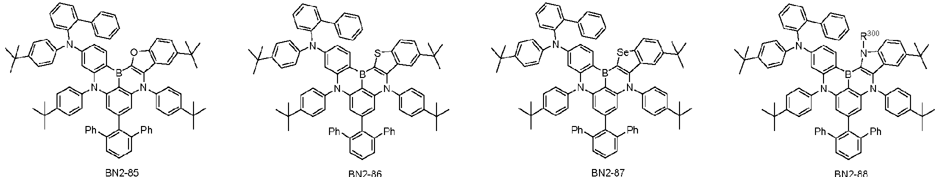

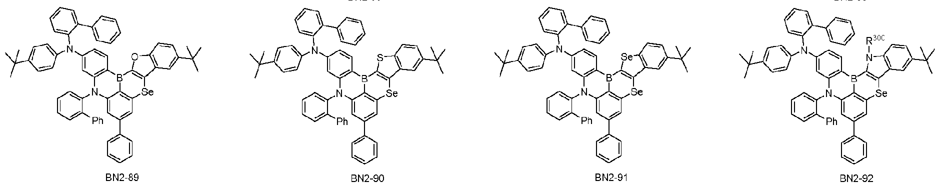

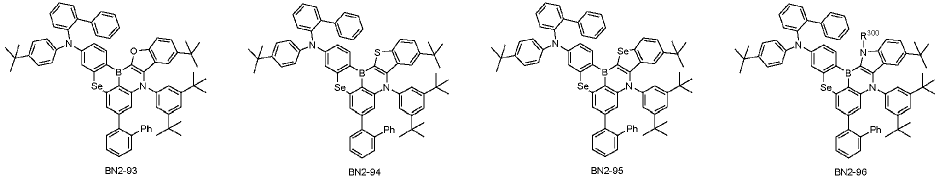

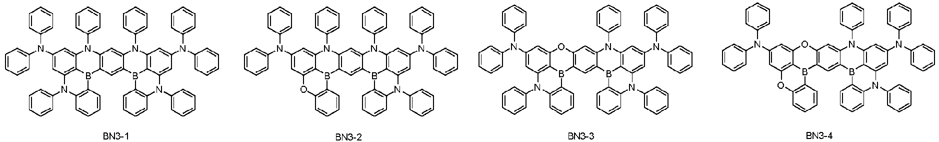

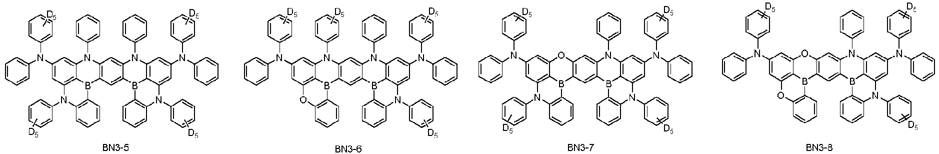

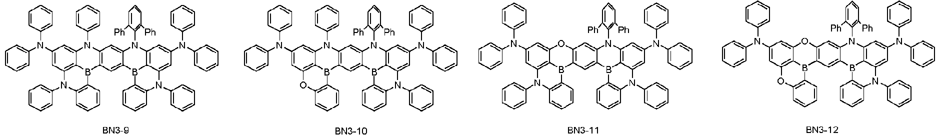

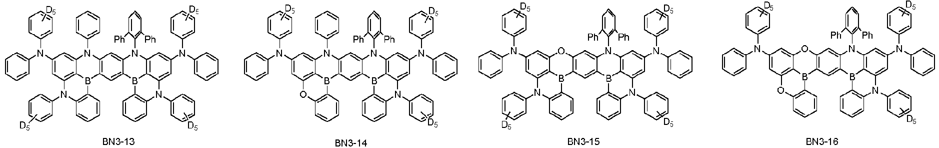

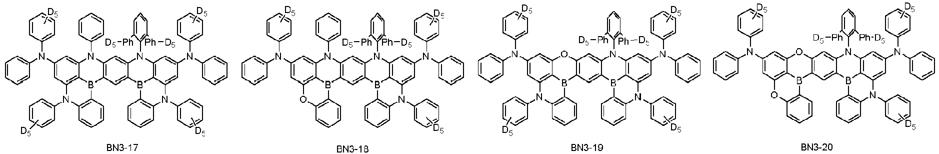

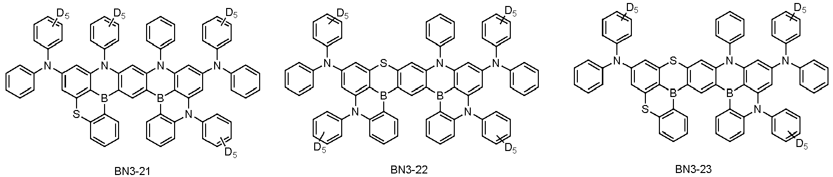

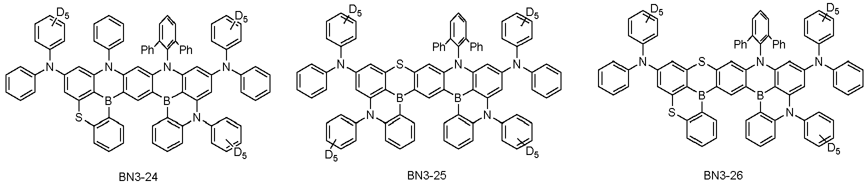

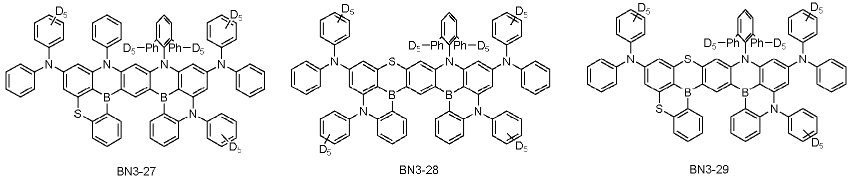

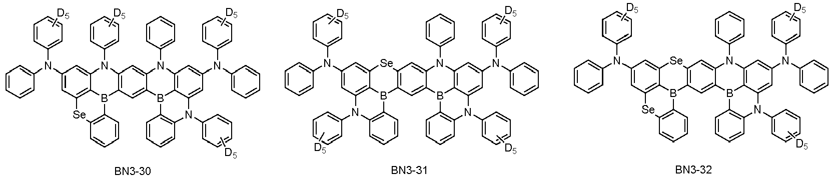

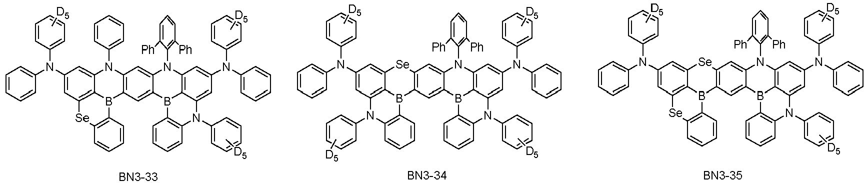

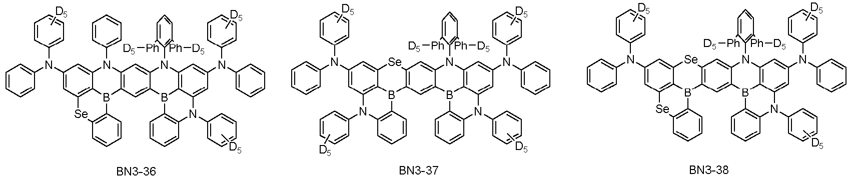

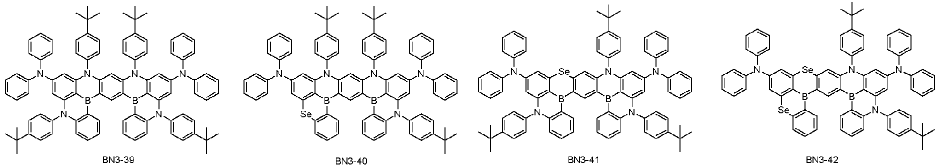

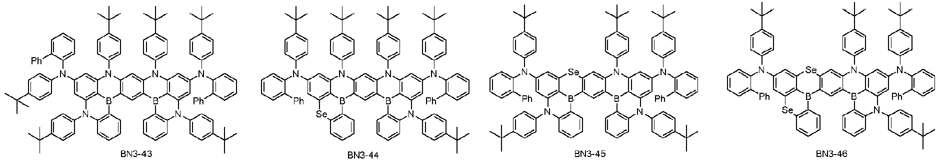

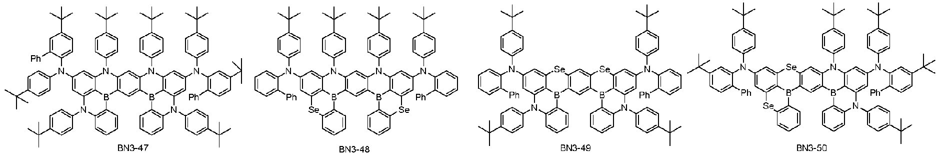

14. An organic photoelectric device, comprising: a substrate layer; a first electrode on the substrate; an organic light-emitting functional layer on the first electrode; a second electrode on the organic light emitting functional layer, wherein the organic light-emitting functional layer comprises the fluorine-containing tetradentate cyclometalated platinum (II) complex according to any one of claims 1 to 5.

15. The organic photoelectric device according to claim 14, wherein the organic light-emitting functional layer further comprises a fluorescent doping material, the fluorescent doping material being selected from any one or more compound represented by formulas (BN1) to (BN5): 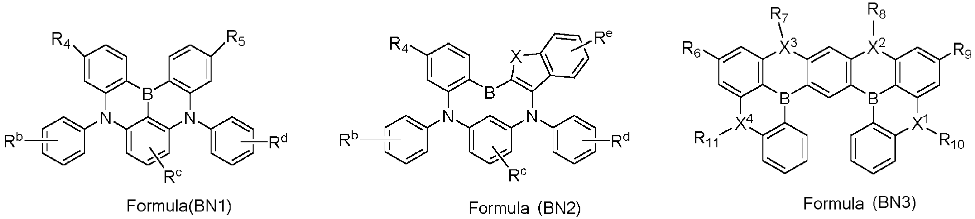 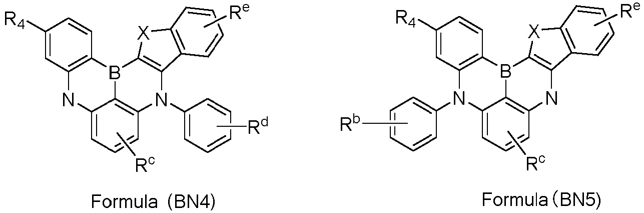
wherein X is O, S, Se or NR³⁰⁰;
X¹, X², X³, X^{4r} each independently represent O, S, Se or N; and
R^{b} to R^{e} are each independently represented as monosubstituted, disubstituted, trisubstituted, tetrasubstituted or unsubstituted; R^{b} to R^{e} are independently selected from a group consisting of hydrogen, deuterium, N, C1-C30 alkyl and C6-C60 aryl; R₄ to R₁₁ are each independently selected from a group consisting of a group consisting of hydrogen, deuterium, n, C1-C30 alkyl and C6-C60 aryl.

## Patentansprüche

1. Fluorhaltiger vierzähniger cyclometallierter Platin(II)-Komplex, der eine in Formel (I) oder Formel (II) gezeigte Struktur aufweist: 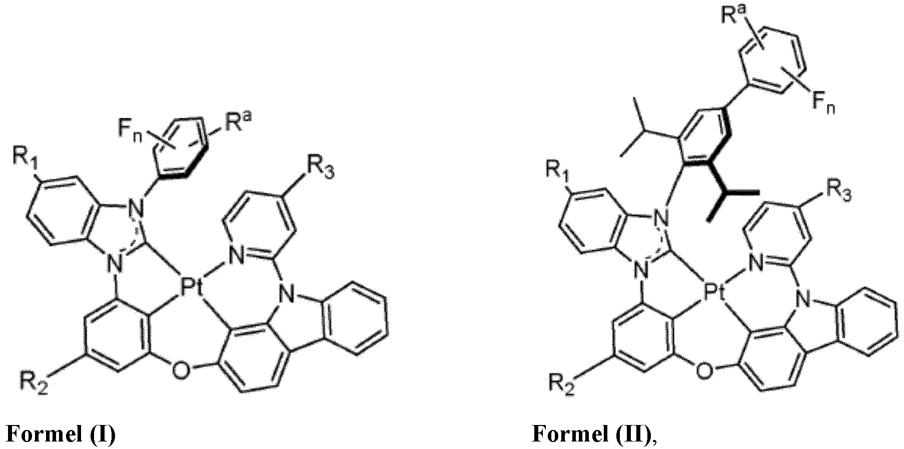
wobei in der Formel (I) oder der Formel (II) Fₙ angibt, dass ein oder mehrere F vorliegen, die an einem Benzolring substituiert sind, an dem sie sich befinden, wobei n eine positive ganze Zahl von 1 bis 5 ist;
R^{a} als monosubstituiert, disubstituiert, trisubstituiert, tetrasubstituiert oder unsubstituiert dargestellt ist; R^{a} aus H oder C1-C30-Alkyl ausgewählt ist;
R₁, R₂ und R₃ unabhängig aus einer Gruppe bestehend aus Wasserstoff, F, N, O, S, CN, C1-C30-Alkyl, C1-C30-Cycloalkyl, C1-C30-Heterocycloalkyl, C1-C30-Haloalkyl, C6-C60-Aryl und C6-C60-Heteroaryl ausgewählt sind.

2. Fluorhaltiger vierzähniger cyclometallierter Platin(II)-Komplex nach Anspruch 1, wobei mindestens ein Wasserstoff in R₁, R₂ und R₃ durch Deuterium oder F substituiert ist.

3. Fluorhaltiger vierzähniger cyclometallierter Platin(II)-Komplex nach Anspruch 1, wobei R₁ und R₃ unabhängig aus Wasserstoff oder C1-C30-Alkyl ausgewählt sind.

4. Fluorhaltiger vierzähniger cyclometallierter Platin(II)-Komplex nach Anspruch 1, wobei R₂ aus Wasserstoff, Deuterium, CN, substituiertem oder unsubstituiertem C1-C30-Alkyl, substituiertem oder unsubstituiertem C1-C30-Heteroalkyl, substituiertem oder unsubstituiertem C1-C30-Cycloalkyl, substituiertem oder unsubstituiertem C1-C30-Heterocycloalkyl, substituiertem oder unsubstituiertem C1-C30-Haloalkyl, substituiertem oder unsubstituiertem C6-C60-Aryl und substituiertem oder unsubstituiertem C6-C60 ausgewählt ist; wobei Heteroatome an dem Heteroalkyl, dem Heterocycloalkyl oder dem Heteroaryl aus einem oder mehreren von O, S und/oder N ausgewählt sind.

5. Fluorhaltiger vierzähniger cyclometallierter Platin(II)-Komplex nach Anspruch 1, wobei der fluorhaltige vierzähnige cyclometallierte Platin(II)-Komplex aus jenen mit einer beliebigen der folgenden chemischen Strukturen ausgewählt ist, wobei "D" für Deuterium steht:

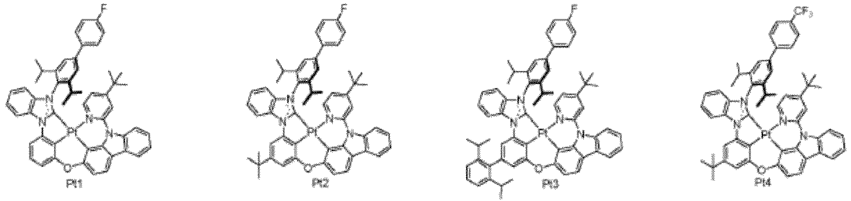

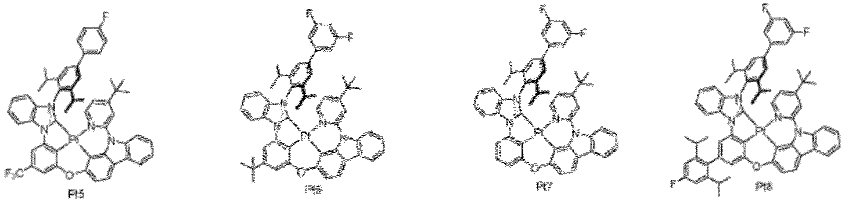

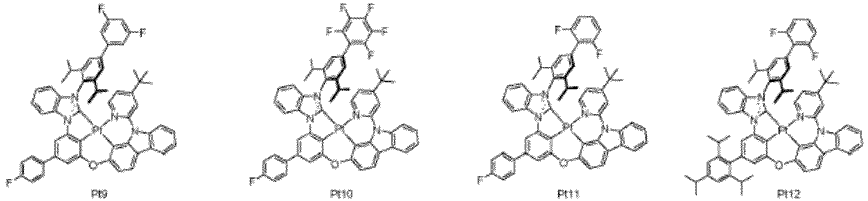

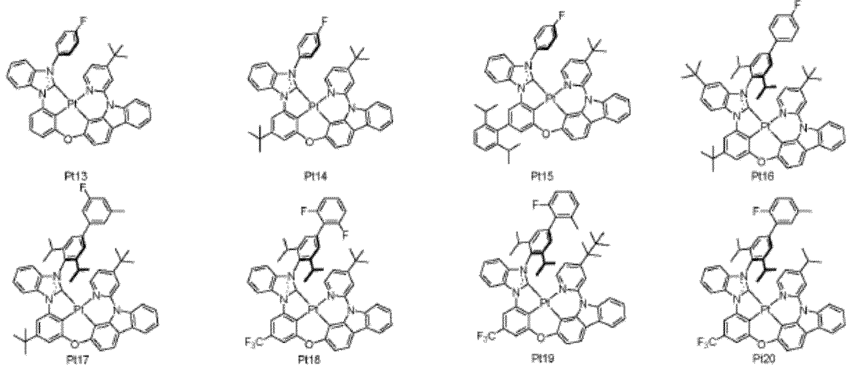

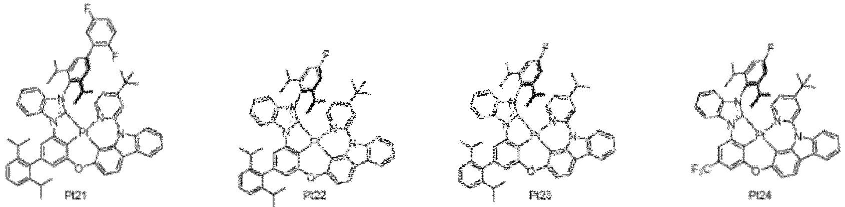

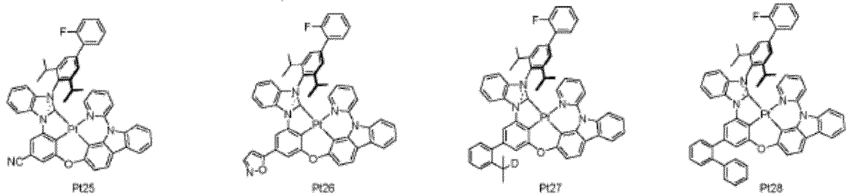

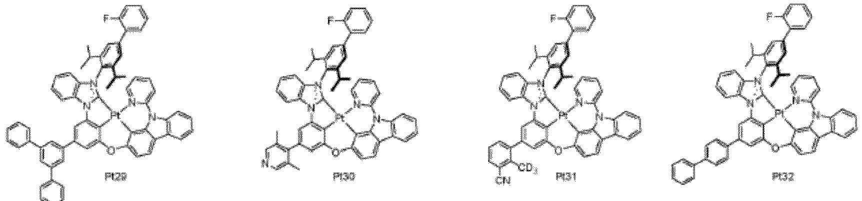

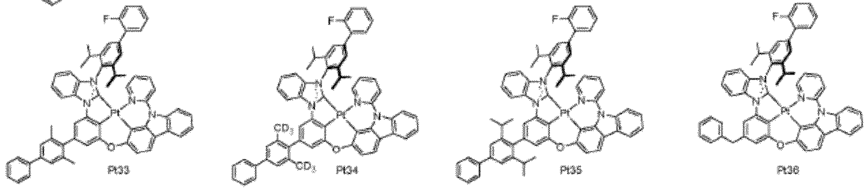

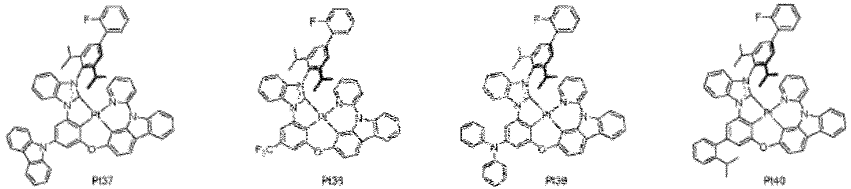

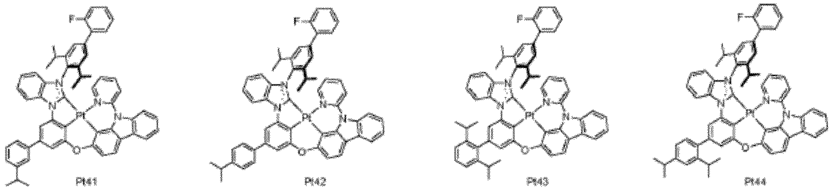

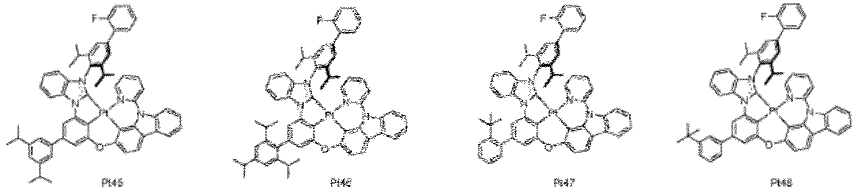

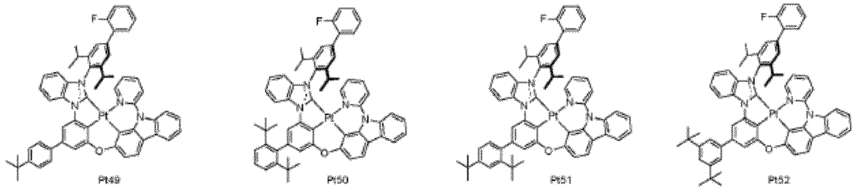

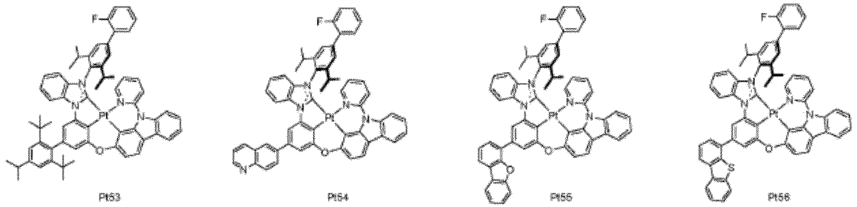

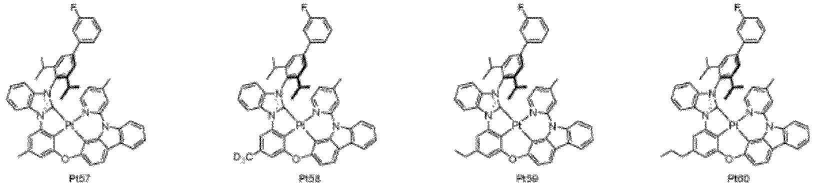

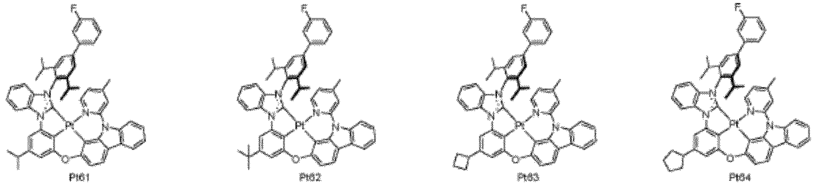

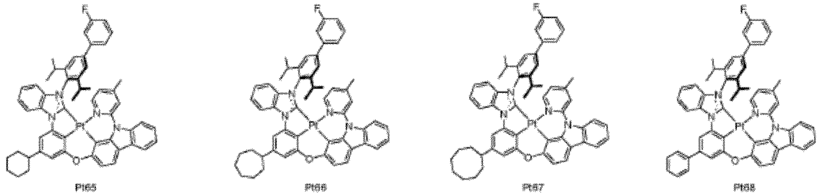

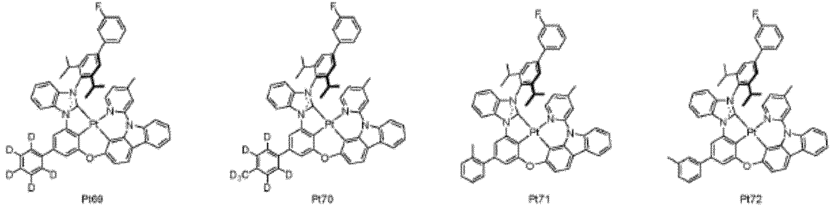

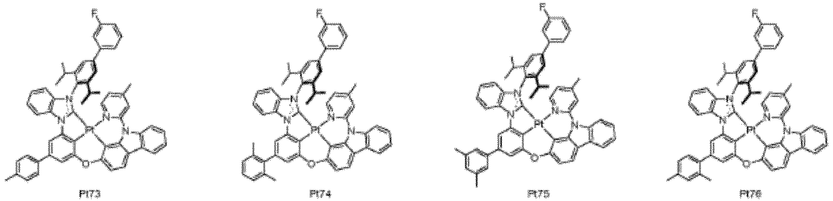

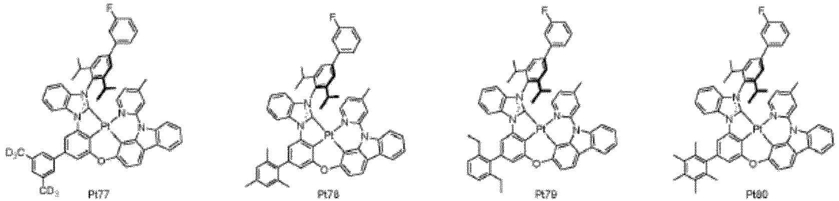

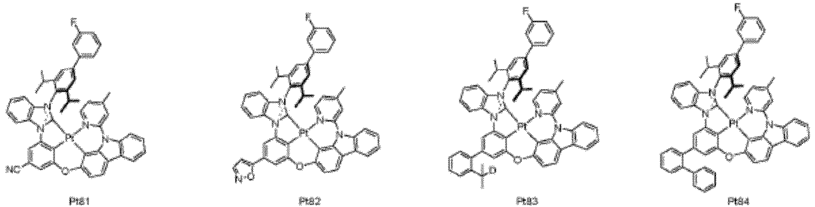

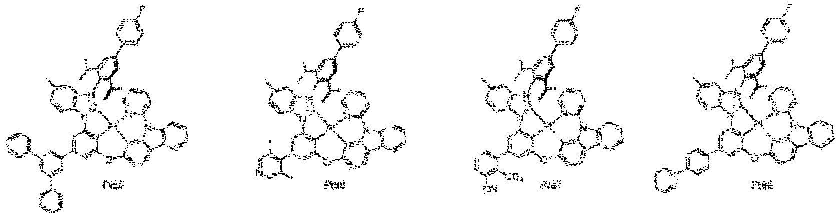

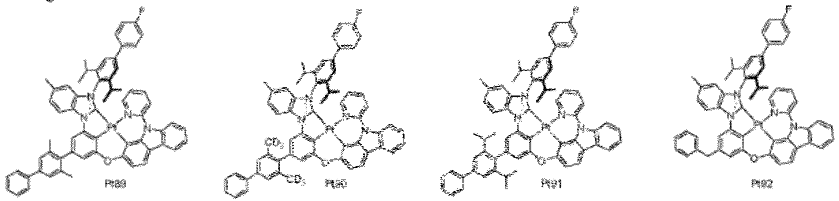

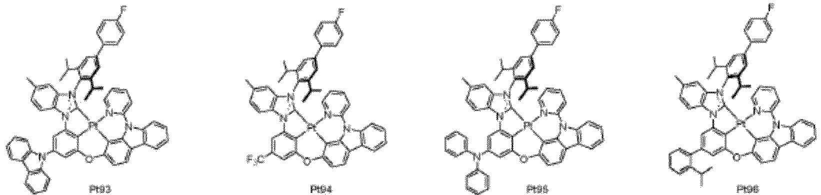

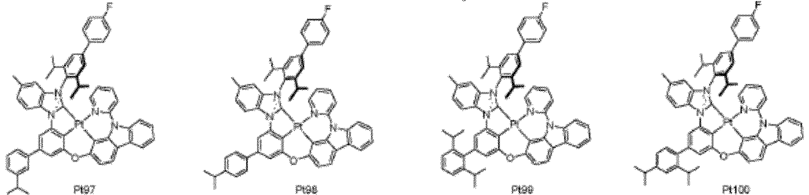

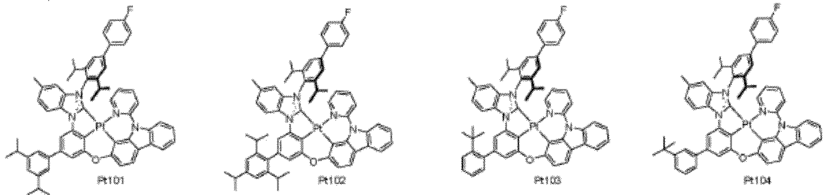

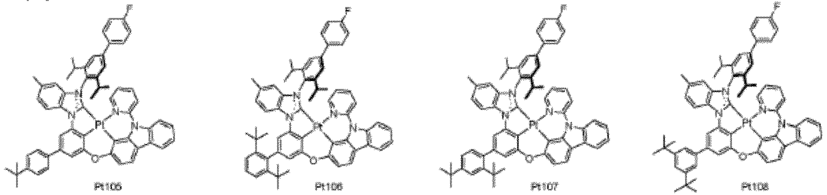

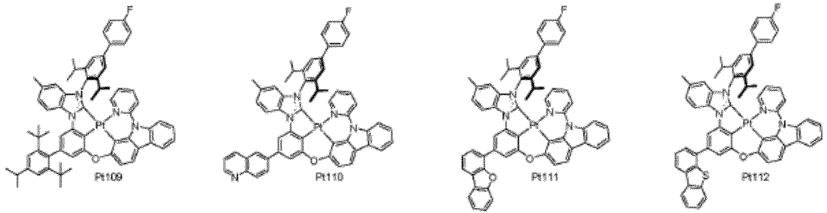

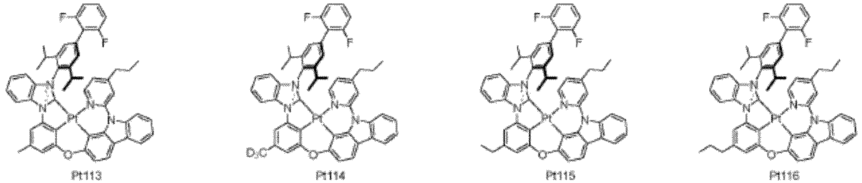

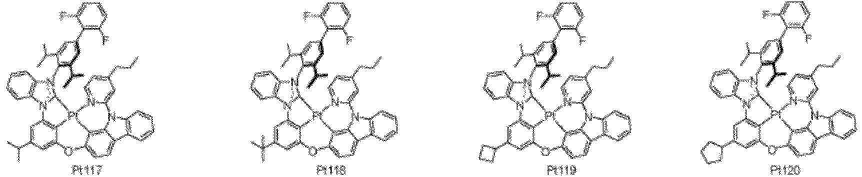

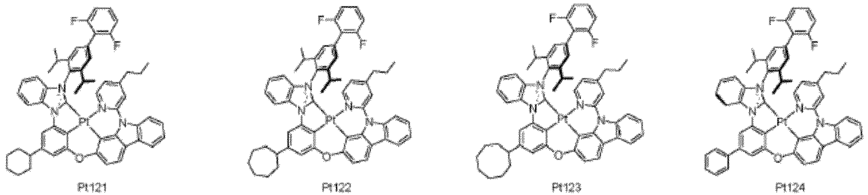

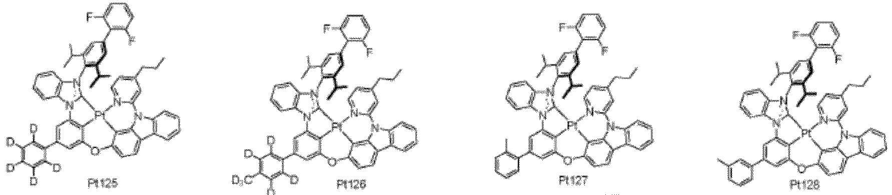

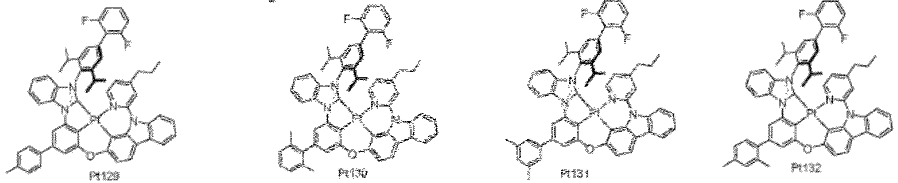

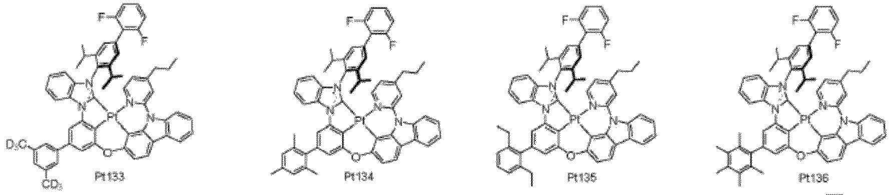

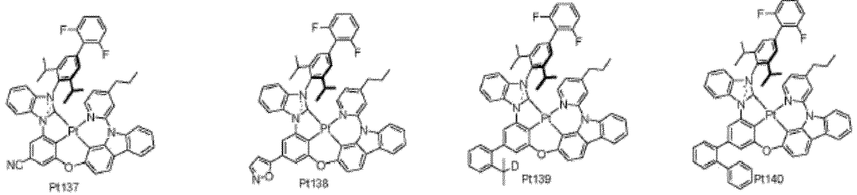

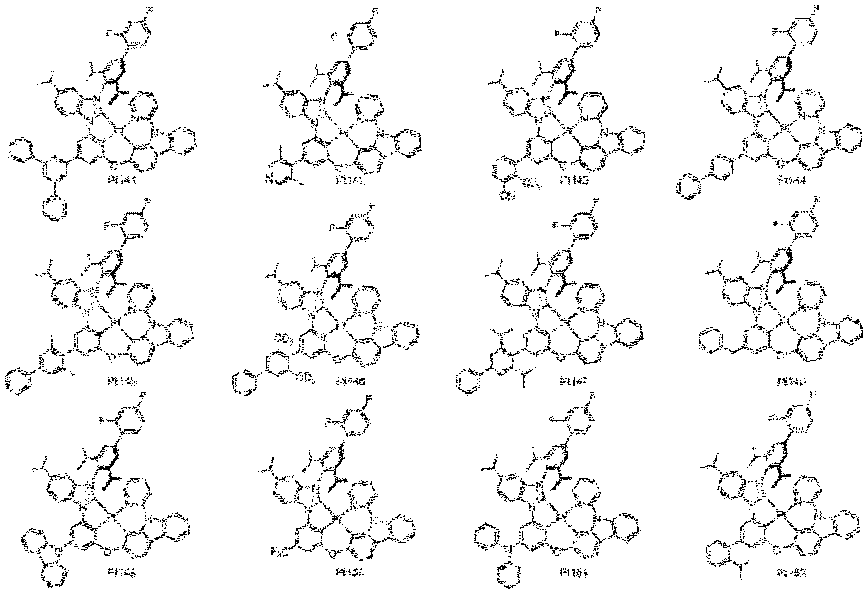

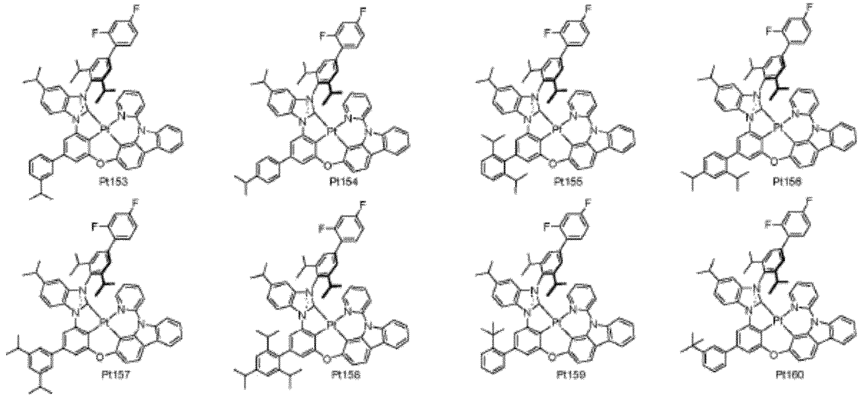

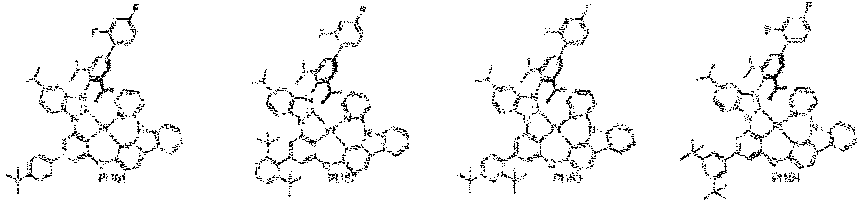

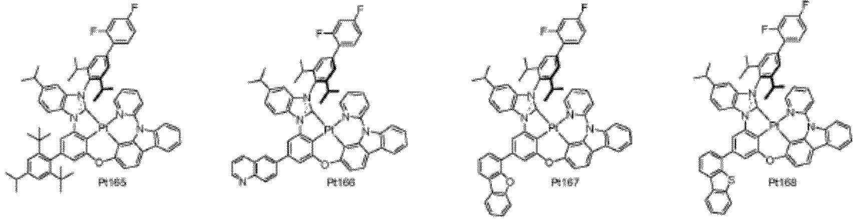

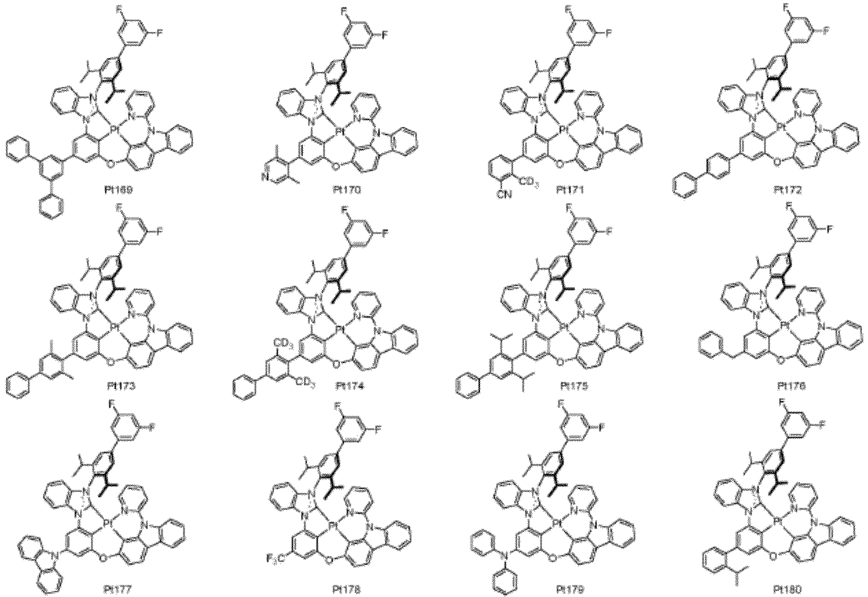

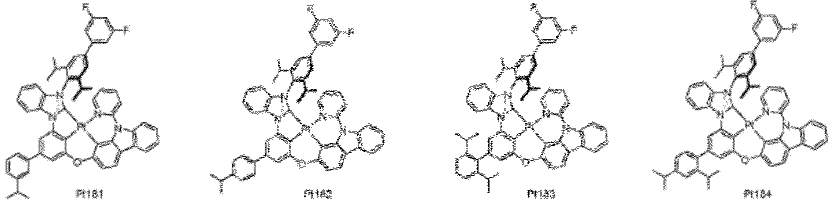

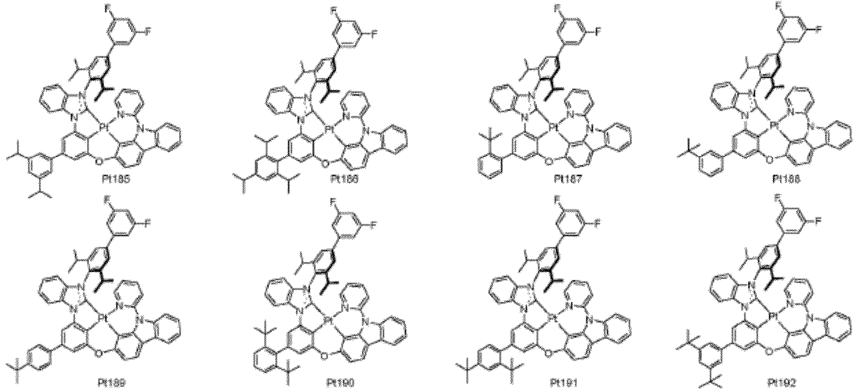

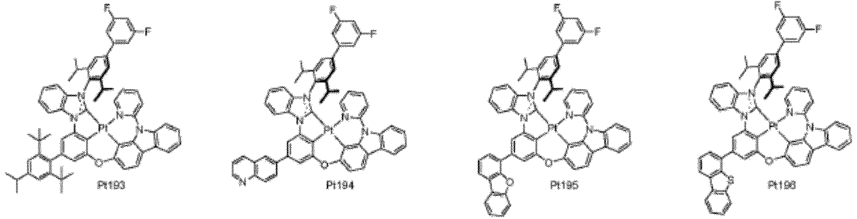

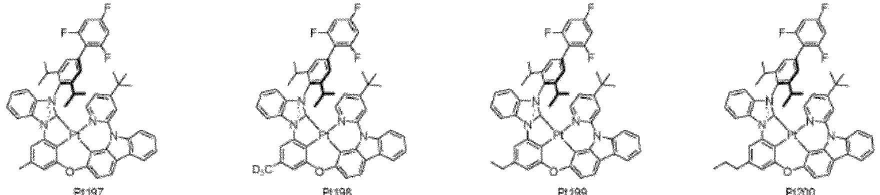

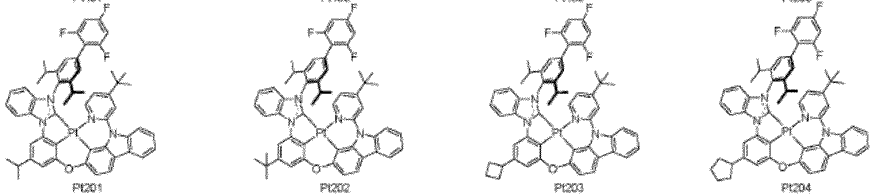

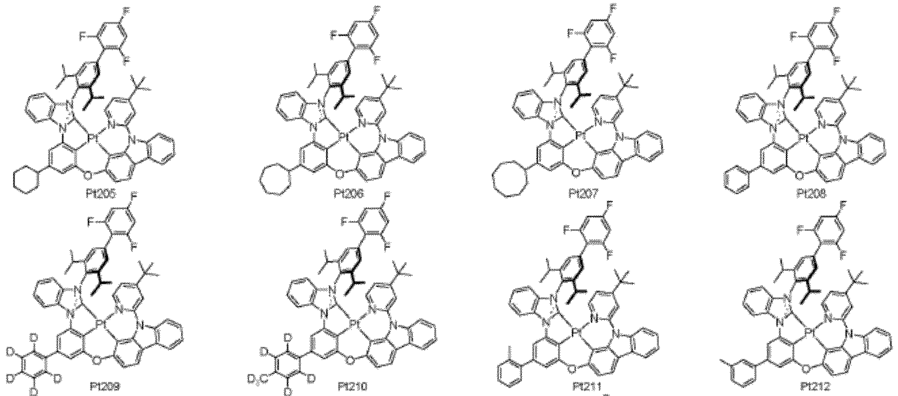

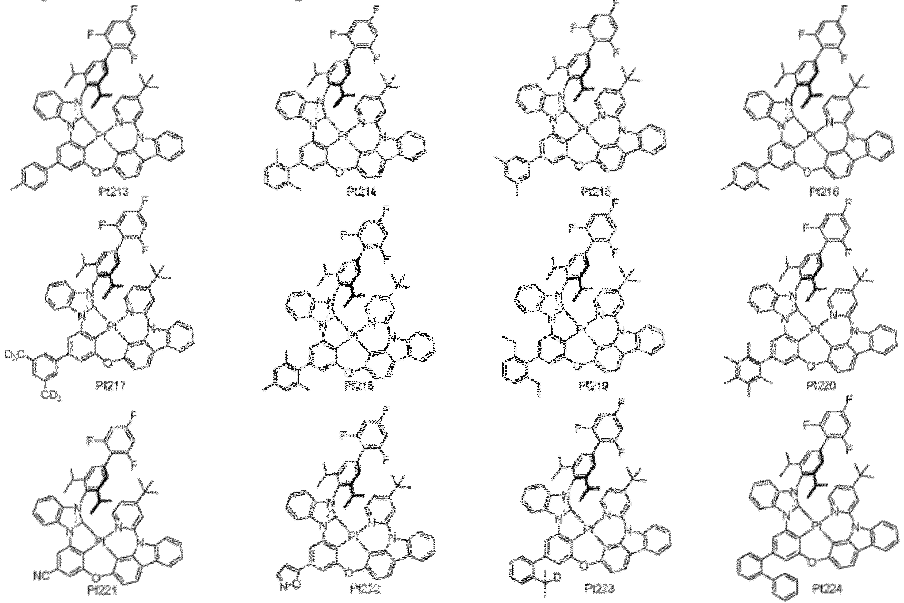

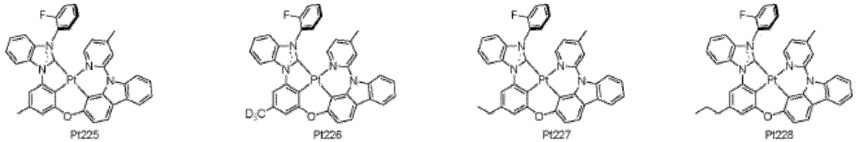

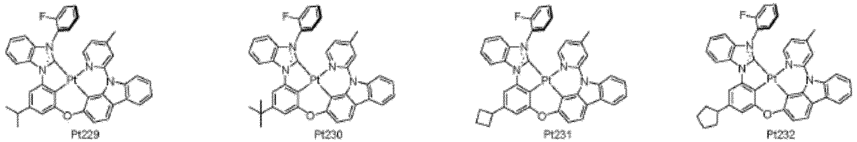

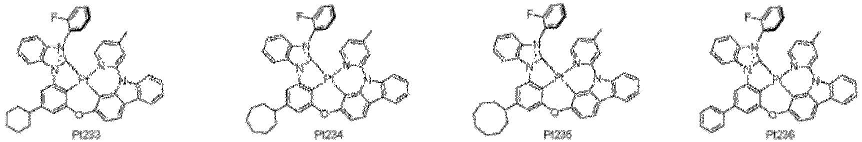

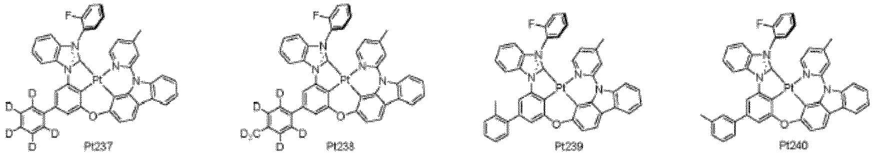

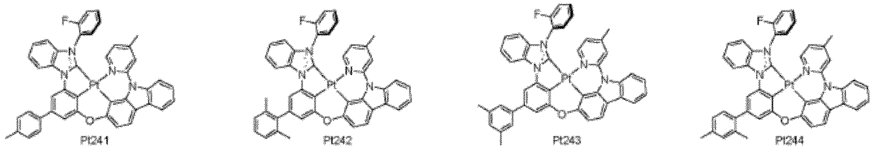

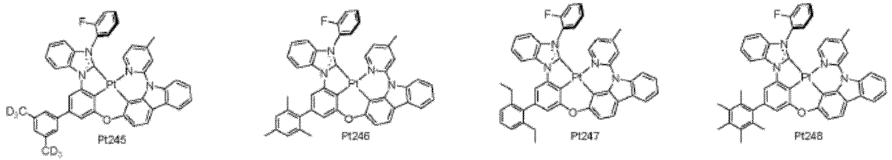

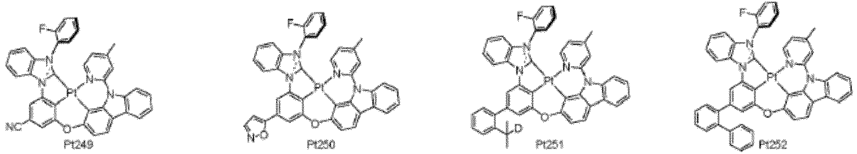

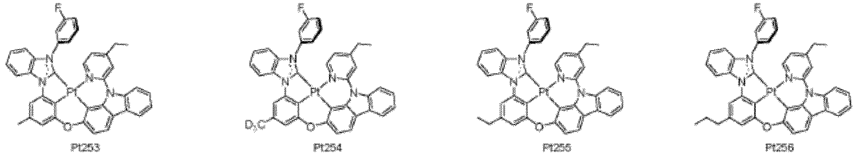

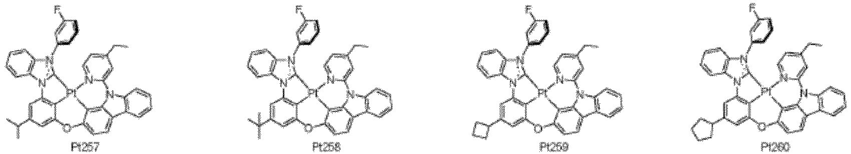

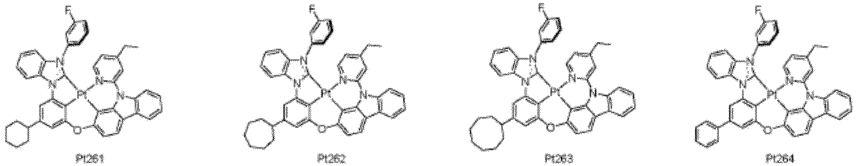

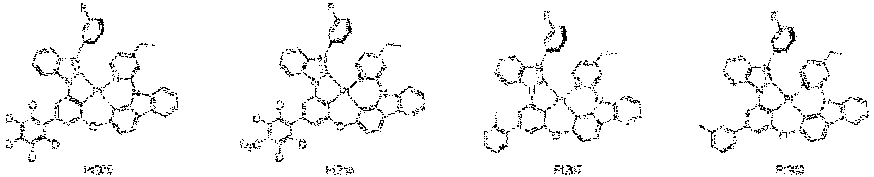

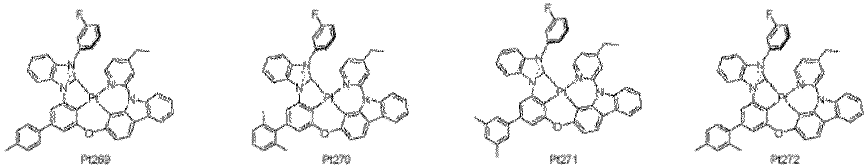

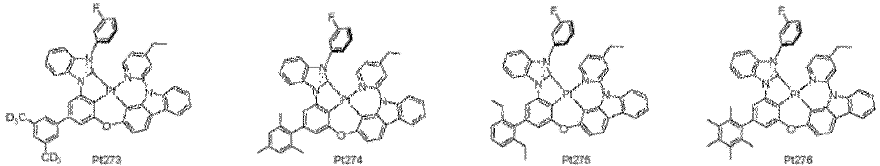

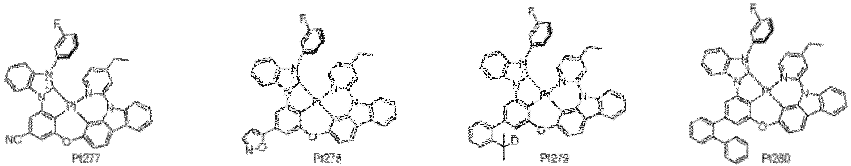

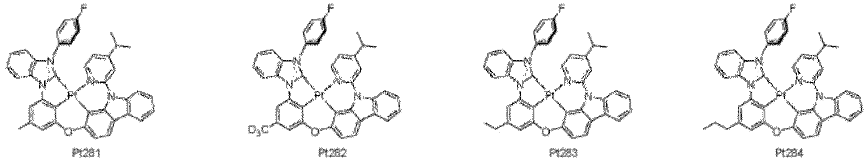

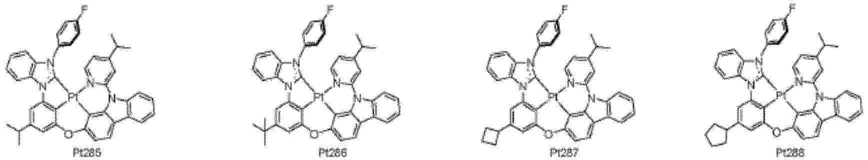

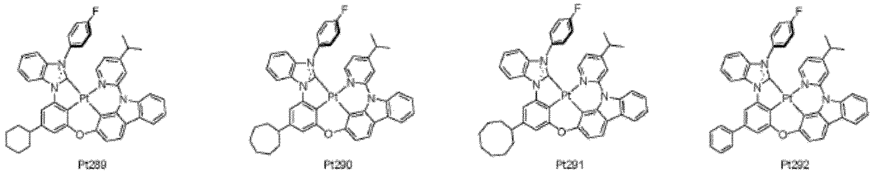

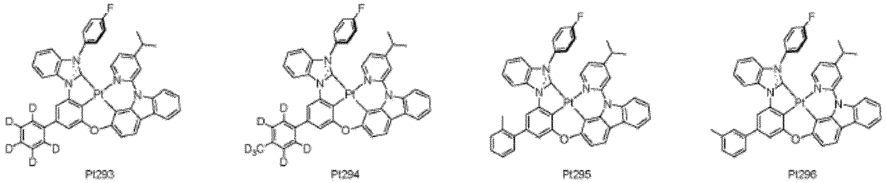

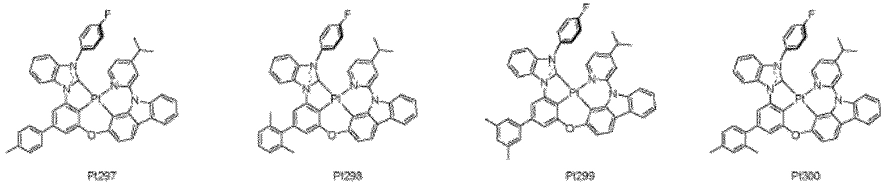

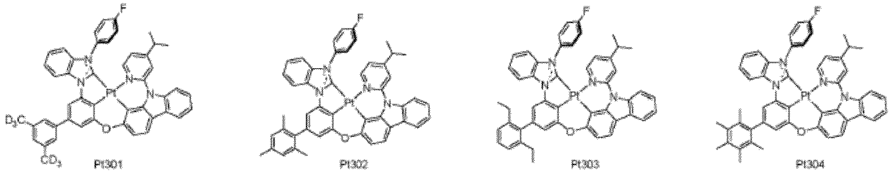

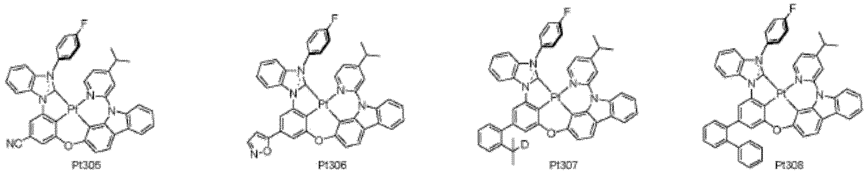

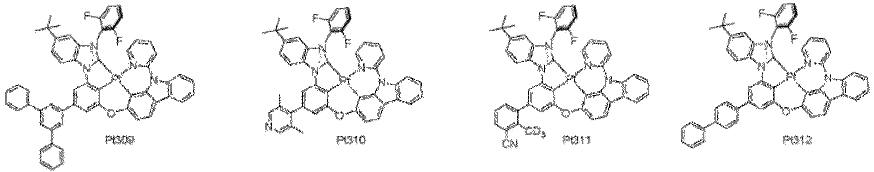

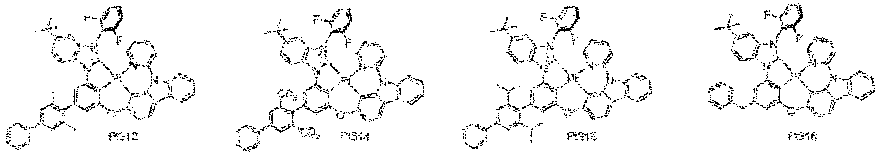

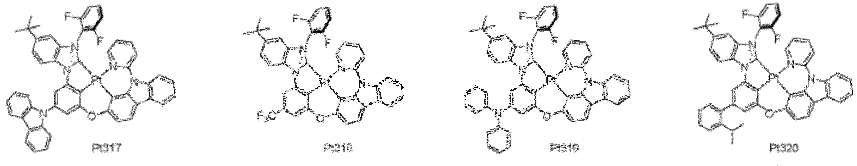

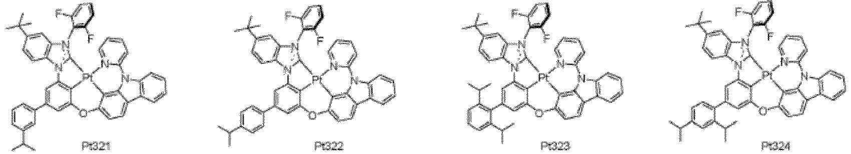

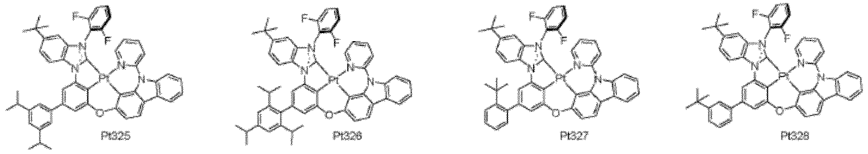

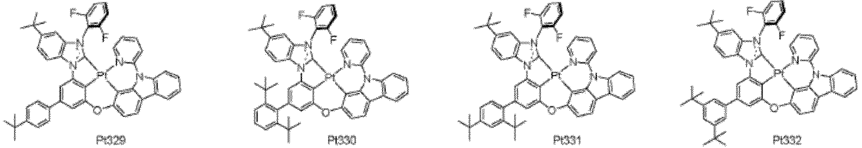

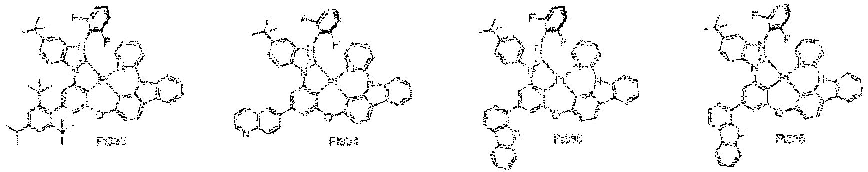

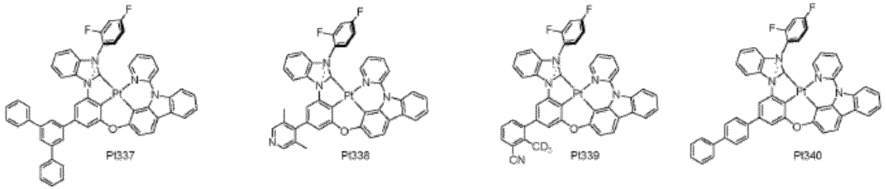

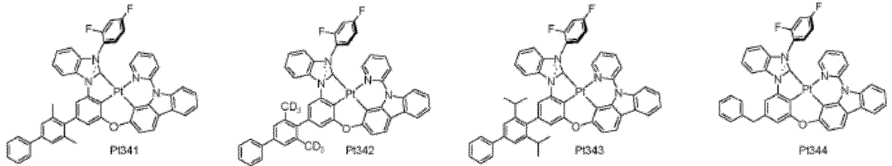

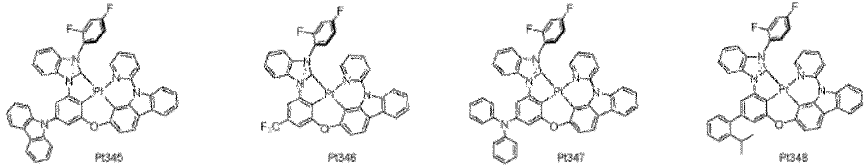

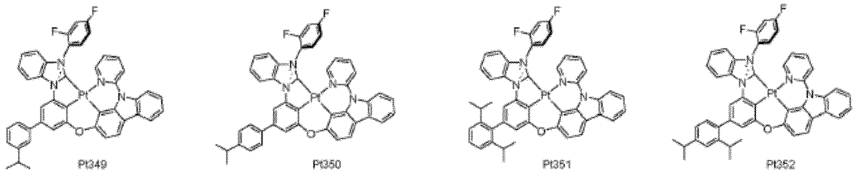

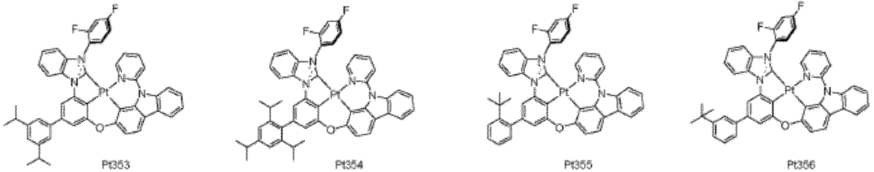

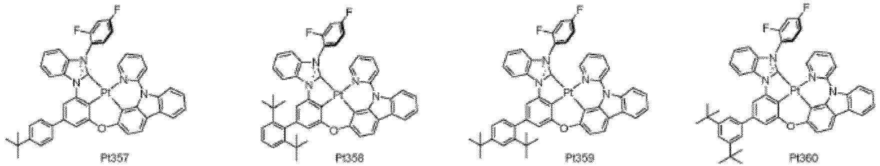

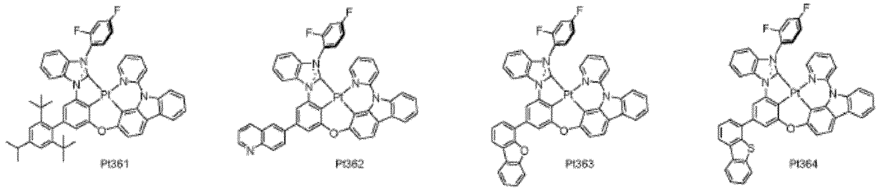

6. Anwendung des fluorhaltigen vierzähnigen cyclometallierten Platin(II)-Komplexes nach einem der Ansprüche 1 bis 5 in einer elektronischen Vorrichtung.

7. Anwendung nach Anspruch 6, wobei die elektronische Vorrichtung eine organische lichtemittierende Vorrichtung, eine organische integrierte Schaltung, einen organischen Feldeffekttransistor, einen organischen Dünnschichttransistor, einen organischen lichtemittierenden Transistor, eine organische Solarzelle, einen organischen optischen Detektor, eine organische Field-Quench-Vorrichtung, eine lichtemittierende elektrochemische Zelle und eine organische Laserdiode umfasst.

8. Organische lichtemittierende Vorrichtung, umfassend eine Kathode, eine Anode und eine organische Funktionsschicht dazwischen, wobei die organische Funktionsschicht den fluorhaltigen vierzähnigen cyclometallierten Platin(II)-Komplex nach einem der Ansprüche 1 bis 5 umfasst.

9. Organische lichtemittierende Vorrichtung, umfassend eine lichtemittierende Schicht, wobei die lichtemittierende Schicht den fluorhaltigen vierzähnigen cyclometallierten Platin(II)-Komplex nach einem der Ansprüche 1 bis 5 umfasst.

10. Organische lichtemittierende Vorrichtung nach Anspruch 9, wobei die lichtemittierende Schicht ferner ein fluoreszierendes Dotiermaterial umfasst, wobei das fluoreszierende Dotiermaterial aus einer beliebigen oder beliebigen mehreren Verbindungen, die durch die Formeln (BN1) bis (BN5) dargestellt sind, ausgewählt ist: 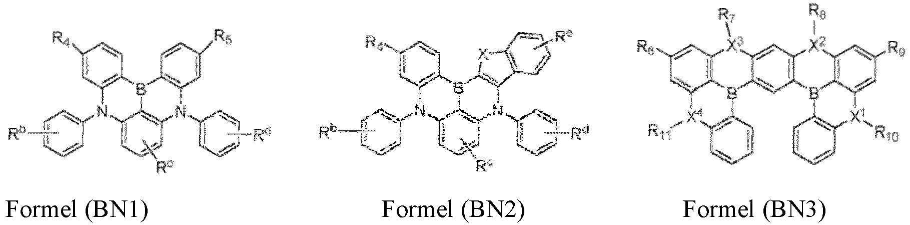 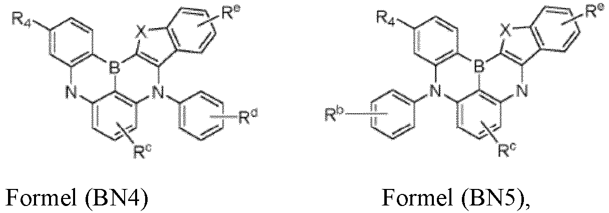
wobei X O, S, Se oder NR³⁰⁰ ist;
X¹, X², X³, X^{4r} jeweils unabhängig für O, S, Se oder N stehen; und
R^{b} bis R^{e} jeweils unabhängig als monosubstituiert, disubstituiert, trisubstituiert, tetrasubstituiert oder unsubstituiert dargestellt sind; R^{b} bis R^{e} unabhängig aus einer Gruppe bestehend aus Wasserstoff, Deuterium, N, C1-C30-Alkyl und C6-C60-Aryl ausgewählt sind; R₄ bis R₁₁ jeweils unabhängig aus einer Gruppe bestehend aus Wasserstoff, Deuterium, n, C1-C30-Alkyl und C6-C60-Aryl ausgewählt sind.

11. Organische lichtemittierende Vorrichtung nach Anspruch 10, wobei R₄ bis R₆ und R₉ unabhängig aus substituierten oder unsubstituierten Diphenylamingruppen oder substituierten oder unsubstituierten Carbazolgruppen ausgewählt sind; wobei es sich bei einer Substitution um mehrere Substitutionen handeln kann und wenn ein Substituent enthalten ist, der Substituent aus Deuterium, C1-C30-Alkyl und C6-C30-Aryl ausgewählt ist.

12. Organische lichtemittierende Vorrichtung nach Anspruch 10, wobei R₇ bis R₈ und R₁₀ bis R₁₁ unabhängig aus einer Gruppe bestehend aus Wasserstoff, C1-C30-Alkyl und C6-C60-Aryl ausgewählt sind.

13. Organische lichtemittierende Vorrichtung nach Anspruch 10, wobei das fluoreszierende Dotiermaterial aus einer beliebigen der folgenden chemischen Strukturen ausgewählt ist, wobei Ph für eine Phenylgruppe steht und D4 und D5 sich jeweils auf durch 4 und 5 Deuterium-Atome substituiert bezieht:

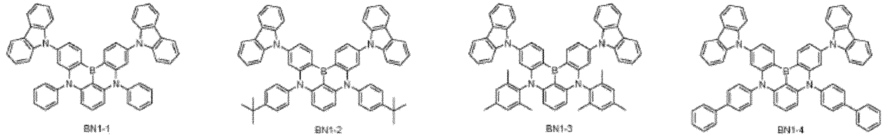

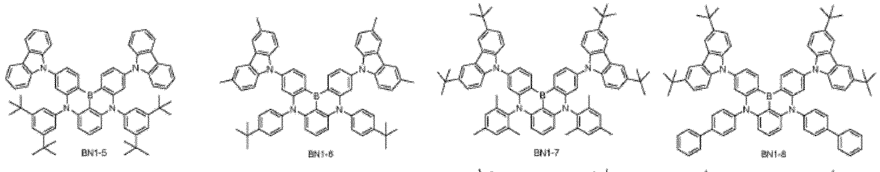

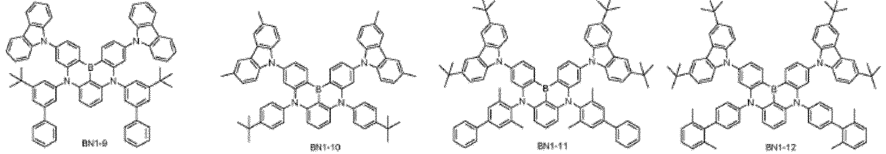

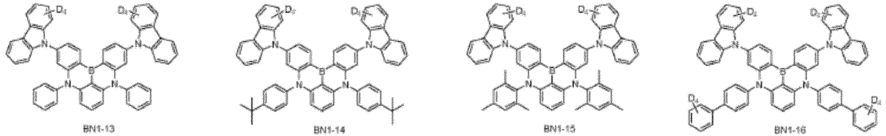

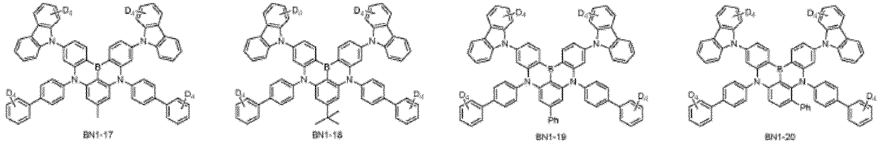

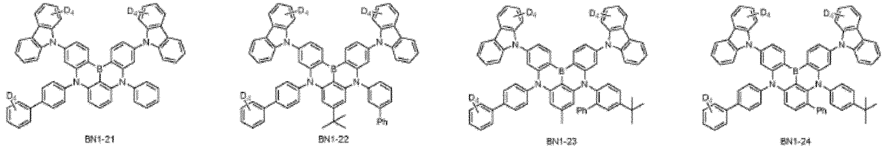

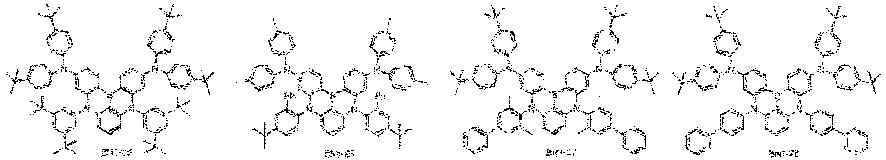

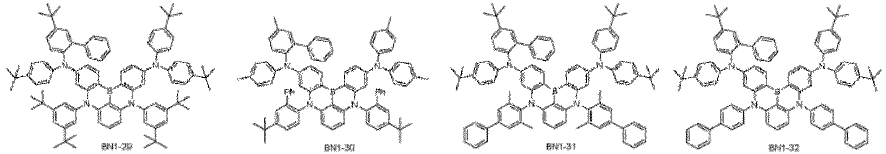

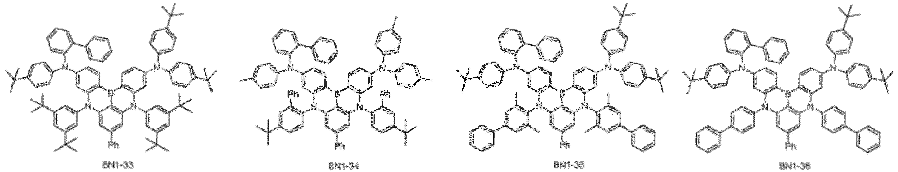

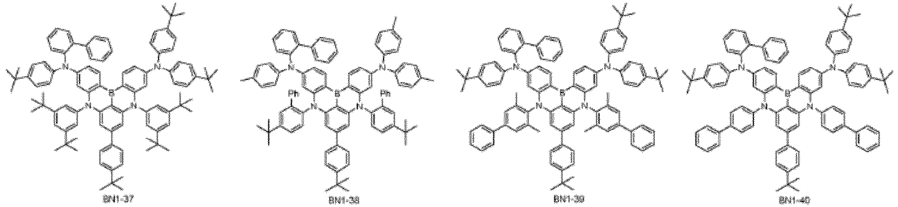

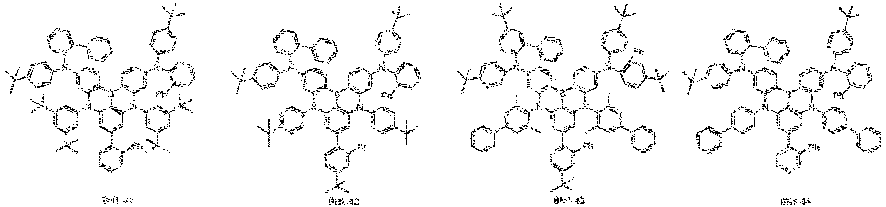

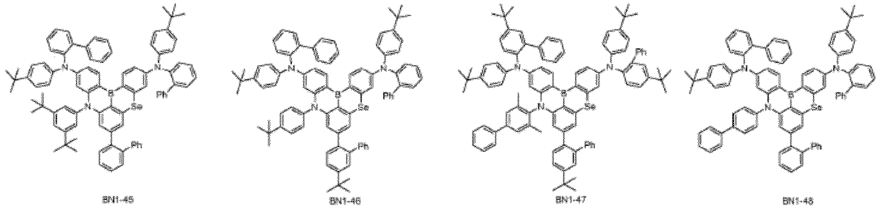

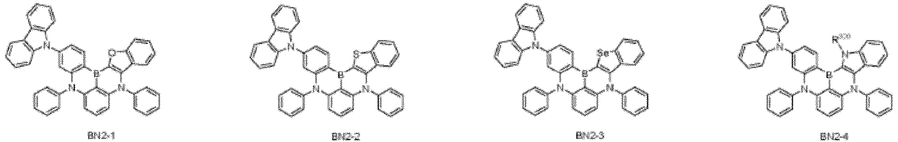

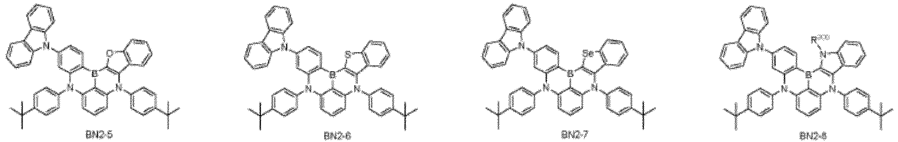

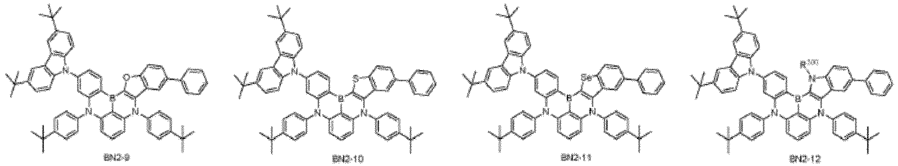

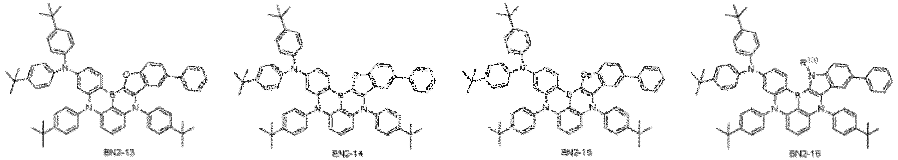

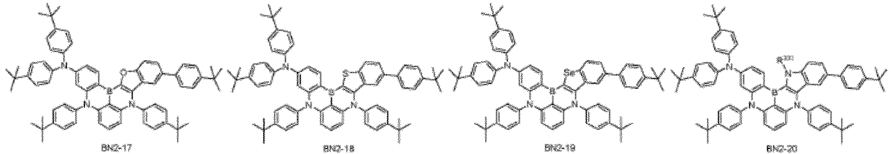

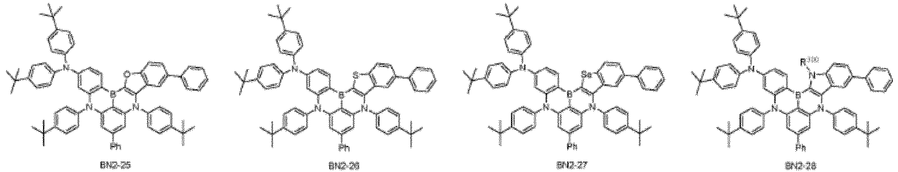

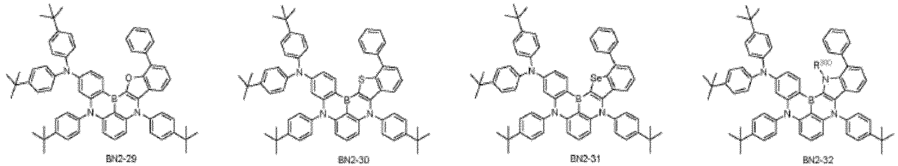

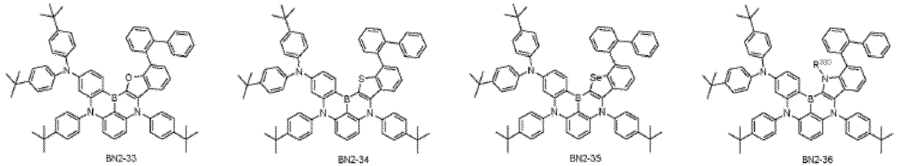

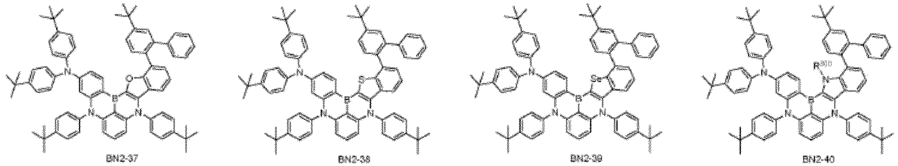

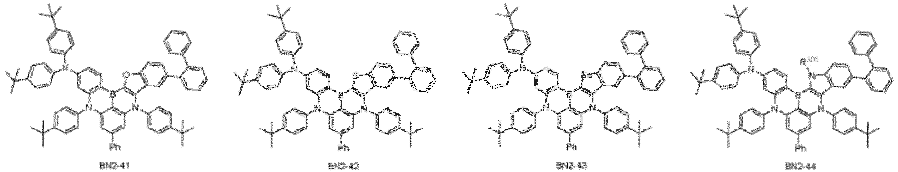

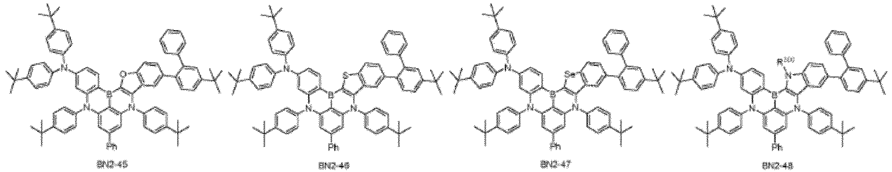

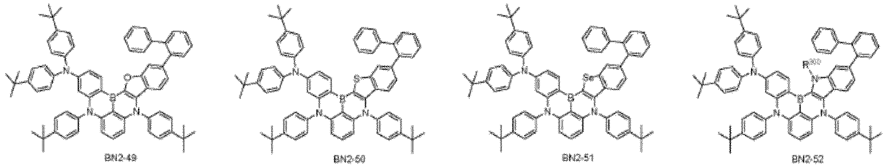

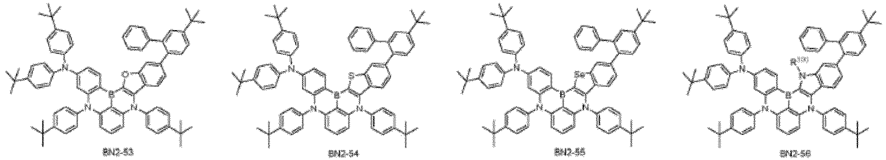

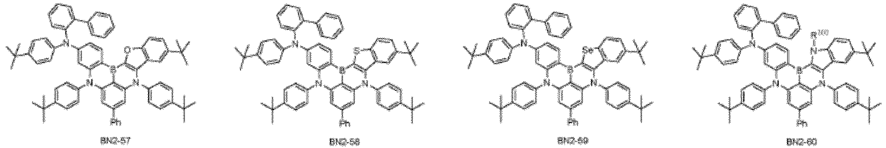

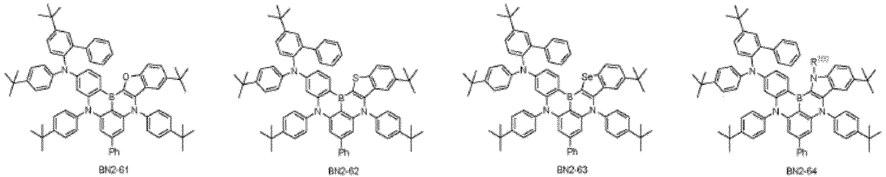

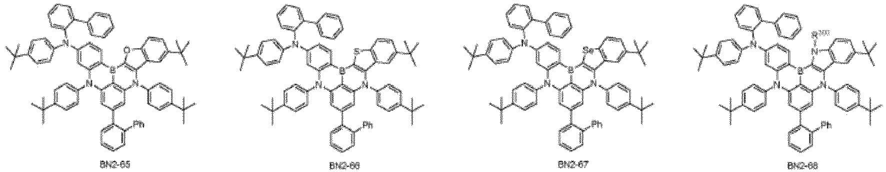

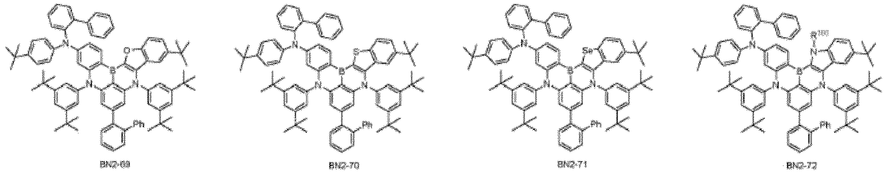

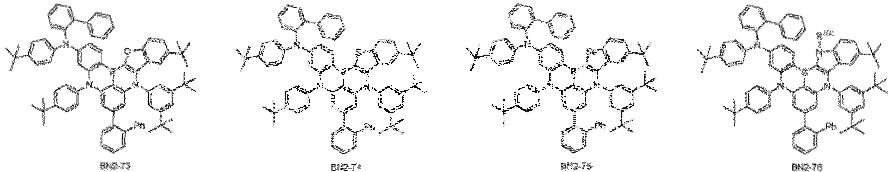

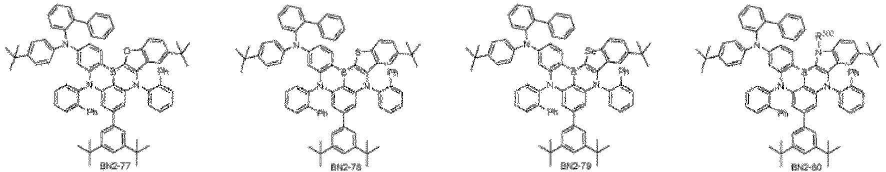

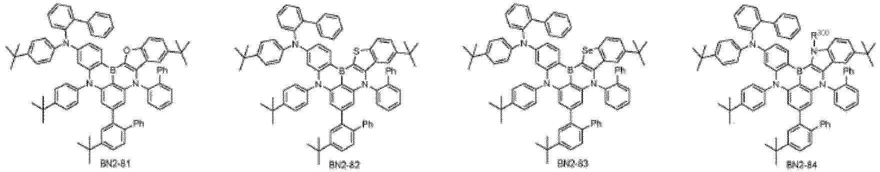

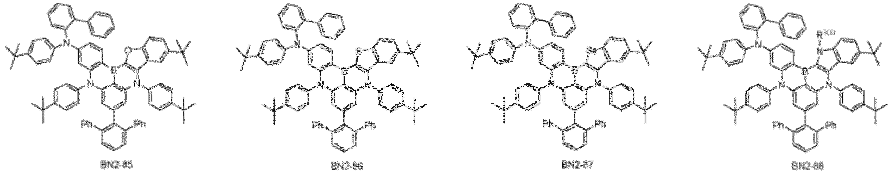

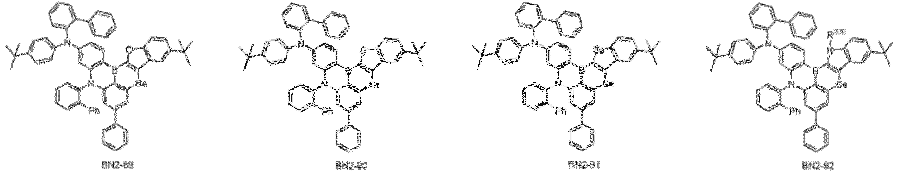

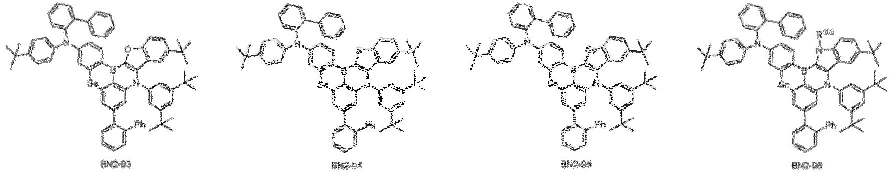

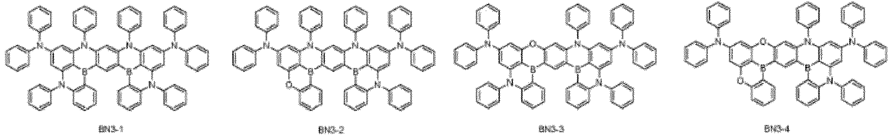

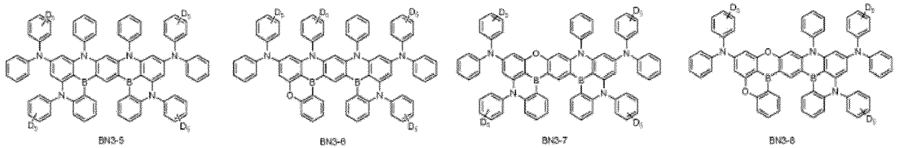

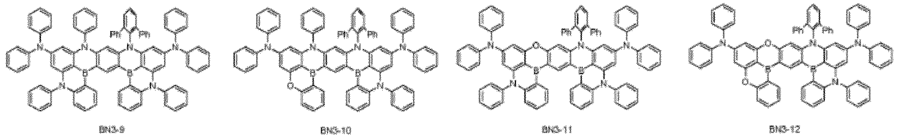

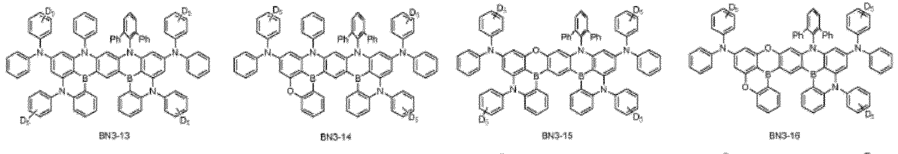

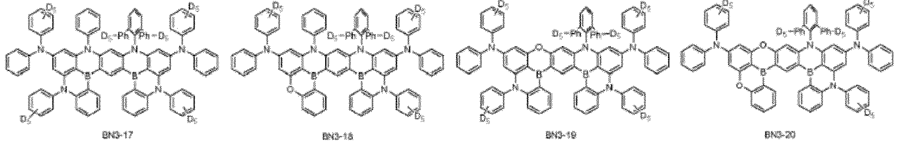

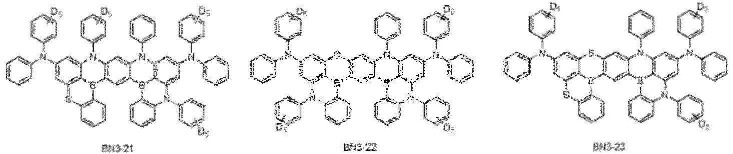

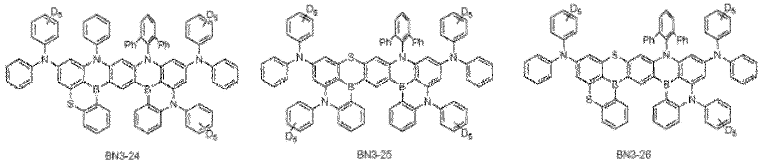

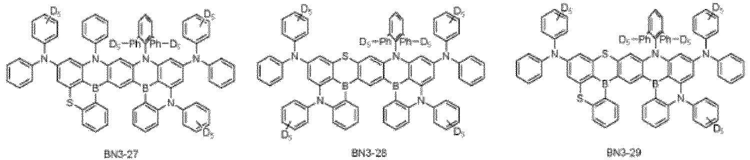

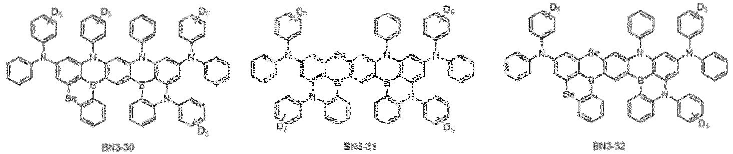

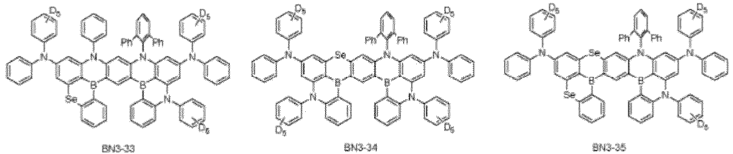

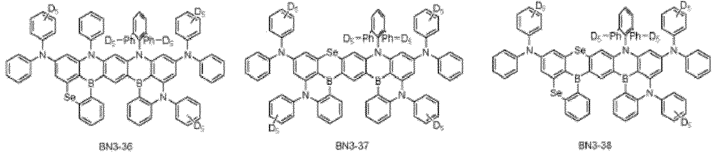

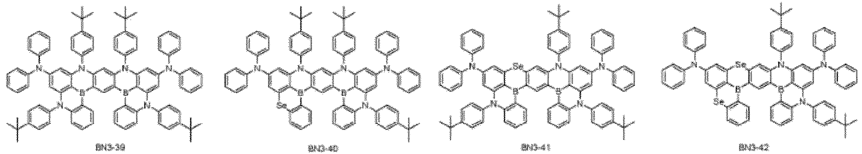

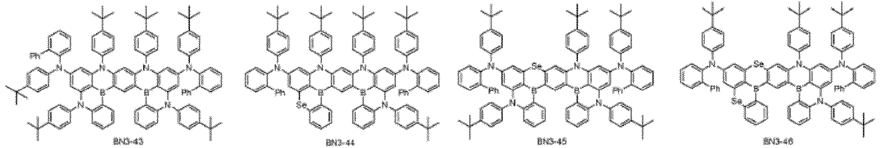

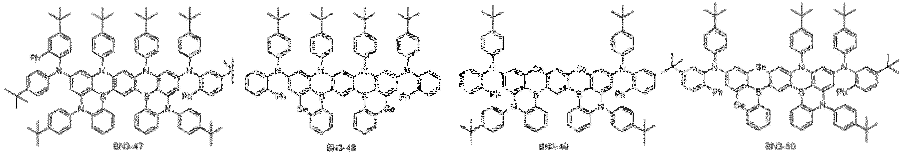

14. Organische photoelektrische Vorrichtung, umfassend: eine Substratschicht; eine erste Elektrode auf dem Substrat; eine organische lichtemittierende Funktionsschicht auf der ersten Elektrode; eine zweite Elektrode auf der organischen lichtemittierenden Funktionsschicht, wobei die organische lichtemittierende Funktionsschicht den fluorhaltigen vierzähnigen cyclometallierten Platin(II)-Komplex nach einem der Ansprüche 1 bis 5 umfasst.

15. Organische photoelektrische Vorrichtung nach Anspruch 14, wobei die organische lichtemittierende Funktionsschicht ferner ein fluoreszierendes Dotiermaterial umfasst, wobei das fluoreszierende Dotiermaterial aus einer beliebigen oder beliebigen mehreren Verbindungen, die durch die Formeln (BN1) bis (BN5) dargestellt sind, ausgewählt ist: 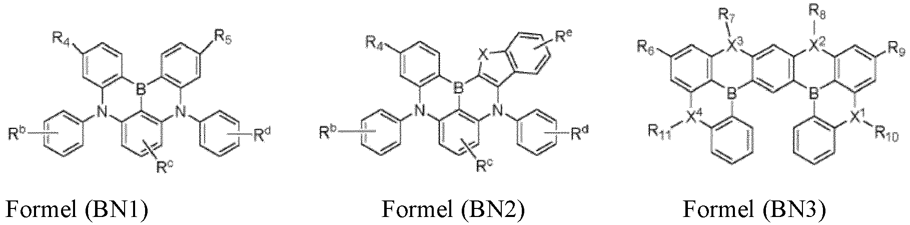 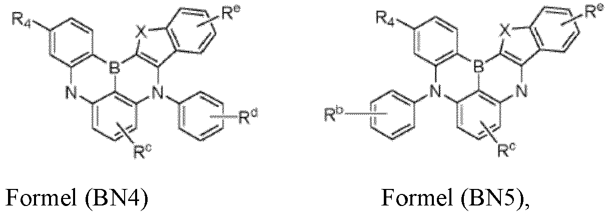
wobei X O, S, Se oder NR³⁰⁰ ist;
X¹, X², X³, X^{4r} jeweils unabhängig für O, S, Se oder N stehen; und
R^{b} bis R^{e} jeweils unabhängig als monosubstituiert, disubstituiert, trisubstituiert, tetrasubstituiert oder unsubstituiert dargestellt sind; R^{b} bis R^{e} unabhängig aus einer Gruppe bestehend aus Wasserstoff, Deuterium, N, C1-C30-Alkyl und C6-C60-Aryl ausgewählt sind; R₄ bis R₁₁ jeweils unabhängig aus einer Gruppe bestehend aus Wasserstoff, Deuterium, n, C1-C30-Alkyl und C6-C60-Aryl ausgewählt sind.

## Revendications

1. Complexe de platine (II) tétradentate cyclométalé contenant du fluor, dont la structure est représentée par la formule (I) ou la formule (II) : 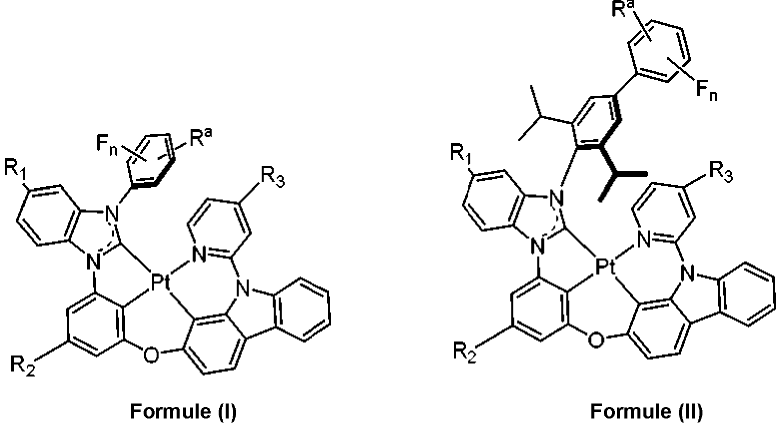
dans la formule (I) ou la formule (II), Fₙ indique qu'il y a un ou plusieurs F substitués sur un cycle benzénique où il se trouve, où n est un entier positif compris entre 1 et 5 ;
R^{a} est représenté sous forme monosubstituée, disubstituée, trisubstituée, tétrasubstituée ou non substituée ; R^{a} est choisi parmi H ou un alkyle C1-C30 ;
R₁, R₂ et R₃ sont choisis indépendamment dans un groupe constitué d'hydrogène, F, N, O, S, CN, alkyle C1-C30, cycloalkyle C1-C30, hétérocycloalkyle C1-C30, haloalkyle C1-C30, aryle C6-C60 et hétéroaryle C6-C60.

2. Complexe de platine (II) tétradentate cyclométalé contenant du fluor selon la revendication 1, **caractérisé en ce qu'**au moins un hydrogène dans R₁, R₂ et R₃ est substitué par du deutérium ou F.

3. Complexe de platine (II) tétradentate cyclométalé contenant du fluor selon la revendication 1, **caractérisé en ce que** R₁ et R₃ sont indépendamment sélectionnés parmi l'hydrogène ou un alkyle C1-C30.

4. Complexe de platine (II) tétradentate cyclométalé contenant du fluor selon la revendication 1, **caractérisé en ce que** R₂ est choisi parmi hydrogène, deutérium, CN, alkyle C1-C30 substitué ou non substitué, hétéroalkyle C1-C30 substitué ou non substitué, cycloalkyle C1-C30 substitué ou non substitué, hétérocycloalkyle C1-C30 substitué ou non substitué, halogénure C1-C30 substitué ou non substitué alkyle, aryle C6-C60 substitué ou non substitué, et C6-C60 substitué ou non substitué ; les hétéroatomes de l'hétéroalkyle, de l'hétérocycloalkyle ou de l'hétéroaryle étant sélectionnés parmi O, S et/ou N.

5. Complexe de platine (II) tétradentate cyclométalé contenant du fluor selon la revendication 1, **caractérisé en ce que** le complexe de platine (II) tétradentate cyclométalé contenant du fluor est choisi parmi ceux présentant l'une des structures chimiques suivantes, où « D » représente le deutérium :

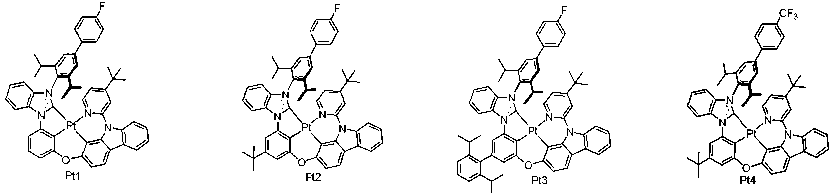

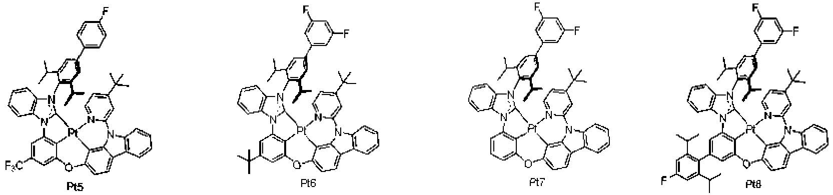

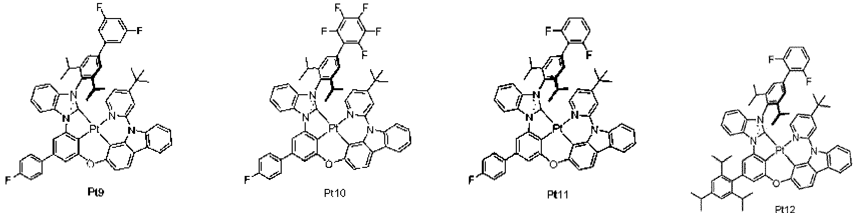

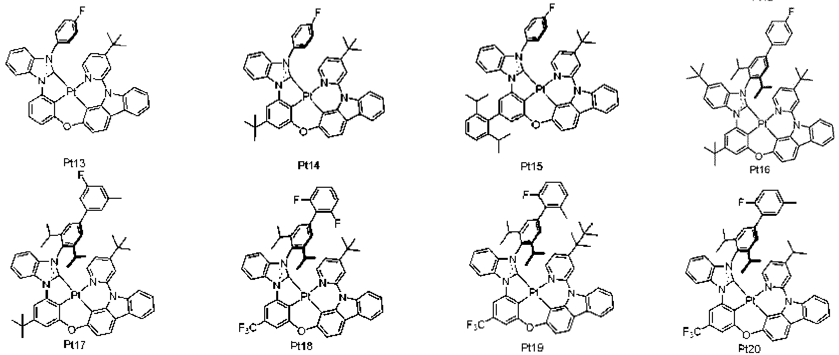

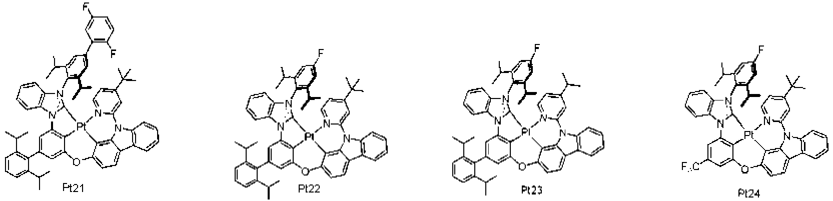

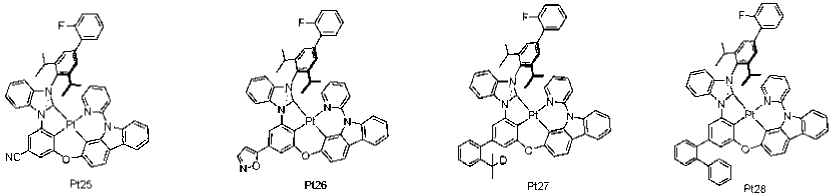

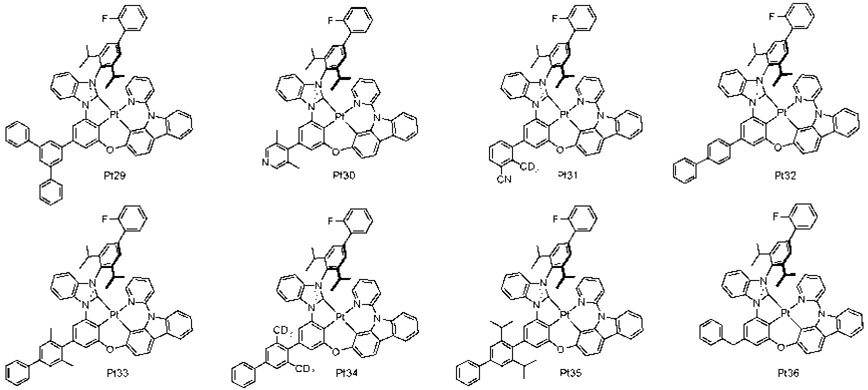

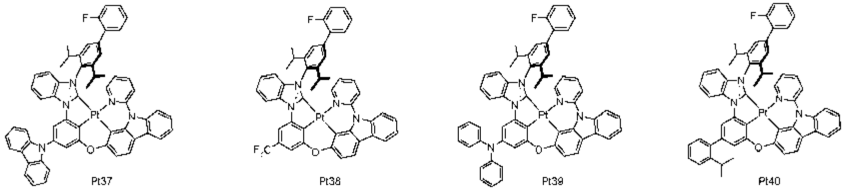

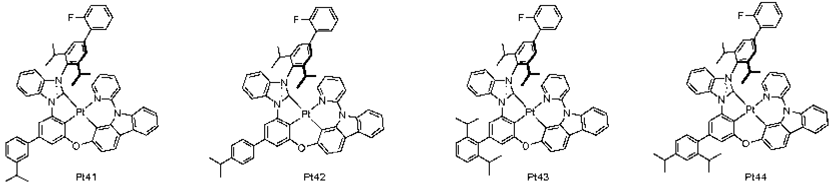

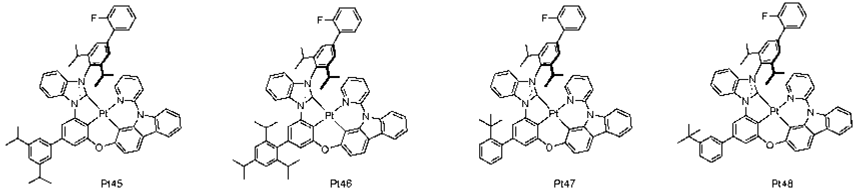

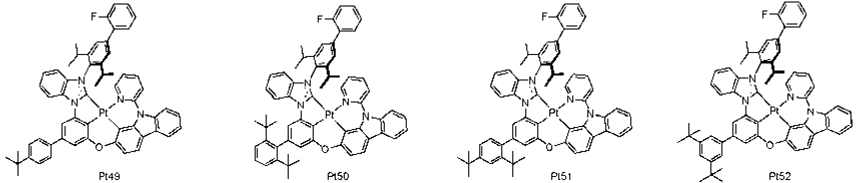

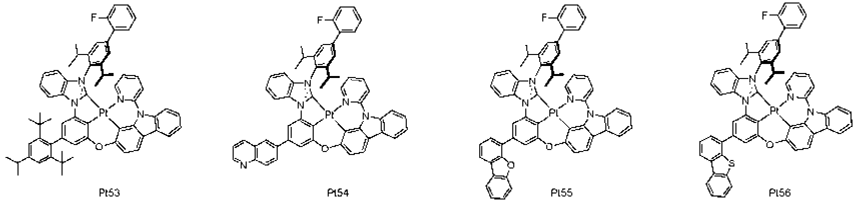

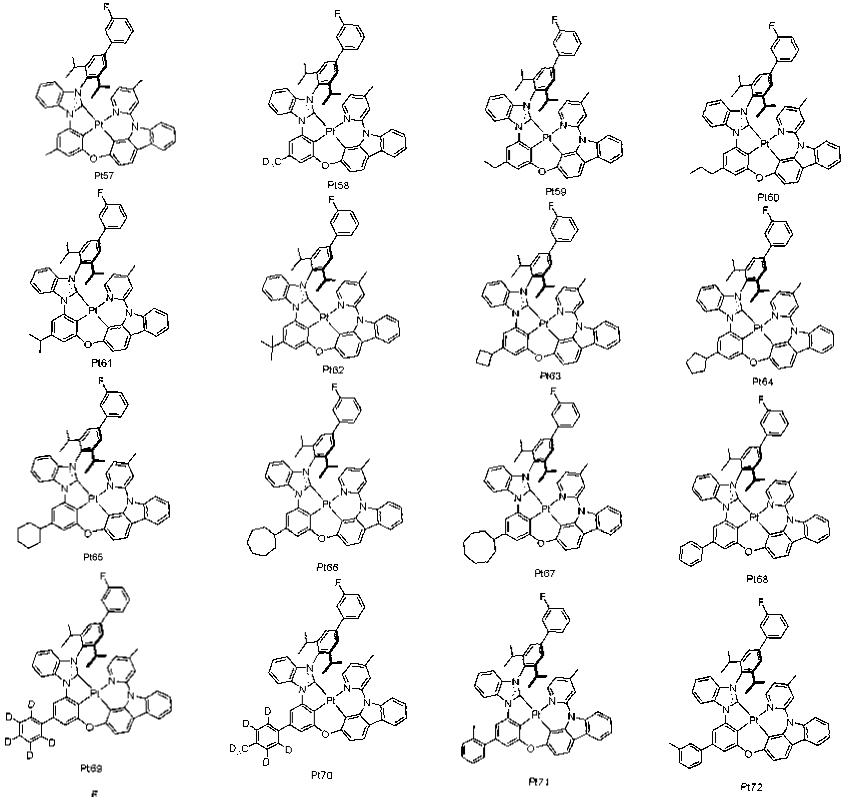

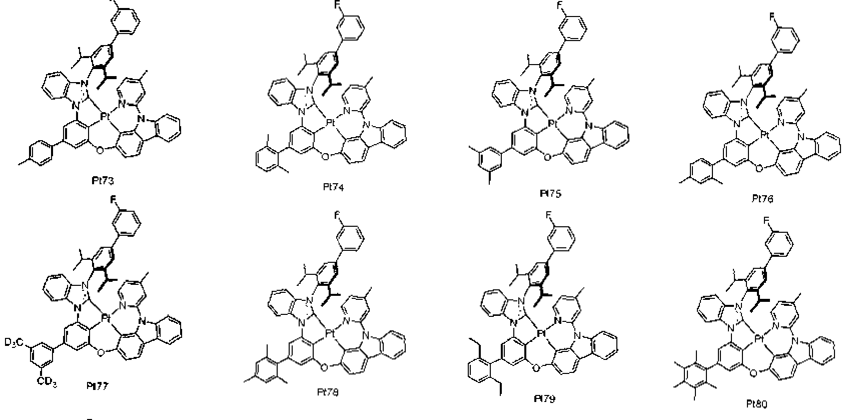

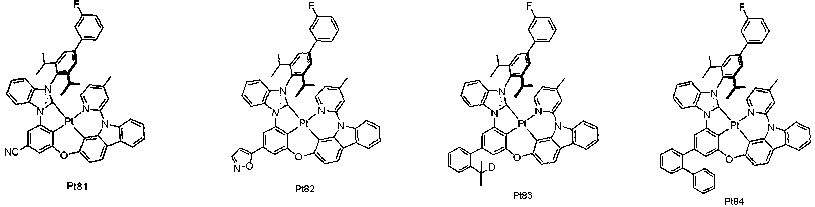

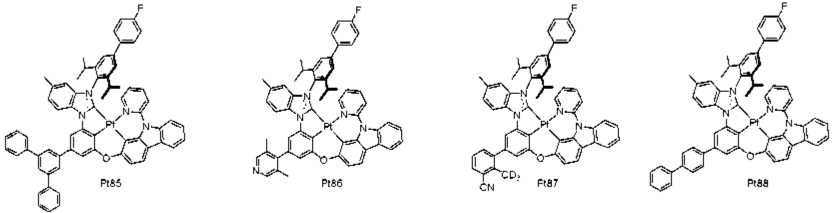

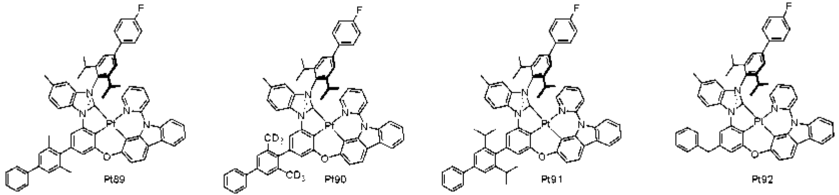

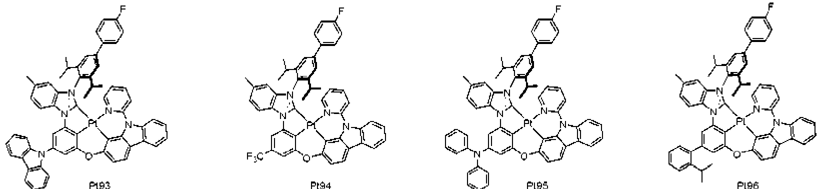

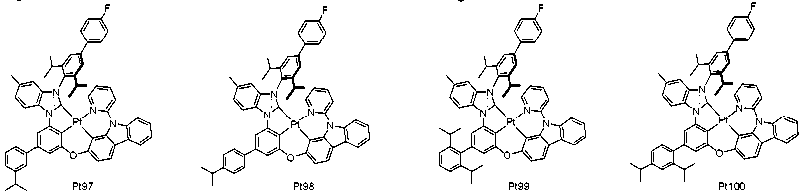

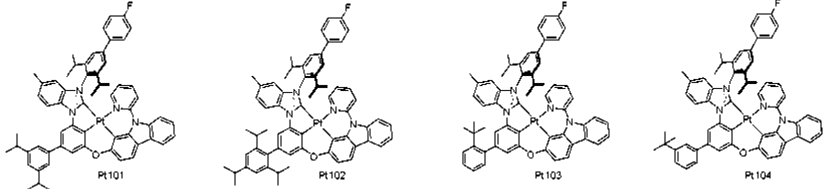

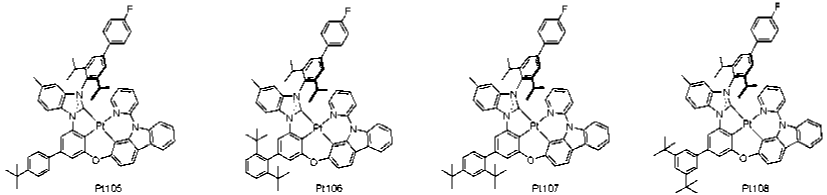

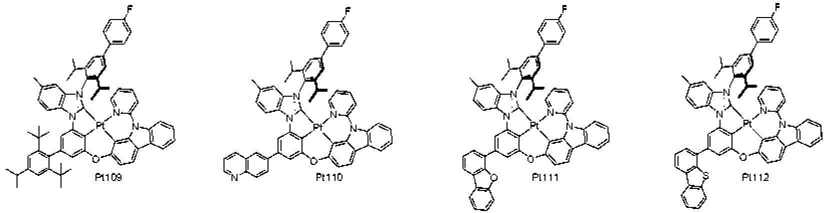

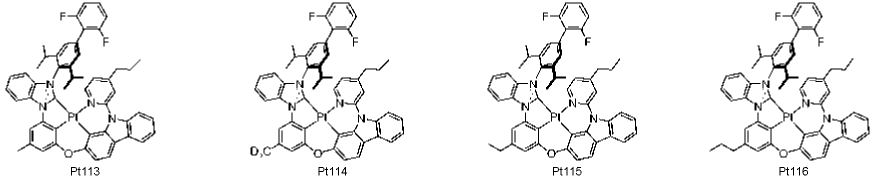

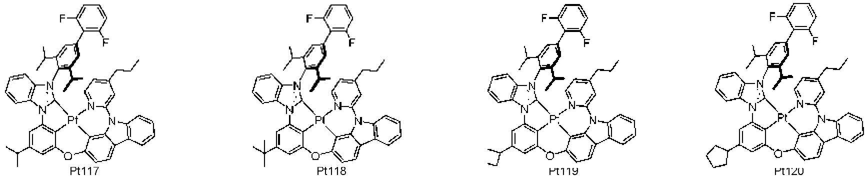

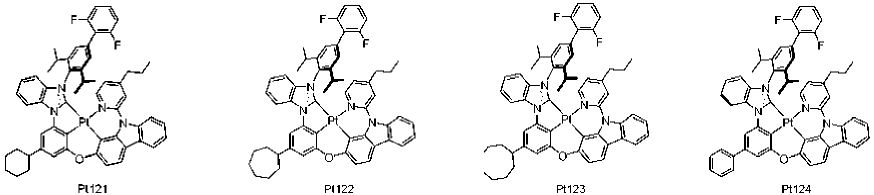

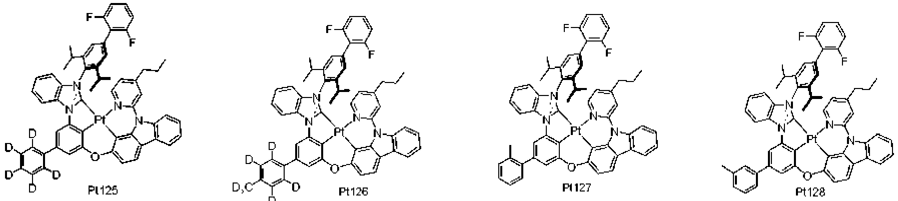

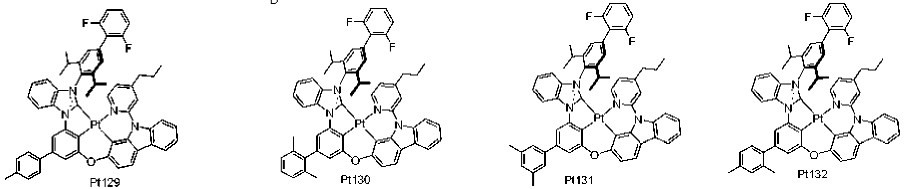

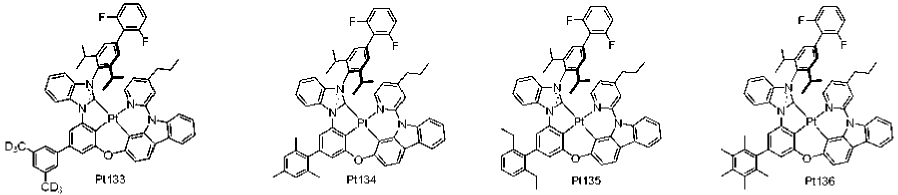

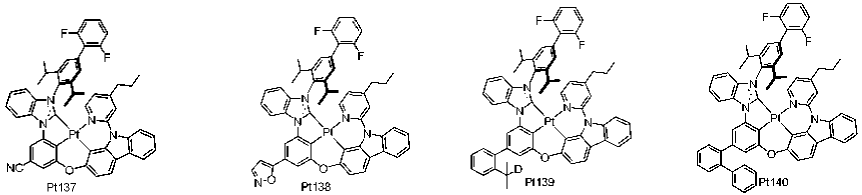

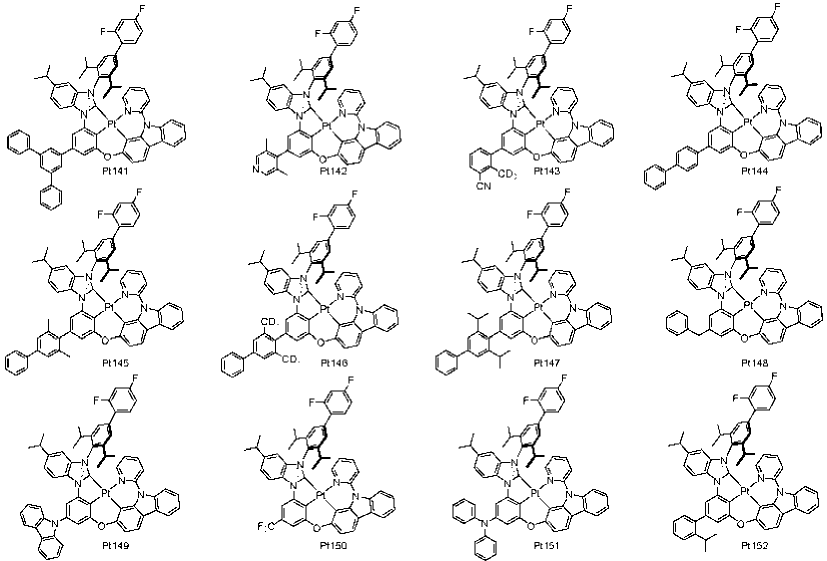

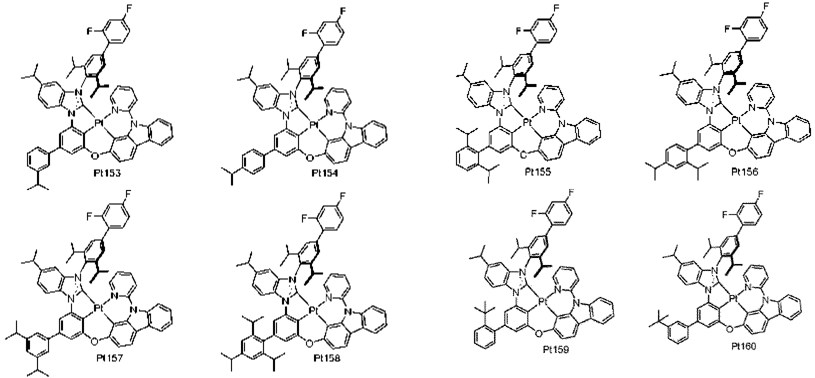

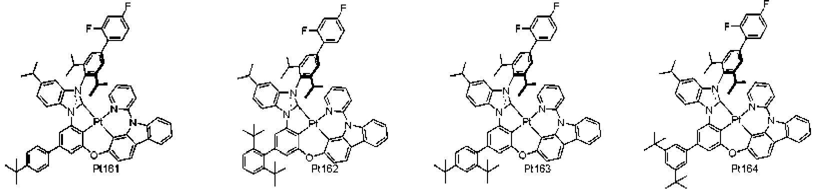

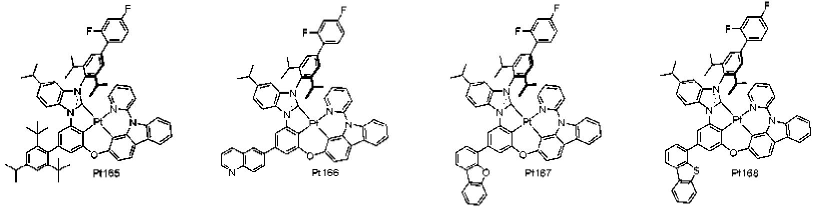

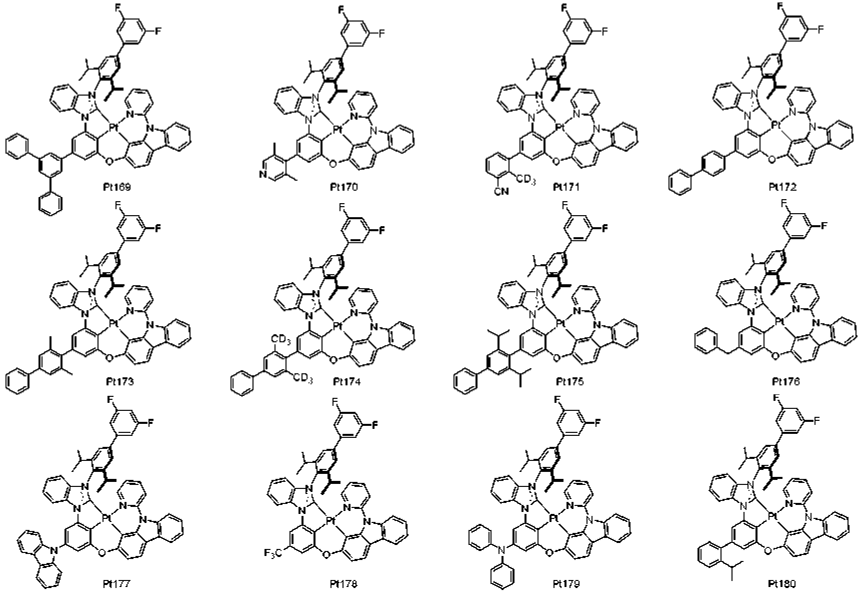

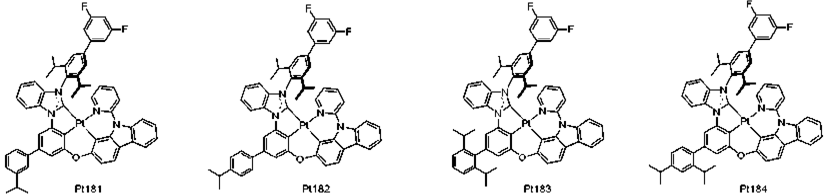

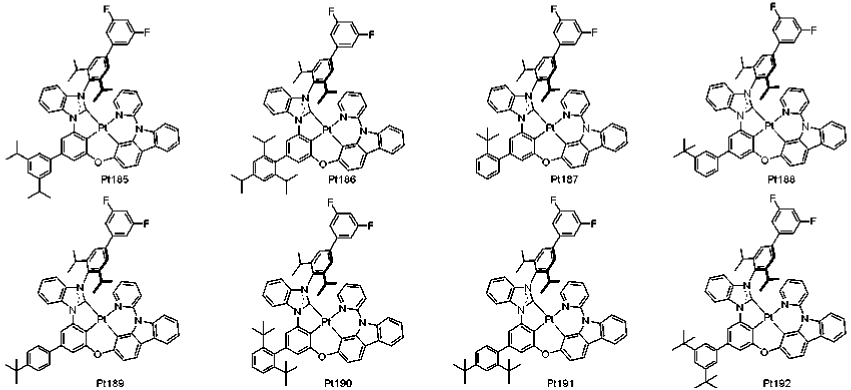

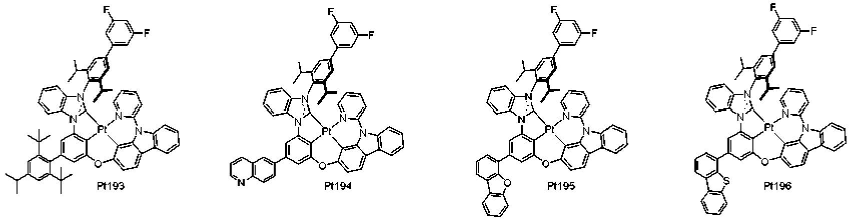

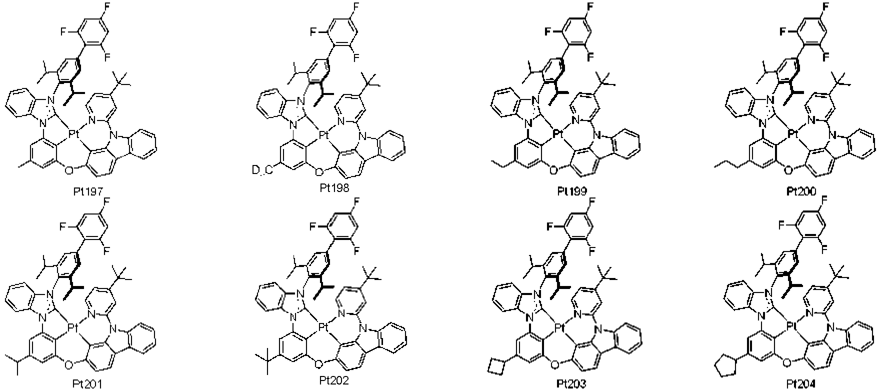

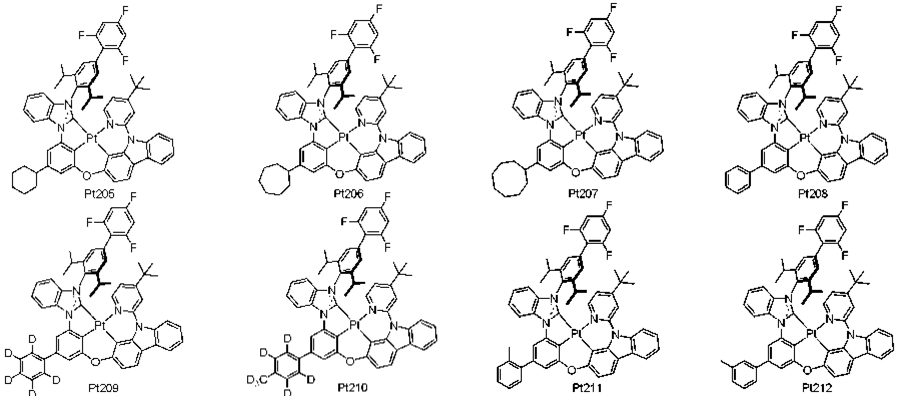

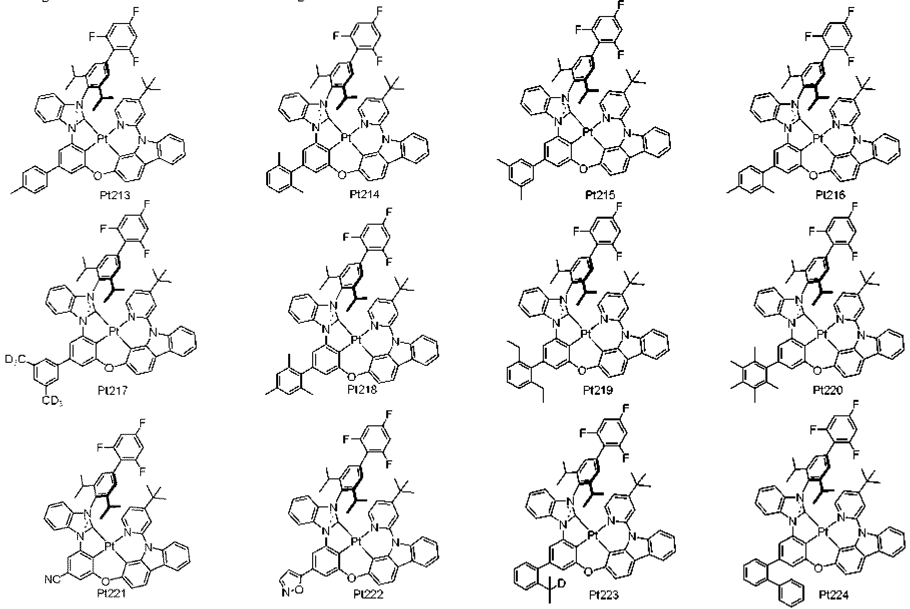

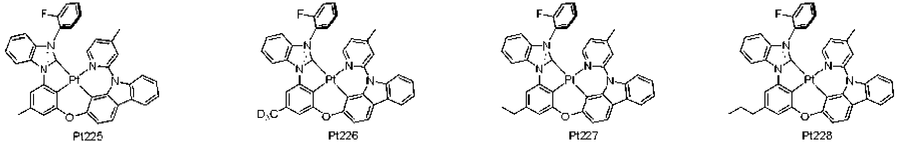

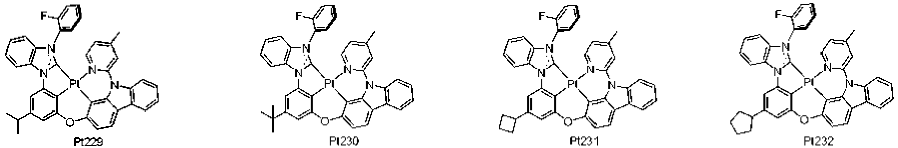

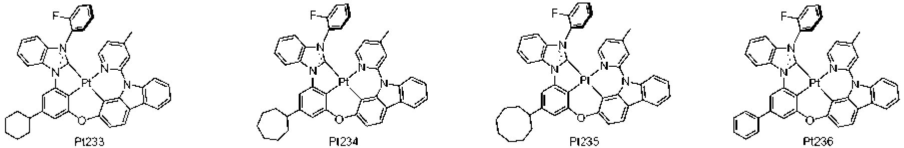

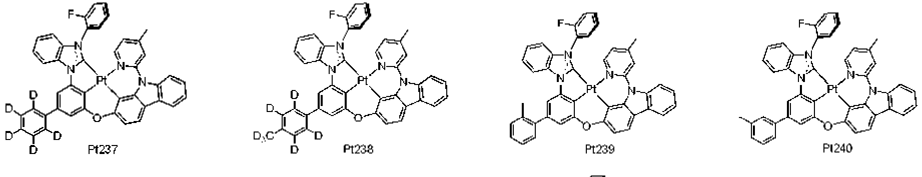

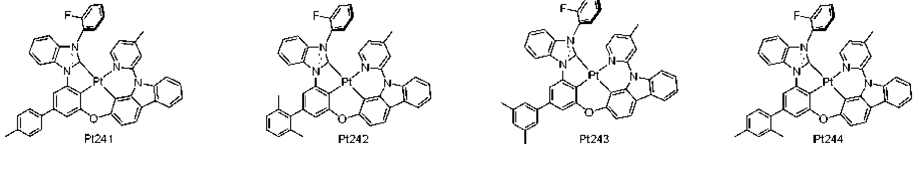

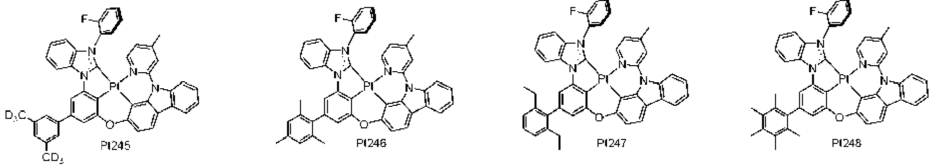

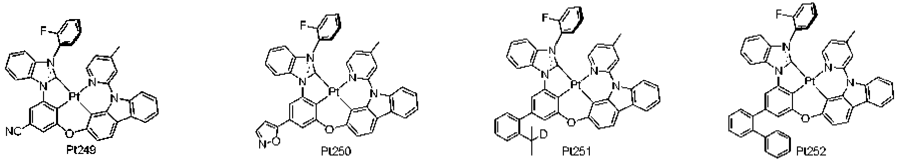

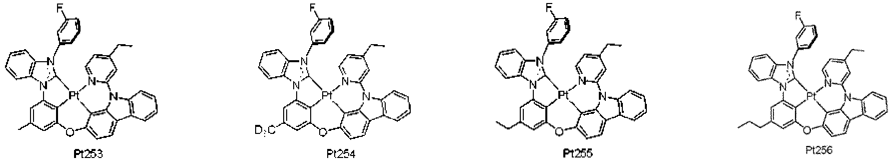

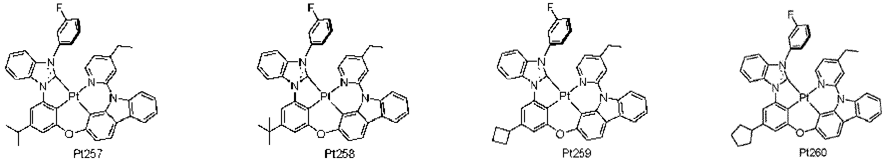

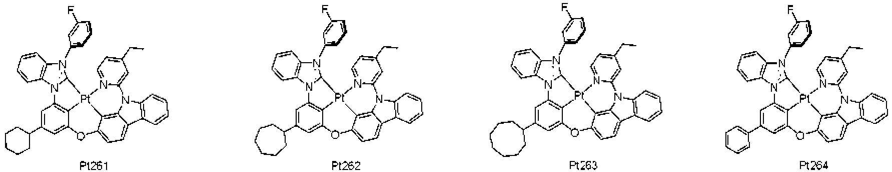

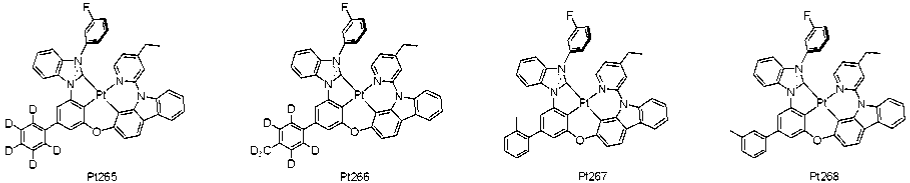

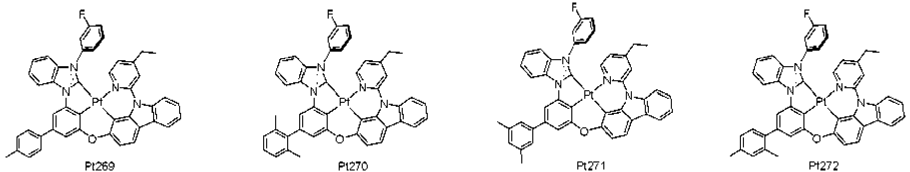

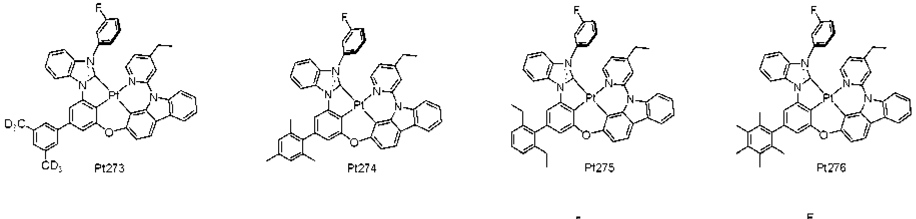

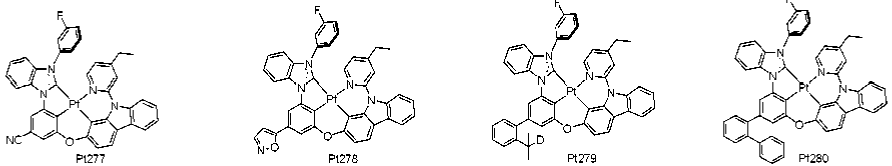

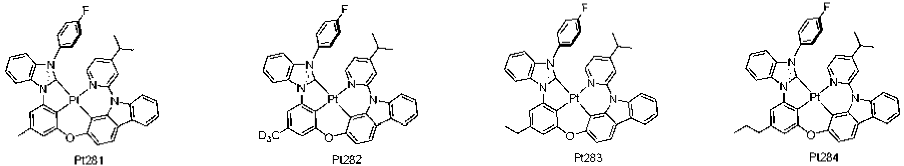

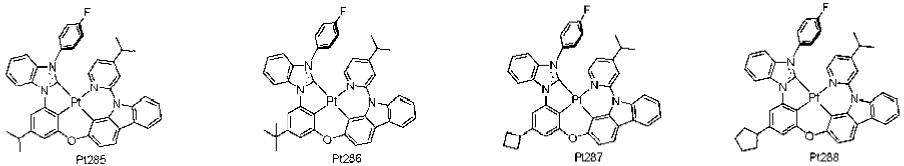

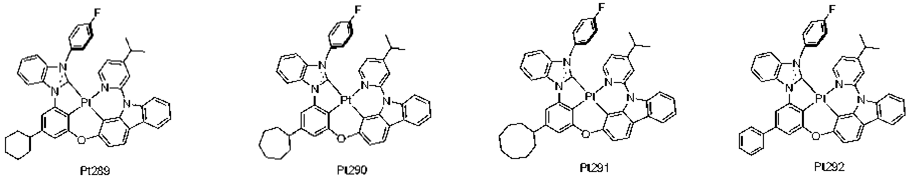

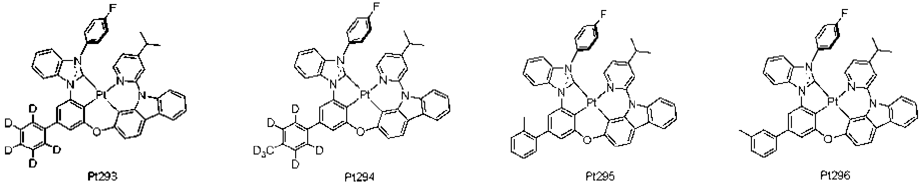

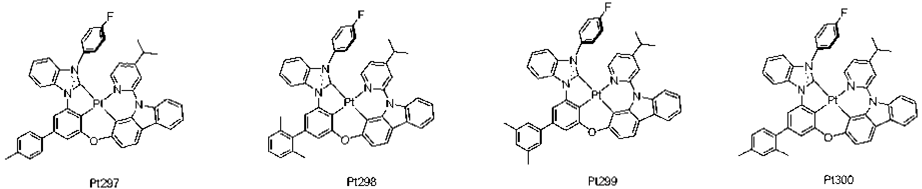

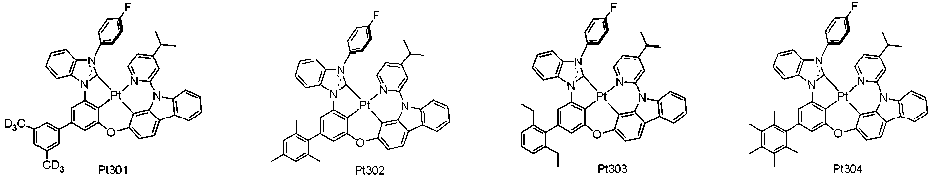

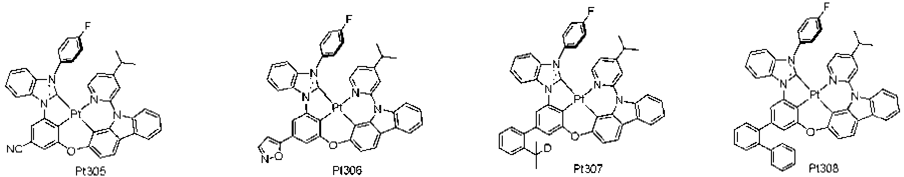

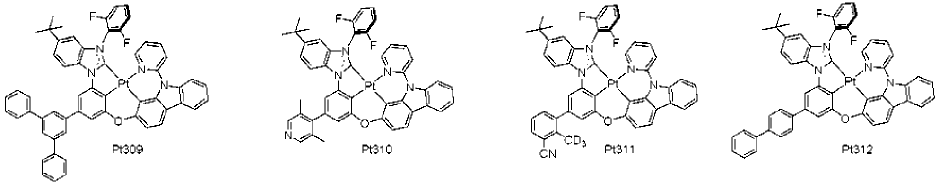

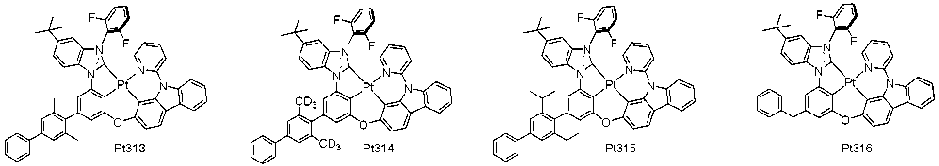

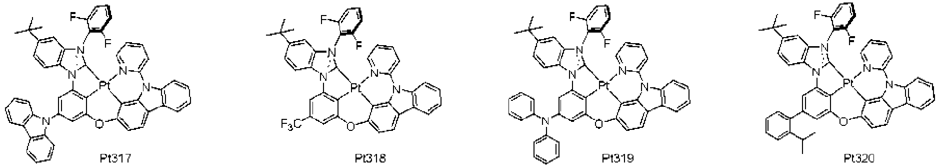

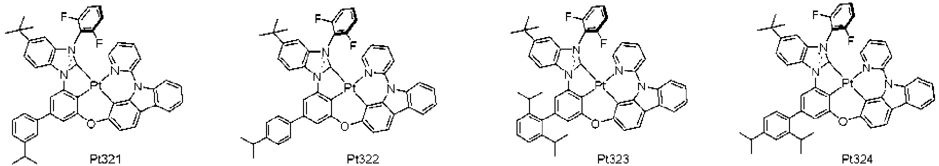

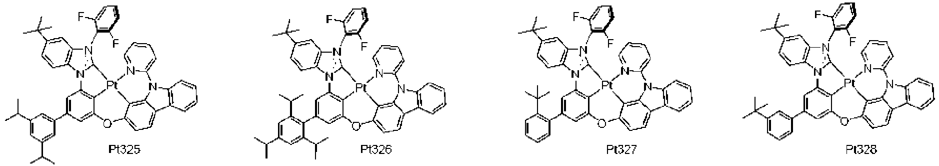

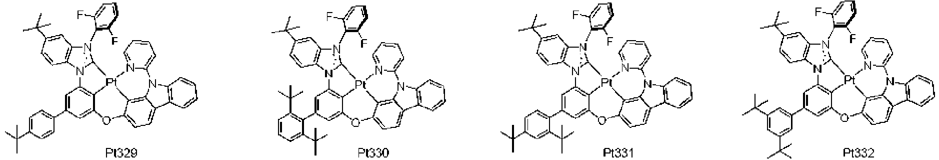

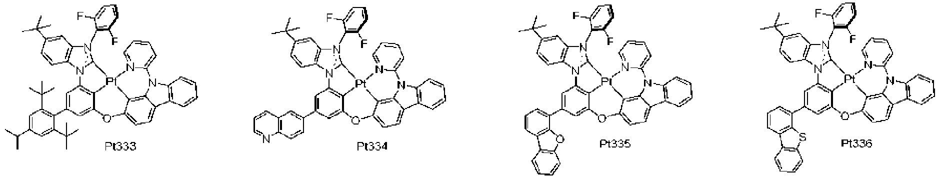

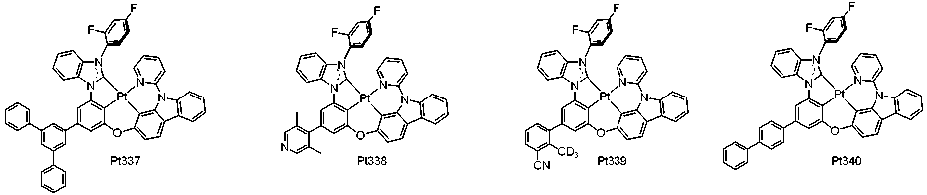

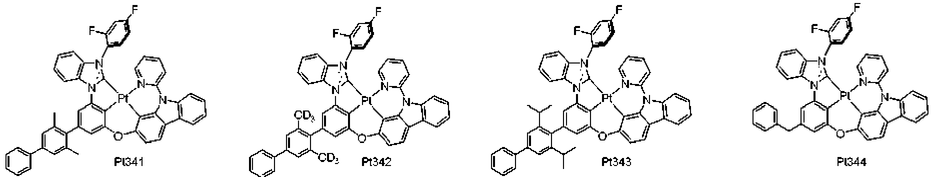

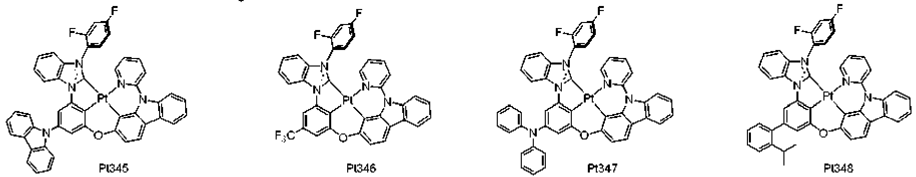

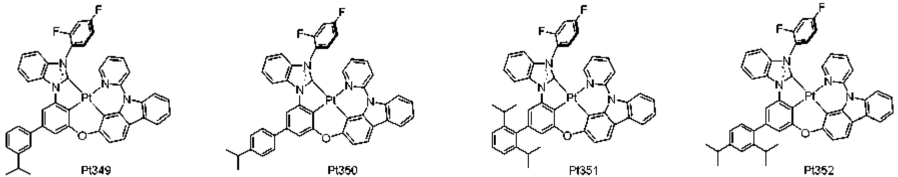

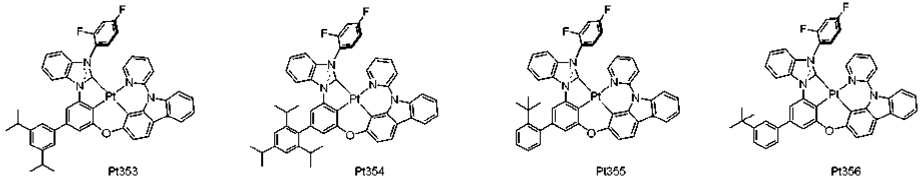

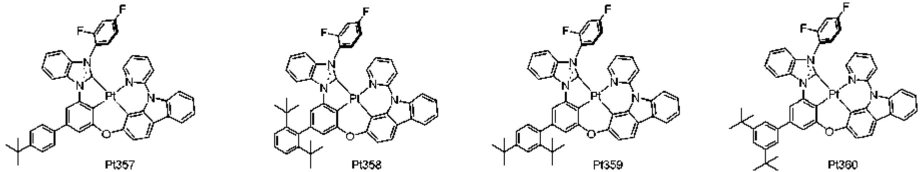

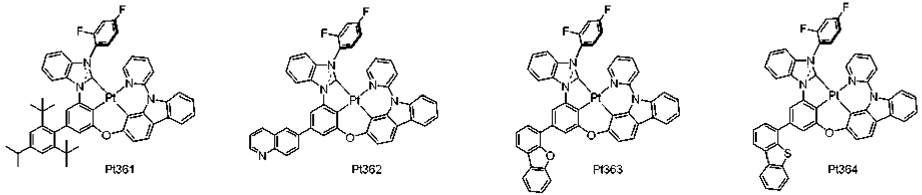

6. Application du complexe de platine (II) tétradentate cyclométalé contenant du fluor selon n'importe laquelle des revendications 1 à 5 dans un dispositif électronique.

7. Application selon la revendication 6, **caractérisée en ce que** le dispositif électronique comprend un dispositif électroluminescent organique, un circuit intégré organique, un transistor à effet de champ organique, un transistor organique à couches minces, un transistor électroluminescent organique, une cellule solaire organique, un détecteur optique organique, un dispositif d'extinction de champ organique, une cellule électrochimique électroluminescente et une diode laser organique.

8. Dispositif électroluminescent organique, comprenant une cathode, une anode et une couche fonctionnelle organique entre celles-ci, **caractérisé en ce que** la couche fonctionnelle organique comprend le complexe de platine (II) cyclométalé tétradenté contenant du fluor selon n'importe laquelle des revendications 1 à 5.

9. Dispositif électroluminescent organique, comprenant une couche électroluminescente, **caractérisé en ce que** la couche électroluminescente comprend le complexe de platine (II) tétradentate cyclométalé contenant du fluor selon n'importe laquelle des revendications 1 à 5.

10. Dispositif électroluminescent organique selon la revendication 9, **caractérisé en ce que** la couche électroluminescente comprend en outre un matériau dopant fluorescent, le matériau dopant fluorescent étant choisi parmi un ou plusieurs composés représentés par les formules (BN1) à (BN5) : 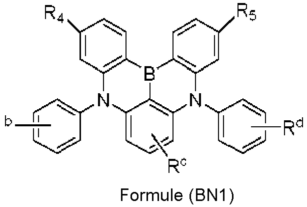 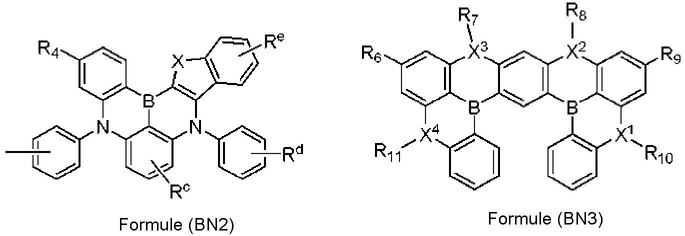 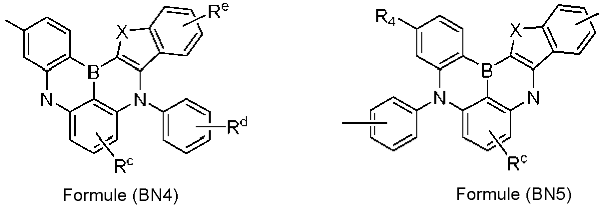
**caractérisé en ce que** X représente O, S, Se ou NR³⁰⁰ ;
X¹, X², X³, X^{4r} représentent chacun indépendamment O, S, Se ou N; et
R^{b} à R^{e} sont chacun indépendamment représentés comme monosubstitués, disubstitués, trisubstitués, tétrasubstitués ou non substitués ; R^{b} à R^{e} sont indépendamment sélectionnés dans un groupe constitué d'hydrogène, de deutérium, N, alkyle C1-C30 et aryle C6-C60 ; R₄ à R₁₁ sont chacun indépendamment sélectionnés dans un groupe constitué d'un groupe constitué par l'hydrogène, le deutérium, N, alkyle C1-30 et aryle C6-C60.

11. Dispositif électroluminescent organique selon la revendication 10, **caractérisé en ce que** R₄ à R6 et R₉ sont sélectionnés indépendamment parmi des groupes diphénylamine substitués ou non substitués, ou des groupes carbazole substitués ou non substitués ; la substitution peut être de multiples substitutions, et lorsqu'un substituant est contenu, le substituant est choisi parmi le deutérium, l'alkyle en C1-C30 et l'aryle C6-C30.

12. Dispositif électroluminescent organique selon la revendication 10, **caractérisé en ce que** R₇ à R₈ et R₁₀ à R₁₁ sont indépendamment sélectionnés dans un groupe constitué d'hydrogène, d'un alkyle C1-C30 et d'un aryle C6-C60.

13. Dispositif électroluminescent organique selon la revendication 10, **caractérisé en ce que** le matériau dopant fluorescent est choisi parmi l'une quelconque des structures chimiques suivantes, où Ph représente un groupe phényle, et D4 et D5 se réfèrent respectivement à être substitué par 4 et 5 atomes de deutérium :

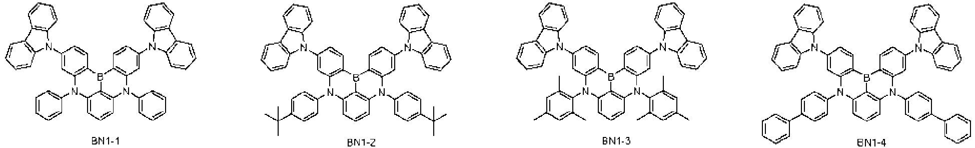

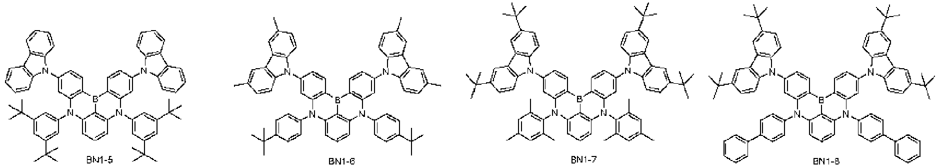

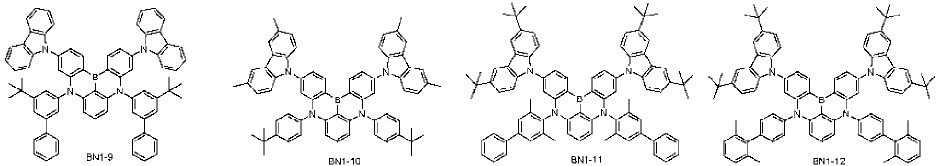

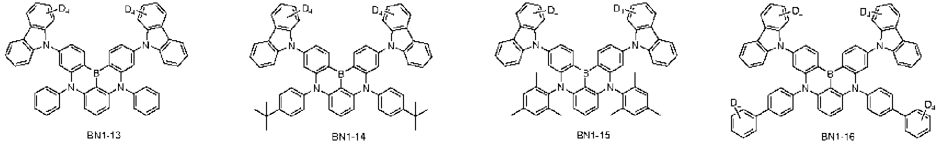

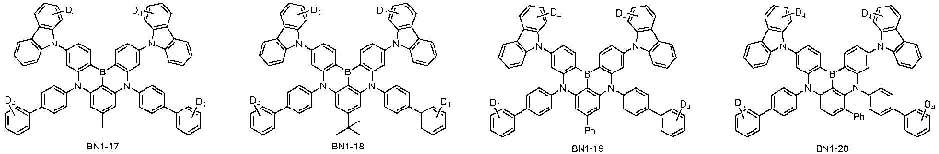

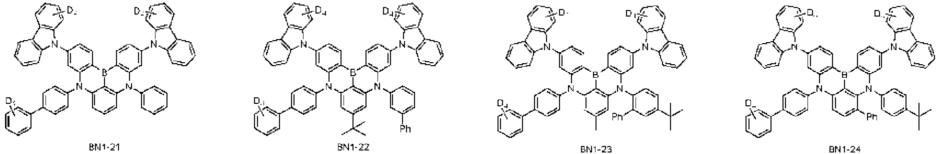

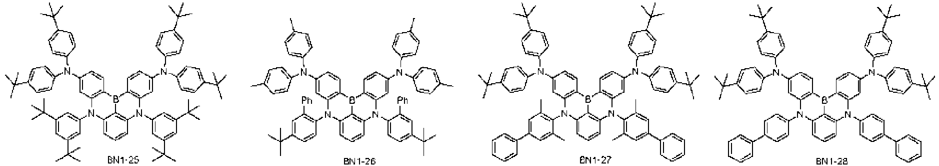

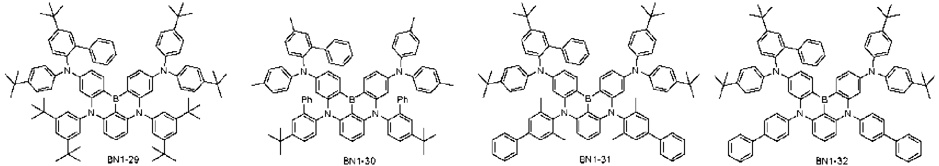

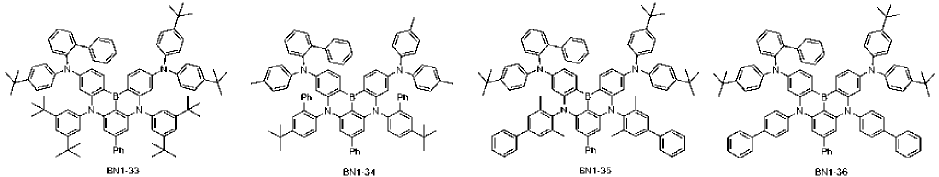

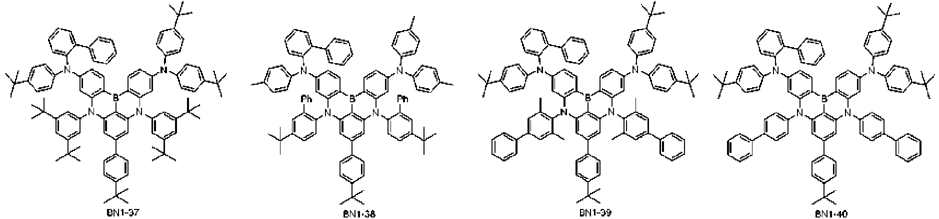

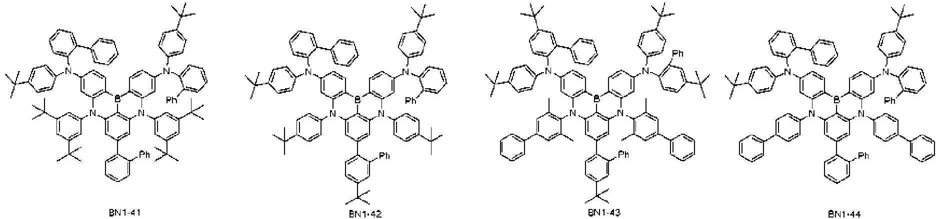

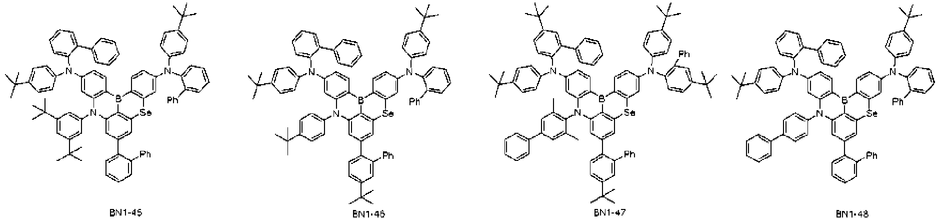

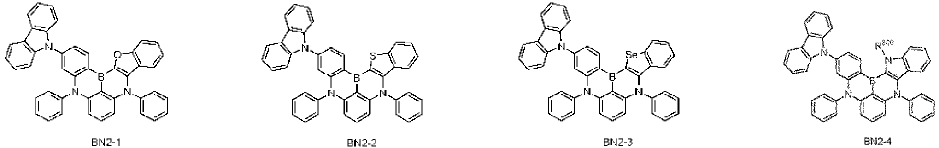

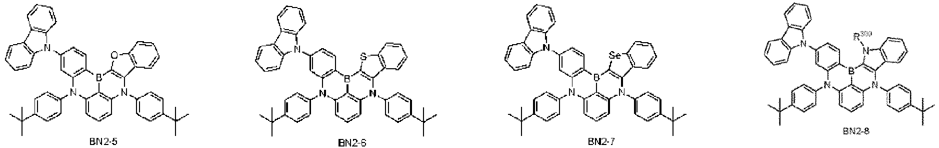

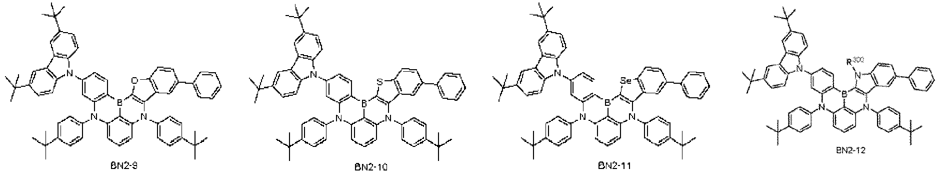

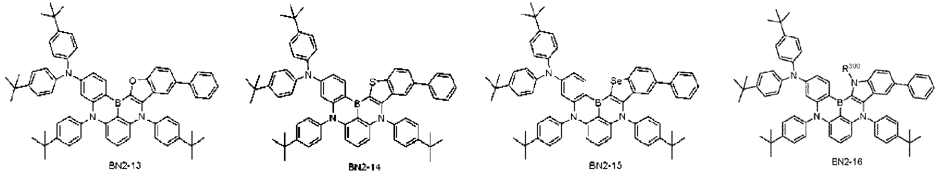

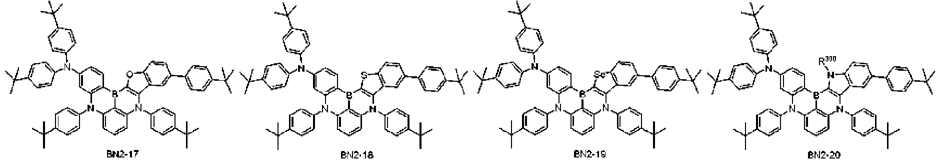

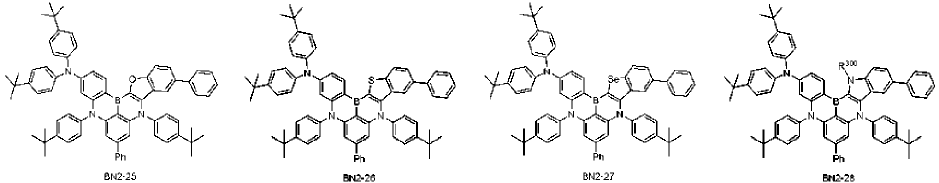

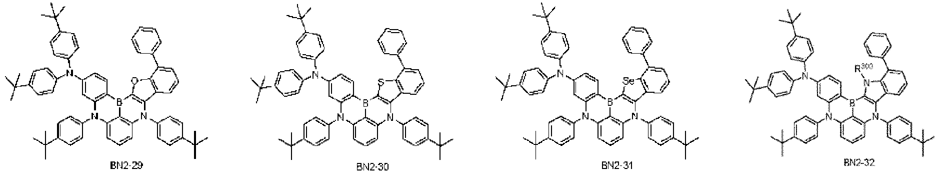

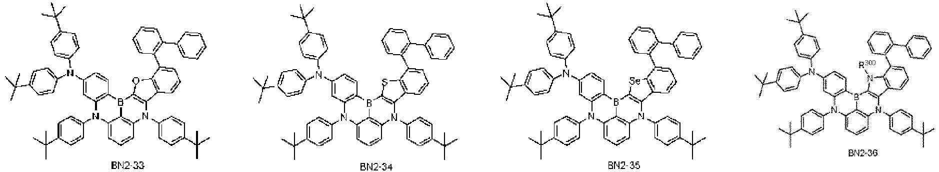

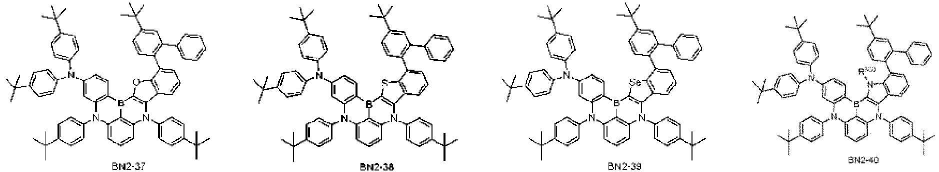

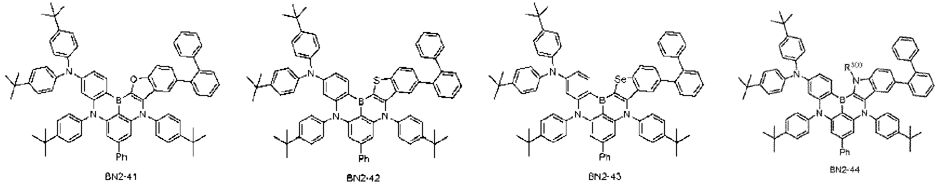

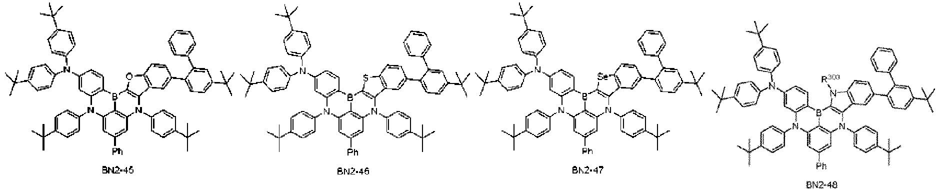

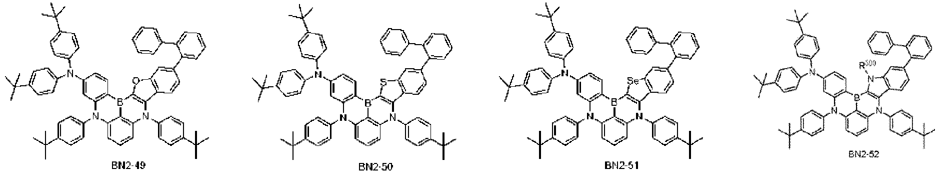

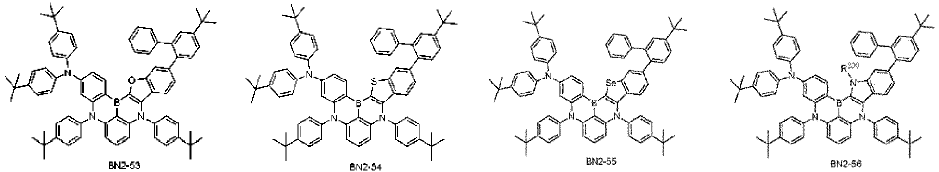

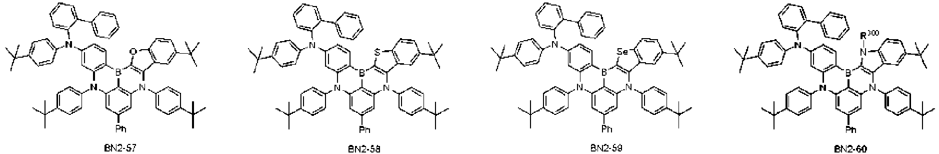

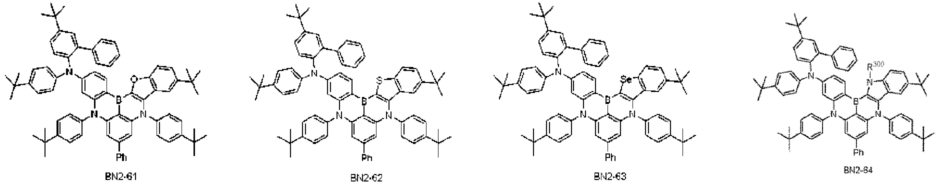

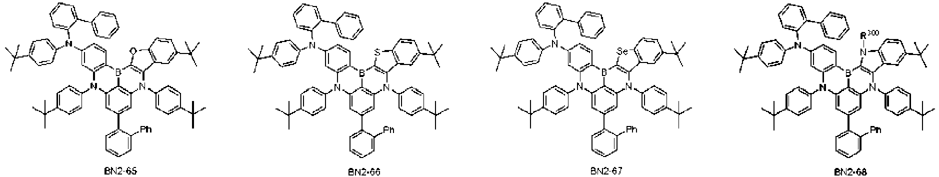

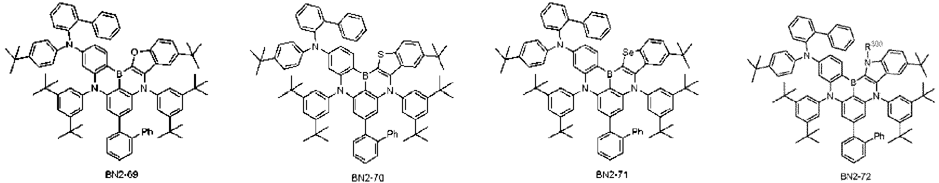

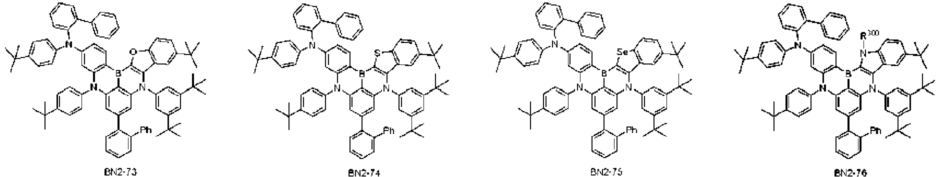

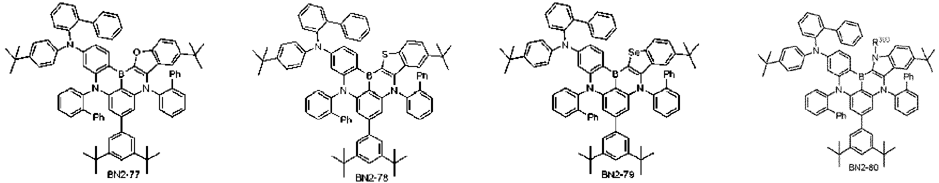

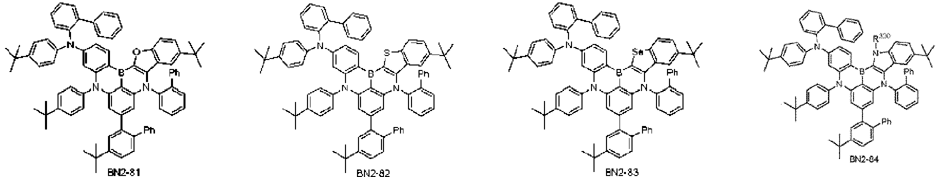

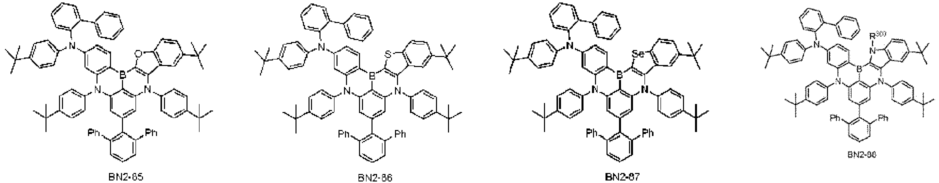

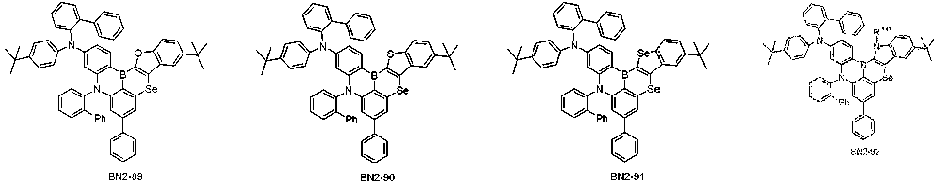

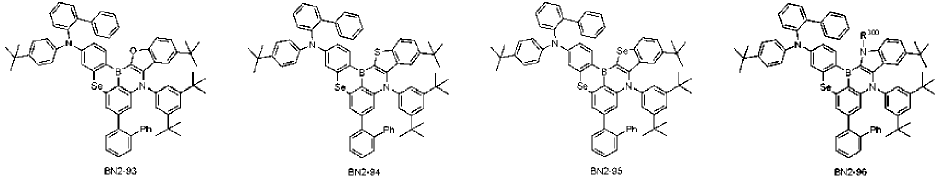

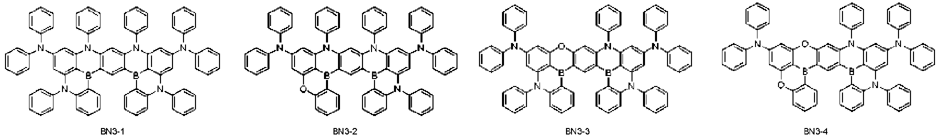

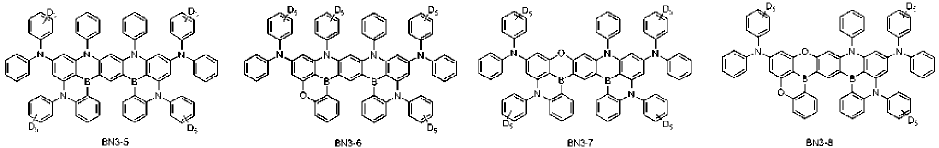

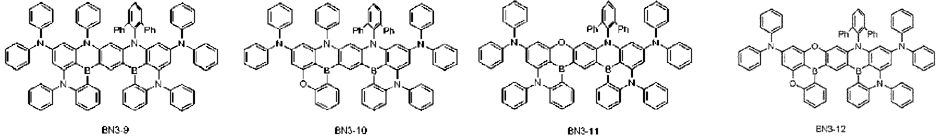

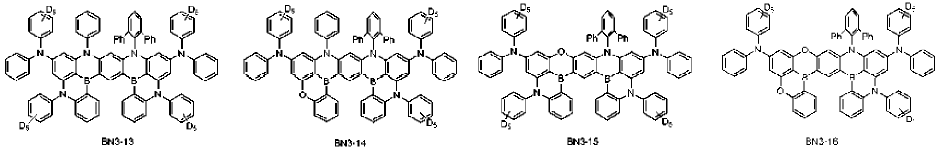

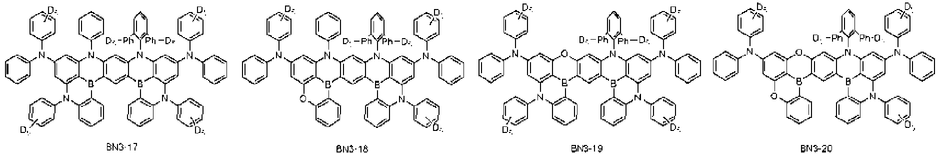

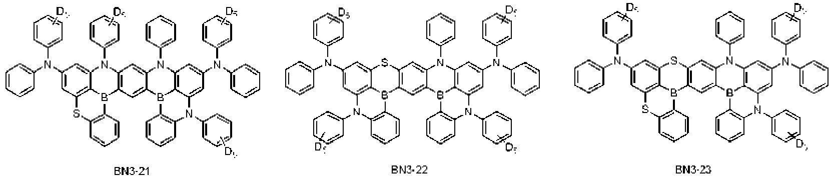

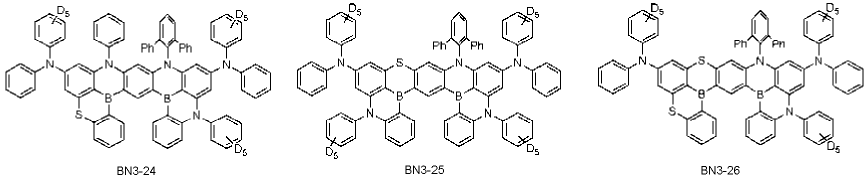

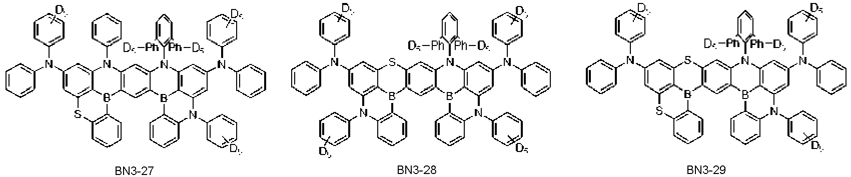

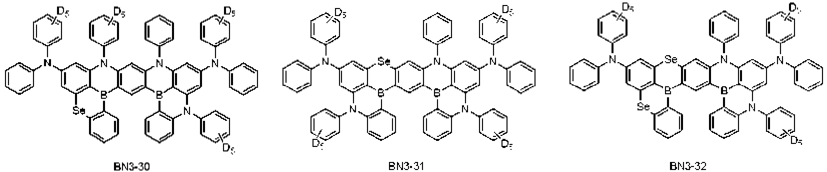

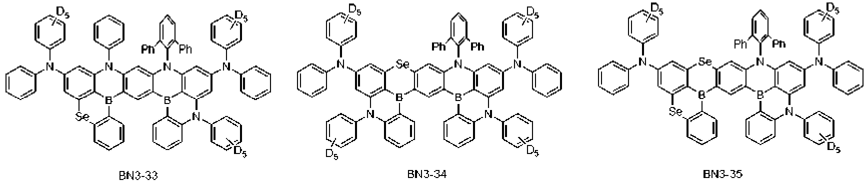

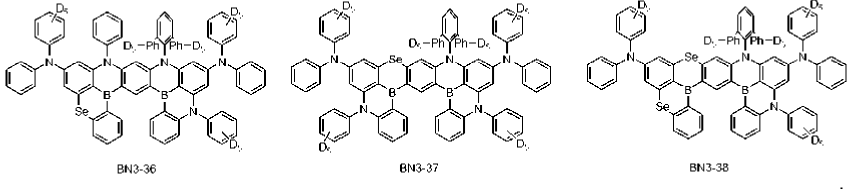

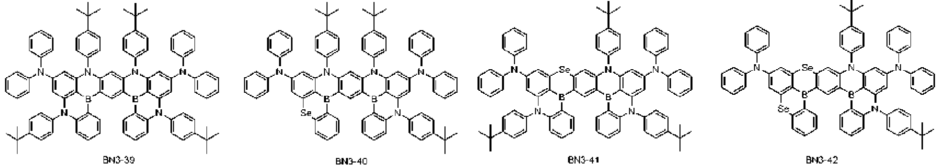

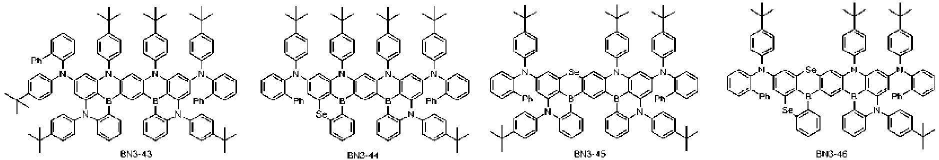

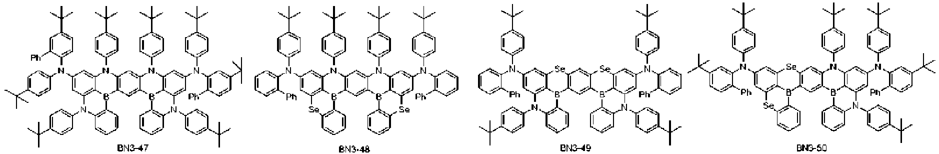

14. Dispositif photoélectrique organique, comprenant : une couche de substrat ; une première électrode sur le substrat ; une couche fonctionnelle électroluminescente organique sur la première électrode ; une seconde électrode sur la couche fonctionnelle électroluminescente organique, **caractérisé en ce que** la couche fonctionnelle électroluminescente organique comprend le complexe de platine cyclométalé tétradenté (II) contenant du fluor selon n'importe laquelle des revendications 1 à 5.

15. Dispositif photoélectrique organique selon la revendication 14, **caractérisé en ce que** la couche fonctionnelle électroluminescente organique comprend en outre un matériau dopant fluorescent, le matériau dopant fluorescent étant choisi parmi un ou plusieurs composés représentés par les formules (BN1) à (BN5) : 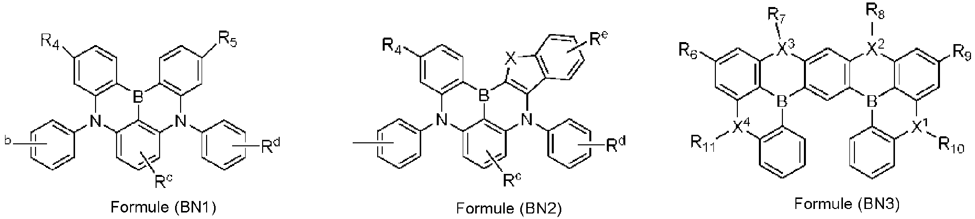 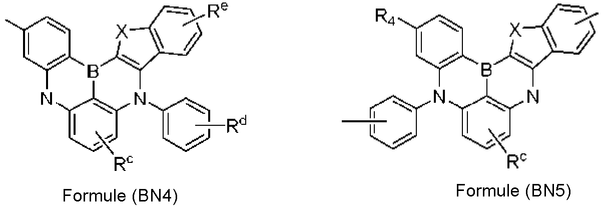
**caractérisé en ce que** X représente O, S, Se ou NR³⁰⁰ ;
X¹, X², X³, X^{4r} représentent chacun indépendamment O, S, Se ou N ; et
R^{b} à R^{e} sont chacun indépendamment représentés comme monosubstitués, disubstitués, trisubstitués, tétrasubstitués ou non substitués ; R^{b} à R^{e} sont indépendamment sélectionnés dans un groupe constitué d'hydrogène, de deutérium, N, alkyle C1-30 et aryle C6-C60 ; R₄ à R₁₁ sont chacun indépendamment sélectionnés dans un groupe constitué d'un groupe constitué par l'hydrogène, le deutérium, n, alkyle C1-30 et aryle C6-C60.
